# EUROPEAN PATENT APPLICATION

(11) **EP 4 851 714 A1**
(43) Date of publication of application: **09.12.2026**
(21) Application number: 25748323.0
(22) Date of filing: 16.01.2025
(51) Int. Cl.: G03F 7/023, C08G 73/10, G03F 7/004, H10K 50/00, H10K 59/10, H10K 59/122, H10K 59/124, H10K 85/10

(54) **PHOTOSENSITIVE RESIN COMPOSITION, CURED PRODUCT, DISPLAY DEVICE, AND ELECTRONIC COMPONENT**

(30) Priority: 31.01.2024 JP 2024012642; 19.06.2024 JP 2024098509
(71) Applicant: Toray Industries, Inc., Tokyo 103-8666 (JP)
(72) Inventor: SAEKI, Akinori, Otsu-shi, Shiga 520-8558 (JP); KAMEMOTO, Satoshi, Otsu-shi, Shiga 520-8558 (JP); KOSHINO, Mika, Otsu-shi, Shiga 520-8558 (JP); ISOBE, Kimio, Otsu-shi, Shiga 520-8558 (JP); KITABATA, Masahiro, Otsu-shi, Shiga 520-8558 (JP)
(74) Representative: Kador & Partner Part mbB
(86) International application number: PCT/JP2025/001131
(87) International publication number: WO 2025/164325

(57) **Abstract**

The purpose of the present invention is to provide: a photosensitive resin composition which has good solubility in a thinner, which can suppress contamination of an opening part after being cured and suppress foaming during lamination, and from which a cured product having good light emission characteristics even after being subjected to a reliability test is obtained; a cured product obtained by curing the photosensitive resin composition; and a display device and an electronic component equipped with a cured product of the resin composition. A photosensitive resin composition according to the present invention contains: a resin (A) including a specific structural unit (hereinafter referred to as resin (A)); a photosensitive agent (B); and a solvent (C). When the total amount of diamine residues in the resin (A) is defined as 100 mol%, the total of the content of a specific diamine residue is 30-100 mol%.

## Description

### TECHNICAL FIELD

The present invention relates to a photosensitive resin composition, a cured product, a display device, and an electronic component.

### BACKGROUND ART

Conventionally, for a bank layer of an organic EL display device, a planarization layer of a TFT substrate, a surface protective film of a semiconductor element, and an interlayer insulating film of an electronic component, a photosensitive polyimide and/or a photosensitive polybenzoxazole, which are excellent in heat resistance, electrical insulation, mechanical properties, and the like and capable of forming a pattern by photolithography, have been widely used, and many proposals have been made so far (for example, see Patent Documents 1 and 2).

In the case of making a coating film of a polyimide resin or a polybenzoxazole resin undergo thermal dehydrative cyclization to obtain a thin film excellent in heat resistance and mechanical properties, it is usually required to conduct high temperature curing at around 350°C. The operation conducted in making a coating film of a polyimide resin or a polybenzoxazole resin undergo thermal dehydrative cyclization to obtain a thin film excellent in heat resistance and mechanical properties may be referred to as curing (curing), and the change of the coating film may be referred to as cure. However, from the viewpoint that a memory device used in recent years, a mold resin used in production of a semiconductor package, and the like are weak against a high-temperature process, and from the viewpoint of semiconductor package reliability, a polyimide-based resin, a polybenzoxazole-based resin, and a polyamideimide-based resin that can be cured by curing at 250°C or less and have higher mechanical properties, chemical resistance, and adhesion are required for a surface protective film and an interlayer insulating film.

In addition, the demand for high reliability of organic EL display devices has become more severe year by year, and materials for a planarization layer and an insulating layer are also required to be capable of maintaining high light emission characteristics even after a reliability test under accelerated conditions such as light irradiation.

Polyimides, polybenzoxazoles, and precursors of any of these, which are used in conventional photosensitive polyimides and/or photosensitive polybenzoxazoles, having a fluorine-containing group such as a trifluoromethyl group in the resin structure, are generally used, but there was a problem that a fluorine-containing residual substance generated during curing or dry etching adhered to an electrode at an opening, increasing the contact resistance of the electrode. On the other hand, a method using a fluorine-free organic insulating film (for example, see Patent Document 3) and a method using a fluorine-free polyimide precursor in which a structure having a specific structure is introduced into the main chain to simultaneously achieve both suppression of electrode contamination and high sensitivity (for example, see Patent Document 4) are disclosed.

On the other hand, for example, a method of providing an organic EL display device excellent in long-term reliability by using a photosensitive resin composition in which the molar ratio S/C of sulfur to carbon obtained when a cross section of a cured film is measured with an electron probe microanalyzer is in a specific range (for example, see Patent Document 5), and a method of providing a photosensitive resin composition that has high sensitivity and is soluble in a γ-butyrolactone solvent by using a resin having a specific structure not including a halogen atom in the molecule (for example, see Patent Document 6) are disclosed.

### PRIOR ART DOCUMENT

### PATENT DOCUMENTS

Patent Document 1: Japanese Patent Laid-open Publication No. 2002-91343
Patent Document 2: Japanese Patent Laid-open Publication No. 2002-116715
Patent Document 3: Japanese Patent Laid-open Publication No. 2009-177113
Patent Document 4: Japanese Patent Laid-open Publication No. 2003-76007
Patent Document 5: International Publication No. 2016/047483
Patent Document 6: International Publication No. 2009/081950

### SUMMARY OF THE INVENTION

### PROBLEMS TO BE SOLVED BY THE INVENTION

However, conventional polyimides, polybenzoxazoles, and precursors of any of these, which do not have a fluorine-containing group such as a trifluoromethyl group, had poor solubility in an organic solvent, and there was a problem of insufficient solubility in propylene glycol monomethyl ether widely used as a thinner in a photolithography step even if they were dissolved in some aprotic polar solvents such as N-methyl-2-pyrrolidone and γ-butyrolactone. The resins disclosed in Patent Documents 3 and 4 have a problem in solubility in propylene glycol monomethyl ether.

Patent Document 5 discloses a photosensitive resin composition including a polyimide precursor including a fluorine-containing group, but as a result of studies by the authors, there was a problem that contamination was observed at the opening after curing. In addition, there was a problem that an abnormality due to foaming was likely to occur when a pixel defining layer was formed on the planarization layer in a step of fabricating an organic EL display device. In addition, when the photosensitive resin composition described in Patent Document 6 was examined by the authors, there was a problem in solubility in propylene glycol monomethyl ether. In addition, when an organic EL display device was fabricated using the photosensitive resin composition described in Patent Document 6 and reliability evaluation was performed, there was a problem that light emission characteristics after a reliability test under accelerated conditions such as light irradiation could not be maintained. As described above, it is the actual situation that a photosensitive resin composition which satisfies all of thinner solubility, suppression of contamination of an opening after curing, suppression of foaming during lamination, and good light emission characteristics after a reliability test is not known.

Therefore, an object of the present invention is to provide a photosensitive resin composition having good thinner solubility, being capable of suppressing contamination of an opening after curing and suppressing foaming at the time of lamination, and the cured product thereof having good light emission characteristics even after a reliability test, a cured product obtained by curing the photosensitive resin composition, and a display device and an electronic component each including a cured product of the photosensitive resin composition.

### SOLUTIONS TO THE PROBLEMS

In order to solve the problems as described above, the present invention has the constitution as described below.
[1] A photosensitive resin composition including: a resin (A) including at least one of a structural unit represented by formula (1), a structural unit represented by formula (19), and a structural unit represented by formula (70), the resin (A) being hereinafter, referred to as resin (A); a photosensitive agent (B); and a solvent (C),
   wherein when the total amount of diamine residues in the resin (A) is defined as 100 mol%, the total content of diamine residues represented by any one of formulas (2) to (4) is 30 to 100 mol%. 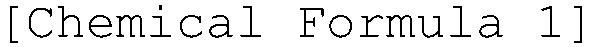 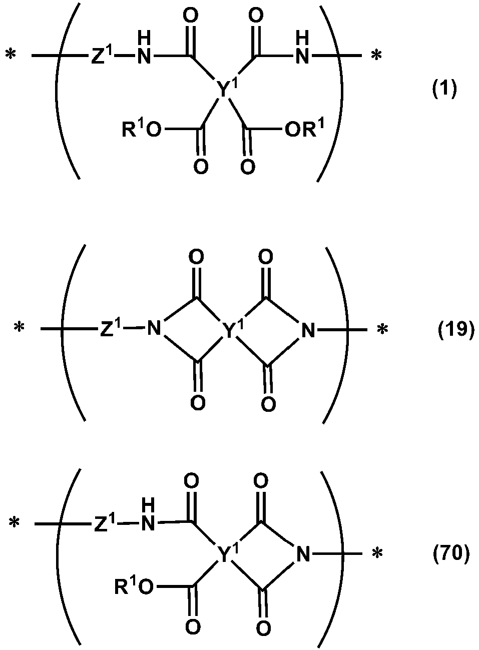 (In formulas (1), (19), and (70), Y¹ each independently represents an acid dianhydride residue having 2 to 40 carbon atoms and having any one of an aliphatic structure having 2 to 20 carbon atoms, an alicyclic structure having 4 to 40 carbon atoms, and an aromatic structure having 6 to 40 carbon atoms. Z¹ each independently represents a diamine residue represented by any one of formulas (2) to (4). R¹ each independently represents a hydrogen atom, an alkyl group having 1 to 20 carbon atoms, or a monovalent group having 2 to 20 carbon atoms and having an ethylenically unsaturated double bond. * represents a bonding site.) 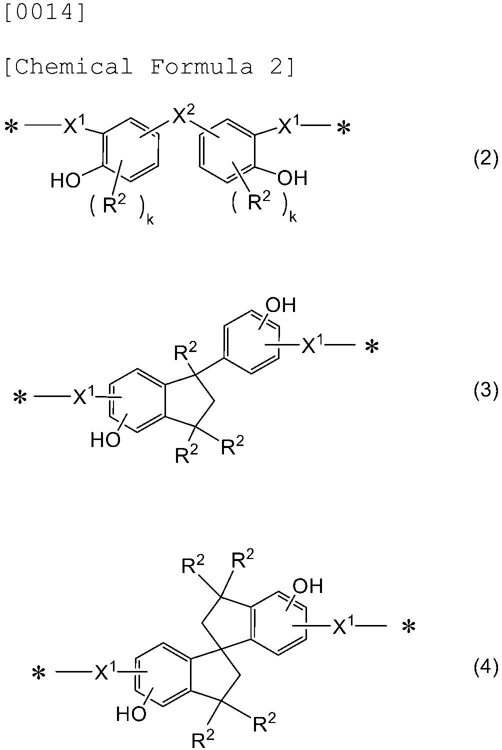 (In the formulas (2), (3) and (4), X¹ each independently represents a direct bond or a divalent group represented by formula (5), R² each independently represents an alkyl group having 1 to 4 carbon atoms, X² is a divalent group represented by formula (6) or (7), k each independently represents 0 or 1, and * represents a bonding site bonded to an imide structure, an amide structure, an amide acid ester structure, or an amide acid structure.) 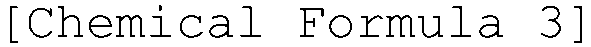 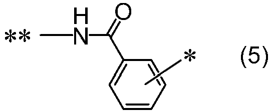 (In formula (5), * represents a bonding site bonded to a nitrogen atom. ** represents a bonding site bonded to an aromatic ring.) 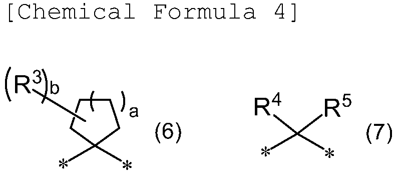 (In formulas (6) and (7), R³ each independently represents an alkyl group having 1 to 4 carbon atoms, a represents 1 or 2, b represents an integer of 1 to 3, R⁴ and R⁵ each independently represent a hydrocarbon group having 1 to 10 carbon atoms or a hydrogen atom, and * represents a bonding site bonded to an aromatic ring, provided that R⁴ and R⁵ do not have the same structure.)
[2] The photosensitive resin composition according to [1], wherein the resin (A) includes a diamine residue represented by formula (2), the total number of carbon atoms of R³ is 1 or more and 5 or less in formula (6), and the total number of carbon atoms of R⁴ and R⁵ is 3 or more and 10 or less in formula (7).
[3] The photosensitive resin composition according to [1] or [2], wherein the resin (A) includes a diamine residue represented by formula (2), and in formula (6), when a=1 is represented by formula (6-1) and a = 2 is represented by formula (6-2), Condition 1 and Condition 2 are satisfied, and in formula (7), the number of carbon atoms of R⁴ is different from the number of carbon atoms of R⁵.
   Condition 1: In formula (6-1), the total number of carbon atoms of R¹¹ to R¹⁴ is different from the total number of carbon atoms of R¹⁵ to R¹⁸.
   Condition 2: In formula (6-2), the total number of carbon atoms of R¹⁹ to R²² is different from the total number of carbon atoms of R²⁵ to R²⁸. 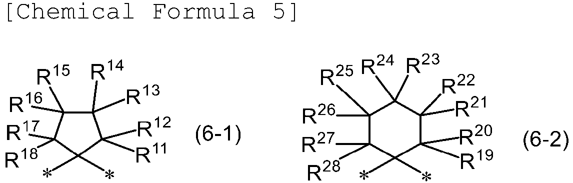 (In formula (6-1) and formula (6-2), R¹¹ to R²⁸ each independently represent a hydrogen atom or an alkyl group having 1 to 4 carbon atoms, provided that both formulas (6-1) and (6-2) satisfy the condition of formula (6).)
[4] The photosensitive resin composition according to any one of [1] to [3], wherein the resin (A) includes a diamine residue represented by formula (2), and X² is a divalent group represented by any one of formulas (8) to (13) and (76) to (83). 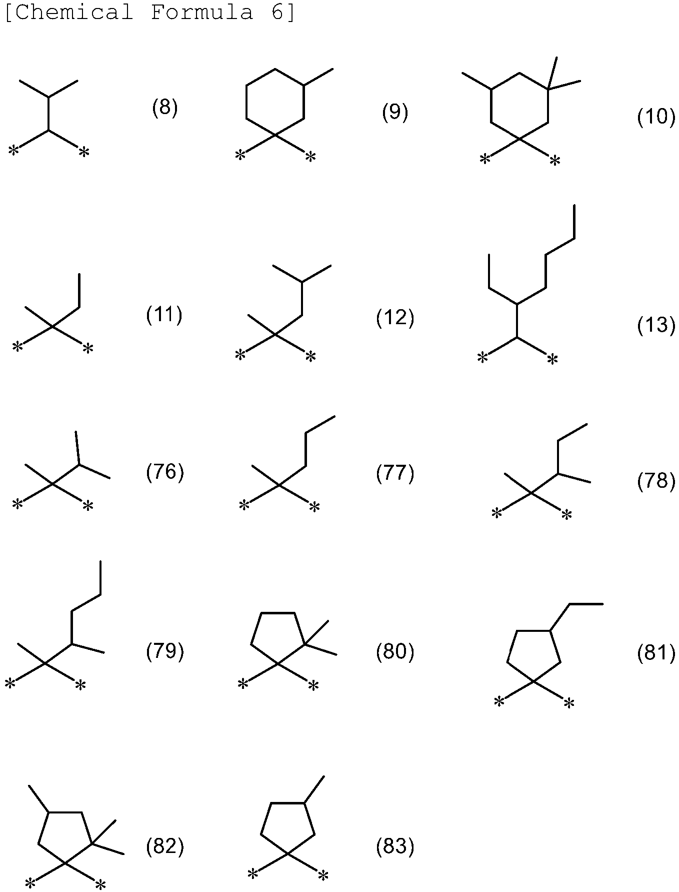 (In formulas (8) to (13) and (76) to (83), * represents a bonding site bonded to an aromatic ring.)
[5] The photosensitive resin composition according to any one of [1] to [4], wherein in formulas (1), (19), and (70), Y¹ each independently represents an acid dianhydride residue having 8 to 40 carbon atoms and having a diphenyl ether structure.
[6] The photosensitive resin composition according to any one of [1] to [5], wherein the resin (A) has a structure represented by formula (84). 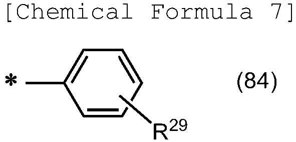 (In formula (84), R²⁹ represents a hydroxyl group, an alkyl group having 1 to 3 carbon atoms, an alkoxy group having 1 to 3 carbon atoms, an alkenyl group having 2 to 5 carbon atoms, or an alkynyl group having 2 to 5 carbon atoms. * represents a bonding site with a nitrogen atom.)
[7] The photosensitive resin composition according to any one of [1] to [6], wherein
   the resin (A) includes a structural unit (a) and/or a structural unit (b), and the resin (A) includes a structural unit (c) and/or a structural unit (d), and
   the resin (A) includes at least one of a structural unit (a) and a structural unit (c).
   Structural unit (a): A structural unit represented by formula (1), formula (19), or formula (70), in which Z¹ in formulas (1), (19), and (70) is represented by formula (2), and two X¹ in formula (2) are each a direct bond
   Structural unit (b): A structural unit represented by formula (48), formula (49), or formula (71), in which Z³ in formula (48), formula (49), and formula (71) is represented by formula (45), and two X¹ in formula (45) are each a direct bond
   Structural unit (c): A structural unit represented by formula (1), formula (19), or formula (70), in which Z¹ in formula (1), formula (19), and formula (70) is represented by formula (2), and at least one X¹ of the two X¹ in formula (2) is a divalent group represented by formula (5)
   Structural unit (d): A structural unit represented by formula (48), formula (49), or formula (71), in which Z³ in formula (48), formula (49), and formula (71) is represented by formula (45), and of two X¹ in formula (45), at least one X¹ is a divalent group represented by formula (5) 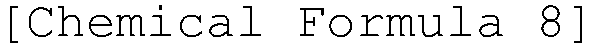 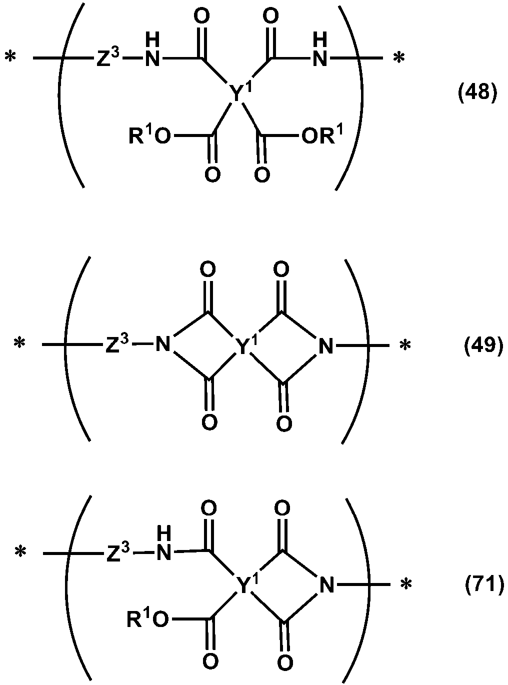 (In formulas (48), (49), and (71), Y¹ and R¹ are in the same ranges as those described in formulas (1), (19), and (70). Z³ each independently represents a diamine residue represented by formula (45). * represents a bonding site.) 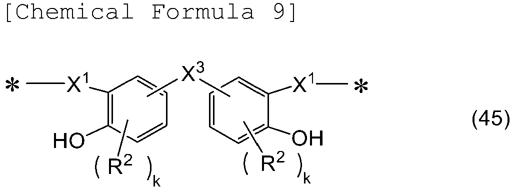 (In formula (45), X¹ is each independently a direct bond or a divalent group represented by formula (5), and R² and k are in the same range as those described in formula (2). X³ represents a divalent organic group represented by any one of formulas (64) to (69). * represents a bonding site bonded to an imide structure, an amide structure, an amide acid ester structure, or an amide acid structure.) 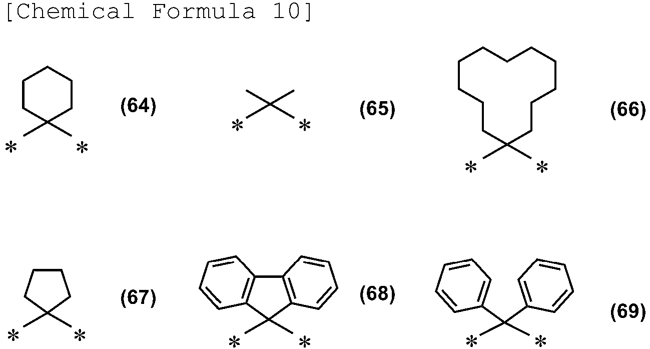 (* represents a bonding site bonded to an aromatic ring.)
[8] The photosensitive resin composition according to [7], wherein when the total amount of the polyimide structural units included in the resin (A) is 100 mol %, the total content of the structural units (a) and (b) is 20 to 95 mol %, and the total content of the structural units (c) and (d) is 5 mol % to 80 mol %.
[9] The photosensitive resin composition according to any one of [1] to [8], wherein the resin (A) further includes at least one of a structural unit represented by formula (50), a structural unit represented by formula (51), and a structural unit represented by formula (72). 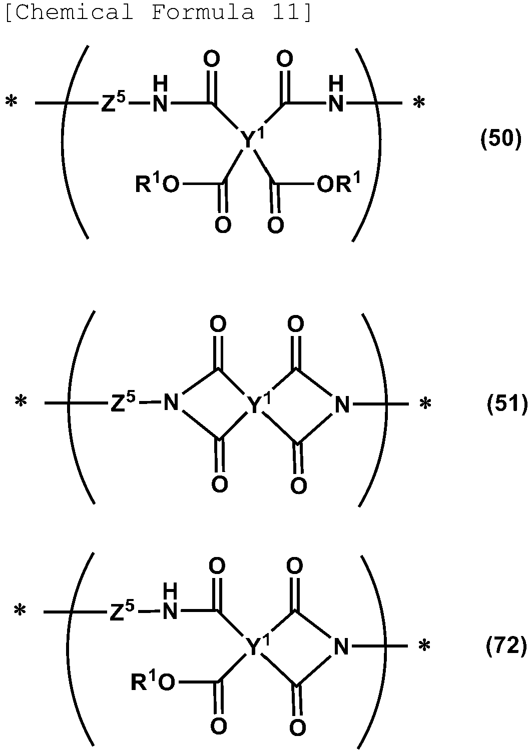 (In formulas (50), (51), and (72), Y¹ and R¹ are in the same ranges as those described in formulas (1), (19), and (70). Z⁵ each independently represents a diamine residue represented by formulas (46) or (47). * represents a bonding site.) 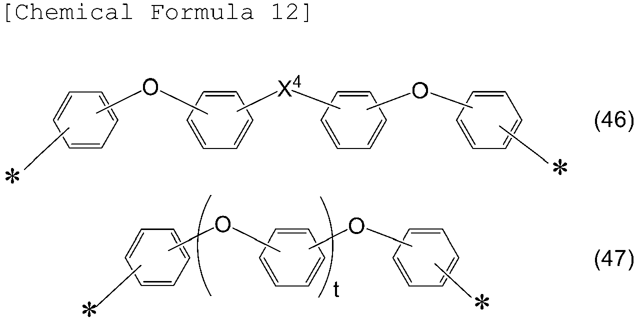 (In formulas (46) and (47), X⁴ represents a direct bond or -C(CH₃)₂-. t represents any integer of 0 to 2. * represents a bonding site bonded to an imide structure, an amide structure, an amide acid ester structure, or an amide acid structure.)
[10] The photosensitive resin composition according to [9], wherein when the total amount of the structural units of the polyimide included in the resin (A) is 100 mol %, the total content of the structural unit represented by formula (50), the structural unit represented by formula (51), and the structural unit represented by formula (72) is 1 to 30 mol %.
[11] The photosensitive resin composition according to any one of [1] to [10], wherein the resin (A) includes an acid dianhydride residue having 4 to 20 carbon atoms and an alicyclic structure.
[12] The photosensitive resin composition according to [11], wherein when the total amount of acid dianhydride residues in the resin (A) is 100 mol%, the total content of acid dianhydride residues having 4 to 20 carbon atoms and including an alicyclic structure is 20 to 100 mol%.
[13] The photosensitive resin composition according to [11] or [12], wherein the resin (A) contains one or more acid dianhydride residues selected from the group consisting of formulas (15), (16), and (85) to (94). 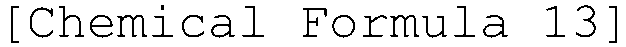 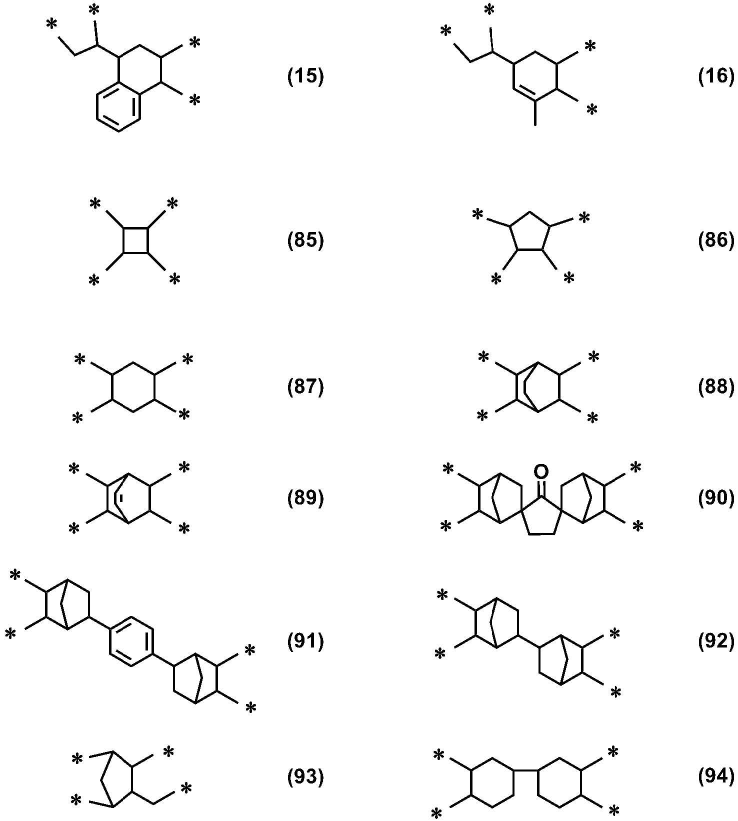 (In formulas (15), (16), and (85) to (94), * represents a bonding site bonded to an imide structure, an amide structure, an amide acid ester structure, or an amide acid structure.)
[14] The photosensitive resin composition according to any one of [1] to [13], wherein the imide ring closure rate of the resin (A) is 50% or less.
[15] The photosensitive resin composition according to any one of [1] to [14], wherein the resin (A) has an esterification rate of 10% or more and 100% or less.
[16] The photosensitive resin composition according to any one of [1] to [15], wherein the solvent (C) contains a solvent represented by formula (17) and/or a solvent (C1) represented by formula (18). 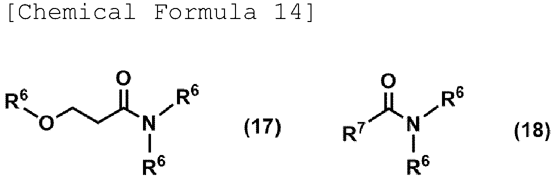
   (In formulas (17) and (18), R⁶ each independently represents an alkyl group having 1 to 6 carbon atoms, and
   R⁷ represents an alkyl group having 2 to 6 carbon atoms.)
[17] The photosensitive resin composition according to any one of [1] to [16], wherein the solvent (C) includes a solvent (C2) having a hydroxyl group and a boiling point of 100°C or more and 200°C or less at atmospheric pressure.
[18] The photosensitive resin composition according to any one of [1] to [17], wherein
   the photosensitive resin composition includes both a solvent (C1) represented by formula (17) and/or formula (18), the solvent (C1) being hereinafter, referred to as solvent (C1), and a solvent (C2) having a hydroxyl group and a boiling point of 100°C or more and 200°C or less at atmospheric pressure, the solvent (C2) being hereinafter, referred to as solvent (C2), and
   a content ratio Y/X in the photosensitive resin composition is 1 or more and 1000 or less, where X (mass) is the content of the solvent (C1) and Y (mass) is the content of the solvent (C2).
[19] A cured product obtained by curing the photosensitive resin composition according to any one of [1] to [18].
[20] A display device comprising the cured product according to [19].
[21] An electronic component comprising the cured product according to [19].

### EFFECTS OF THE INVENTION

According to the present invention, it is possible to obtain a photosensitive resin composition having good thinner solubility, capable of suppressing contamination of an opening after curing and suppressing foaming at the time of lamination, and having a cured product having good light emission characteristics even after a reliability test, a cured product obtained by curing the photosensitive resin composition, and a display device and an electronic component each comprising a cured product of the photosensitive resin composition.

### BRIEF DESCRIPTION OF THE DRAWINGS

Fig. 1 is a cross-sectional view of a planarity evaluation sample.
Fig. 2 is a schematic view showing a method of manufacturing an organic EL display device including a planarization layer and a pixel defining layer in Examples.

### EMBODIMENTS OF THE INVENTION

Hereinafter, the present invention will be described in detail.

In the present description, a numerical range represented using "to" means a range including numerical values located before and after "to" as the lower limit and the upper limit.

In addition, in the present specification, as for the polyimide, since it is intended that an imide ring is formed after the operation of curing, a structure before ring-closing to the imide ring, that is, what has a structure of an amide acid (or an amic acid) or an ester of the acid is also included, and as for the polybenzoxazole, since it is intended that a benzoxazole ring is formed after the operation of curing, a structure before ring-closing to the oxazole ring, that is, what has a structure of a hydroxyamide is also included.

The photosensitive resin composition of the present invention contains a resin (A) (hereinafter, referred to as resin (A)) including at least one of a structural unit represented by formula (1), a structural unit represented by formula (19), and a structural unit represented by formula (70).

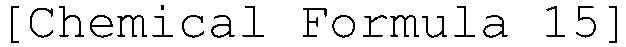

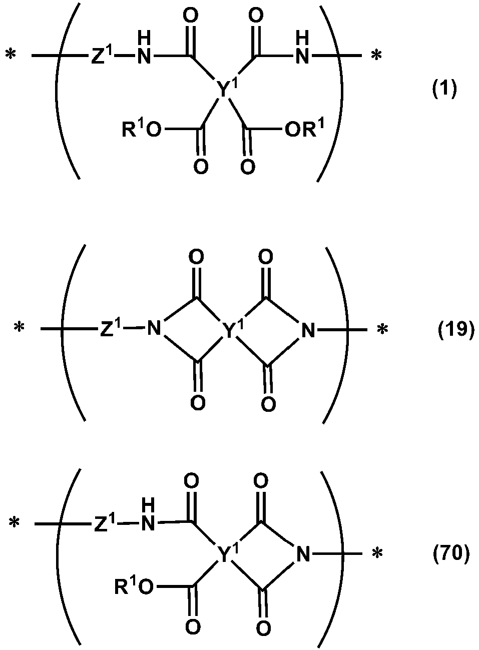

In formulas (1), (19), and (70), Y¹ each independently represents an acid dianhydride residue having 2 to 40 carbon atoms and having any one of an aliphatic structure having 2 to 20 carbon atoms, an alicyclic structure having 4 to 40 carbon atoms, and an aromatic structure having 6 to 40 carbon atoms. Z¹ each independently represents a diamine residue represented by any one of formulas (2) to (4). R¹ each independently represents a hydrogen atom, an alkyl group having 1 to 20 carbon atoms, or a monovalent group having 2 to 20 carbon atoms and having an ethylenically unsaturated double bond. * represents a bonding site.

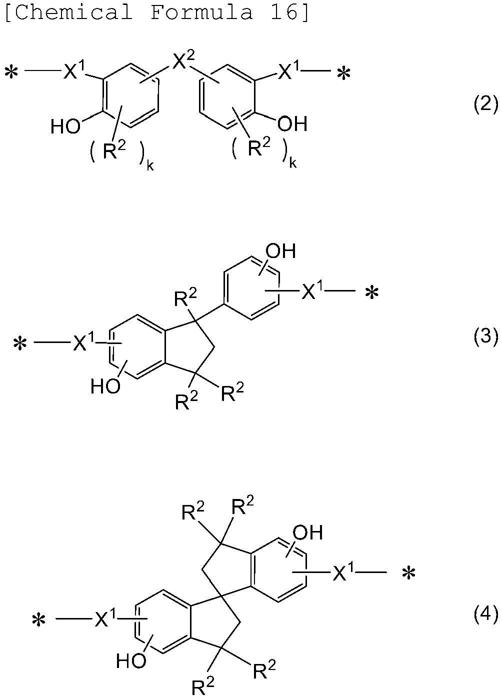

In the formulas (2), (3) and (4), X¹ each independently represents a direct bond or a divalent group represented by formula (5), R² each independently represents an alkyl group having 1 to 4 carbon atoms, X² is a divalent group represented by formula (6) or (7), k each independently represents 0 or 1, and * represents a bonding site bonded to an imide structure, an amide structure, an amide acid ester structure, or an amide acid structure.

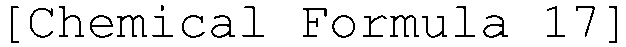

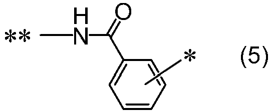

In formula (5), * represents a bonding site bonded to a nitrogen atom. ** represents a bonding site bonded to an aromatic ring.

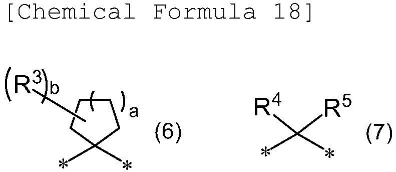

In formulas (6) and (7), R³ each independently represents an alkyl group having 1 to 4 carbon atoms, a represents 1 or 2, b represents an integer of 1 to 3, R⁴ and R⁵ each independently represent a hydrocarbon group having 1 to 10 carbon atoms or a hydrogen atom, and * represents a bonding site bonded to an aromatic ring, provided that R⁴ and R⁵ do not have the same structure.

Formula (1), formula (19), and formula (70) are all structural units of polyimide, formula (1) represents a structural unit in which the amide acid structure or the amide acid ester structure in the structural unit is not ring-closed and all are an amide acid structure or an amide acid ester structure, the structural unit represented by formula (19) represents a structural unit in which all of the amide acid structure or the amide acid ester structure in the structural unit are ring-closed and imidized, and the structural unit represented by formula (70) represents a structural unit in which one amide acid structure or amide acid ester structure in the structural unit is not ring-closed and the other amide acid structure or amide acid ester structure is ring-closed and imidized. When the resin (A) has the structural units of formula (1) and formula (70), the thinner solubility is good and the residual substance can be reduced. In addition, since the resin (A) has the structural unit of formula (19), it is possible to reduce the amount of outgas under a high temperature of a cured product obtained by curing the photosensitive resin composition and to suppress foaming during lamination. When the numbers of the structural unit represented by formula (1), the structural unit represented by formula (19), and the structural unit represented by formula (70) in the resin (A) are p, q, and r, respectively, p + q + r is an integer of 1 or more, and it is preferable that p ≥ 1 or r ≥ 1. When the total number of structural units of the polyimide constituting the resin (A) is 100 mol%, the total of the structural unit represented by formula (1), the structural unit represented by formula (19), and the structural unit represented by formula (70) is preferably 30 to 100 mol%, more preferably 40 to 100 mol%, still more preferably 50 to 100 mol%, and particularly preferably 60 to 100 mol%. By the ratio of the structural units of formula (1), formula (19), and formula (70) being within the above range, it becomes possible to obtain a photosensitive resin composition in which solvent solubility is good, contamination of the opening after curing is suppressed, and suppression of foaming during lamination is possible. The structural unit of polyimide herein refers to a structural unit in which an imide ring is to be formed after a curing operation. It also includes a structure before ring-closing to the imide ring, that is, a structure of an amide acid (or an amic acid) or an ester of the acid. Specifically, in the present application, the structural unit of the polyimide is represented by formulas (73), (74), and (75).

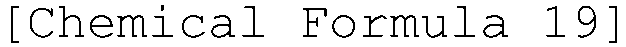

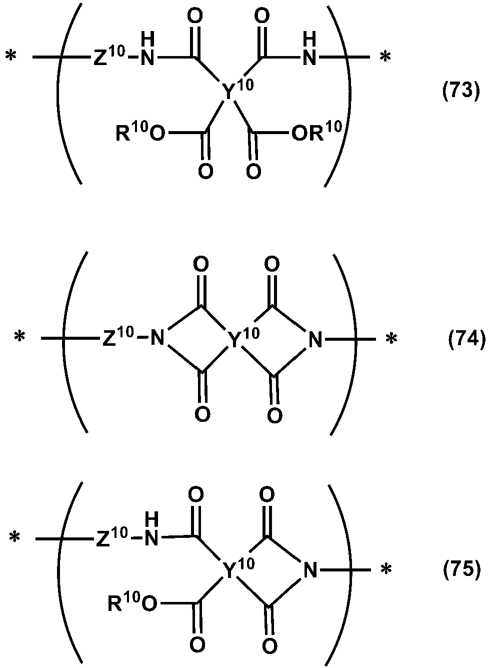

In formulas (73), (74), and (75), Y¹⁰ each independently represents an acid dianhydride residue. Z¹⁰ each independently represents a diamine residue. R¹⁰ each independently represents a hydrogen atom or a monovalent group. * represents a bonding site.

When the resin (A) has a structural unit other than polyimide, it is preferable that the resin (A) has a polybenzoxazole structural unit from the viewpoint that a cured product having good heat resistance can be obtained. When including a structural unit of polybenzoxazole, the resin (A) preferably has, for example, one or more selected from the group consisting of a structural unit represented by formula (38), a structural unit represented by formula (39), and a structural unit represented by formula (40).

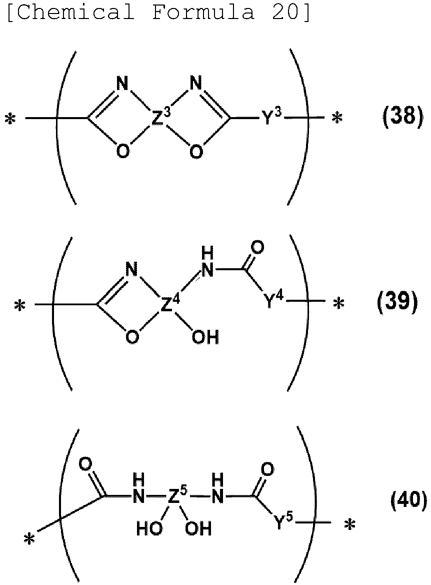

In formulas (38), (39), and (40), Y³, Y⁴, and Y⁵ represent a dicarboxylic acid residue, and Z³, Z⁴, and Z⁵ represent a bisaminophenol residue. The dicarboxylic acid residue is a residue obtained by removing two carboxyl groups from the dicarboxylic acid compound. The bisaminophenol residue is a residue obtained by removing two amino groups and two hydroxyl groups from the bisaminophenol compound.

The structural unit represented by formula (38) represents a structural unit in which all of the hydroxyamide structures in the structural unit are ring-closed and oxazolated. Formula (39) represents a structural unit in which a part of the hydroxyamide structures in the structural unit is ring-closed and oxazolated, and a part thereof is a hydroxyamide structure. Formula (40) represents a structural unit in which the hydroxyamide structures in the structural unit are not ring-closed, and all thereof are hydroxyamide structures.

When the resin (A) has a structural unit other than polyimide, the total amount of structural units of the polyimide is preferably 50 to 100 mol%, more preferably 65 to 100 mol%, and still more preferably 80 to 100 mol% based on 100 mol% of the total amount of all structural units included in the resin (A). When the polyimide structural unit is included at the above ratio, a cured product having good reliability and excellent heat resistance can be obtained.

The imide ring closure rate of the resin (A) is preferably 90% or less, more preferably 80% or less, and still more preferably 50% or less. When the imide ring closure rate is within the above range, the residual substance can be reduced, and the alkali development speed can be set to a preferable range, so that a good pattern shape can be obtained. In particular, when the imide ring closure rate of the resin (A) is 50% or less, the solvent solubility of the resin (A) is improved, and the aggregation of the resin (A) during storage is suppressed. As a result, the storage stability of the photosensitive resin composition can be improved, which is preferable. The imide ring closure rate of the resin (A) is determined by the method described later.

The esterification rate of the resin (A) is preferably 10% or more and 100% or less, more preferably 20% or more and 98% or less, still more preferably 30% or more and 95% or less, and particularly preferably 35% or more and 90% or less. When the esterification rate is within the above range, the residual substance can be reduced, and a photosensitive resin composition excellent in thinner solubility can be obtained. The esterification rate of the resin (A) is determined by the method described later.

R¹ in formula (1) are each independently preferably an alkyl group having 1 to 10 carbon atoms or a monovalent organic group having an ethylenically unsaturated double bond, and more preferably an alkyl group having 1 to 3 carbon atoms or a monovalent organic group having an ethylenically unsaturated double bond. When R¹ is an alkyl group having 1 to 10 carbon atoms or a monovalent organic group having an ethylenically unsaturated double bond, solubility in a developer can be adjusted to a preferable range, so that a good pattern shape can be obtained. In addition, when R¹ is a monovalent organic group having an ethylenically unsaturated double bond, it is preferable because in addition to the above, improvement of elongation at break and improvement of chemical resistance are possible by the progress of a crosslinking reaction during thermal curing. Examples of the alkyl group include a methyl group, an ethyl group, a propyl group, an isopropyl group, a butyl group, an isobutyl group, a t-butyl group, a pentyl group, and a hexyl group, and examples of the monovalent organic group having an ethylenically unsaturated double bond include a structure in which a hydroxyl group is removed from 2-hydroxyethyl methacrylate (HEMA) or 2-hydroxyethyl acrylate.

In formulas (1), (19), and (70), Y¹ each independently represents an acid dianhydride residue having 2 to 40 carbon atoms and having any one of an aliphatic structure having 2 to 20 carbon atoms, an alicyclic structure having 4 to 40 carbon atoms, and an aromatic structure having 6 to 40 carbon atoms. The acid dianhydride residue refers to a residue obtained by removing two acid anhydride structures from an acid dianhydride compound.

Specific examples of Y¹ include residues of alicyclic tetracarboxylic dianhydrides such as 1,2-dimethyl-1,2,3,4-cyclobutanetetracarboxylic dianhydride, 1,2,3,4-tetramethyl-1,2,3,4-cyclobutanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, bicyclo[2.2.2]oct-7-ene-2,3,5,6-tetracarboxylic dianhydride, 2,3,4,5-tetrahydrofurantetracarboxylic dianhydride, 3,5,6-tricarboxy-2-norbornaneacetic dianhydride, 1,3,3a,4,5,9b-hexahydro-5-(tetrahydro-2,5-dioxo-3-furanyl)naphtho[1,2-c]furan-1,3-dione, and 5-(2,5-dioxotetrahydrofuryl)-3-methyl-3-cyclohexene-1,2-dicarboxylic anhydride,
residues of aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,2,5,6-naphthalenetetracarboxylic dianhydride, 2,3,6,7-naphthalenetetracarboxylic dianhydride, 2,3,5,6-pyridinetetracarboxylic dianhydride, and 3,4,9,10-perylenetetracarboxylic dianhydride, and
residues of aromatic acid dianhydrides such as bis(3,4-dicarboxyphenyl)sulfone dianhydride, 4,4'-oxydiphthalic anhydride, 3,4'-oxydiphthalic anhydride, 3,3'-oxydiphthalic anhydride, 2,2-bis(3,4-dicarboxyphenyl)hexafluoropropane dianhydride, 2,2-bis(4-(3,4-dicarboxyphenoxy)phenyl)propane dianhydride, 2,2-bis(3-(3,4-dicarboxyphenoxy)phenyl)propane dianhydride, 2,2-bis(4-(3,4-dicarboxyphenoxy)phenyl)hexafluoropropane dianhydride, 2,2-bis(3-(3,4-dicarboxyphenoxy)phenyl)hexafluoropropane dianhydride, 9,9-bis(3,4-dicarboxyphenyl)fluorene dianhydride, 9,9-bis[4-(3,4-dicarboxyphenoxy)phenyl]fluorene dianhydride, and 4,4'-(1,4-phenylenedioxy)bisphthalic anhydride, or a compound obtained by substituting an aromatic ring of these compounds with an alkyl group or a halogen atom, and an acid dianhydride having an amide group.

Among them, in the above formulas (1), (19), and (70), it is preferable that Y¹ each independently represents an acid dianhydride residue having 8 to 40 carbon atoms and a diphenyl ether structure. By satisfying the above conditions, the cured product obtained by curing the photosensitive resin composition can have good light emission characteristics even after the reliability test. Specific examples of Y¹, which is an acid dianhydride residue having a diphenyl ether structure and having 8 to 40 carbon atoms, include for example residues such as 4,4'-oxydiphthalic anhydride, 3,4'-oxydiphthalic anhydride, 3,3'-oxydiphthalic anhydride, 2,2-bis(4-(3,4-dicarboxyphenoxy)phenyl)propane dianhydride, and 4,4'-(1,4-phenylenedioxy)bisphthalic anhydride.

Among them, the resin (A) preferably includes an acid dianhydride residue including an alicyclic structure and 4 to 20 carbon atoms. That is, Y¹ is preferably an acid dianhydride residue having 4 to 20 carbon atoms and including an alicyclic structure. When Y¹ is an acid dianhydride residue having 4 to 20 carbon atoms and including an alicyclic structure, it is possible to obtain a photosensitive resin composition capable of obtaining a cured product having good sensitivity, small coloration in the visible light region, and high transmittance.

When the total amount of the acid dianhydride residues in the resin (A) is 100 mol%, the total content of the acid dianhydride residues having 4 to 20 carbon atoms and including an alicyclic structure is preferably 20 to 100 mol%, and more preferably 30 to 100 mol%.

In addition, it is preferable to contain one or more kinds of acid dianhydride residues selected from the group consisting of formulas (15), (16), and (85) to (94) as the acid dianhydride residue having 4 to 20 carbon atoms and including an alicyclic structure. Among them, it is preferable to contain an acid dianhydride residue represented by formula (15) and/or formula (16). The acid dianhydride residue represented by formula (15) is a residue obtained by removing two acid anhydride structures from 1,3,3a,4,5,9b-hexahydro-5-(tetrahydro-2,5-dioxo-3-furanyl)naphtho[1,2-c]furan-1,3-dione, and the acid dianhydride residue represented by formula (16) is a residue obtained by removing two acid anhydride structures from 5-(2,5-dioxotetrahydrofuryl)-3-methyl-3-cyclohexene-1,2-dicarboxylic anhydride. By including these acid anhydride residues, it is possible to obtain a photosensitive resin composition which is particularly excellent in thinner solubility and has less residual substance.

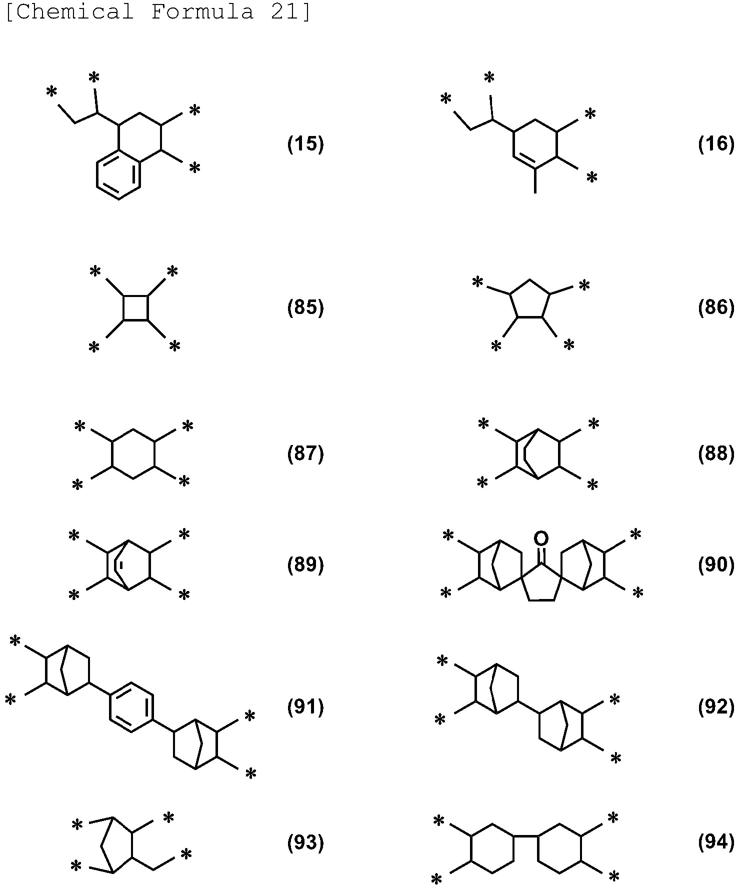

In formulas (15), (16), and (85) to (94), * represents a bonding site bonded to an imide structure, an amide structure, an amide acid ester structure, or an amide acid structure.

When the total amount of diamine residues in the resin (A) including at least one of the structural unit represented by formula (1), the structural unit represented by formula (19), and the structural unit represented by formula (70) is 100 mol%, the total content of diamine residues represented by any one of formulas (2) to (4) is 30 to 100 mol%. That is, in formulas (1), (19), and (70), Z¹ each independently represents a diamine residue represented by any one of formulas (2) to (4). The diamine residue refers to a structure obtained by removing two amino groups from the diamine compound. Since both diamine residues represented by any one of formulas (2) to (4) have a phenolic hydroxyl group, solubility in an alkaline developer can be imparted, and development residual substances can be reduced. In addition, by having the diamine residue represented by any one of formulas (2) to (4), intermolecular packing is suppressed, and thinner solubility can be improved. In addition, since the structure does not include fluorine, it is possible to suppress contamination of the opening after curing and to suppress foaming at the time of lamination.

By including the diamine residue represented by any one of formulas (2) to (4), it is possible to suppress opening contamination after curing and suppress foaming during lamination. Although the detailed mechanism is unknown, the principle of obtaining the above effect is estimated as follows. For example, when polyimide using a fluorine-containing diamine described in International Publication No. 2016/047483 is used, it is considered that the hexafluoroisopropylidene group is thermally decomposed in the step of thermal curing, and the fluorine-containing hydrocarbon group adheres to the opening to cause opening contamination. On the other hand, since all of the diamine residues represented by any one of formulas (2) to (4) have a structure that does not include fluorine, it is considered that opening contamination caused by fluorine-containing hydrocarbon groups does not occur, and as a result, opening contamination after curing is suppressed. In addition, it is considered that when polyimide using a fluorine-containing diamine is used, fluorine, which is an electron-withdrawing group, suppresses the progress of the imide ring-closing reaction in the step of thermal curing. As a result, it is considered that the imide ring-closing reaction is not completed in a predetermined thermal curing step, and the amide acid structure remains in the film. Since the remaining amide acid structure is gradually imide-ring-closed in the additional heating step to generate water, it is considered to be a cause of foaming at the time of forming the laminate and a cause of lowering the reliability of the organic EL display device. On the other hand, since all of the diamine residues represented by any one of formulas (2) to (4) have a structure that does not include fluorine, the imide ring-closing reaction rapidly proceeds in the thermal curing step, and almost no amide acid structure remains in the film after the thermal curing step. As a result, it is estimated that foaming and a decrease in reliability are suppressed.

In formula (2), formula (3), and formula (4), X¹ is each independently a direct bond or a divalent group represented by formula (5). When X¹ is a direct bond, the hydroxyl group concentration of the resin (A) can be increased, so that residual substances after development can be reduced, which is preferable. Further, it is preferable since X¹ is a divalent organic group represented by formula (5), a structure of hydroxyamide, which is a benzoxazole precursor, is formed in the structure of formula (2), and the hydroxyamide undergoes ring-closure to form an oxazole ring in the curing step, so that a cured product having low water absorption can be obtained. In formulas (2), (3) and (4), R² each independently represents an alkyl group having 1 to 4 carbon atoms. Among them, R² is preferably a methyl group from the viewpoint that the heat resistance of the resin (A) can be enhanced and the development residual substance can be reduced. In formula (2), X² is a divalent group represented by formula (6) or (7), and in formulas (6) and (7), R³ each independently represents an alkyl group having 1 to 4 carbon atoms, a represents 1 or 2, b represents an integer of 1 to 3, and R⁴ and R⁵ each independently represent a hydrocarbon group having 1 to 10 carbon atoms or a hydrogen atom, provided that R⁴ and R⁵ do not have the same structure. By including the structure represented by formula (6) or formula (7), intermolecular packing is suppressed, and thinner solubility can be enhanced. Among them, from the viewpoint that the chemical resistance of the cured product obtained by curing the photosensitive resin composition can be further improved, it is preferable to include the structure represented by formula (7). R3 each independently is an alkyl group having 1 to 4 carbon atoms, and is preferably a methyl group from the viewpoints that the heat resistance of the resin (A) can be enhanced and development residual substance can be reduced. When a represents 1 or 2 and b represents an integer of 1 to 3, heat resistance and thinner solubility of the resin (A) can be compatible, which is preferable. R4 and R⁵ each independently represent a hydrocarbon group having 1 to 10 carbon atoms or a hydrogen atom, and from the viewpoint that the heat resistance of the resin (A) can be enhanced and the development residual substance can be reduced, R⁴ and R⁵ each independently preferably represent a saturated hydrocarbon group having 1 to 10 carbon atoms, and more preferably a saturated hydrocarbon group having 1 to 8 carbon atoms, provided that R⁴ and R⁵ do not have the same structure. The phrase "not have the same structure" as used herein includes cases where the relationship between R⁴ and R⁵ is a relationship having different composition formulas, as well as cases where they are structural isomers having the same composition formula but different bonding states between atoms. Since R⁴ and R⁵ do not have the same structure, it is possible to improve the thinner solubility of the resin (A). In formula (2), k each independently represents 0 or 1. When k is 0, development residual substances can be reduced, which is preferable. When k = 1, a photosensitive resin composition having good thinner solubility can be obtained, and the dielectric constant of a cured product obtained by curing the photosensitive resin composition can be reduced, which is preferable.

When the total amount of the diamine residues in the resin (A) is 100 mol%, the total content of the diamine residues represented by any one of formulas (2) to (4) is 30 to 100 mol%, preferably 40 to 100 mol%, more preferably 50 to 100 mol%, and still more preferably 60 to 100 mol%. Among them, the total content of the diamine residues represented by formula (2) is preferably within the above range. When the total content of the diamine residues represented by any one of formulas (2) to (4) is within the above range, it is possible to obtain a photosensitive resin composition having a small development residual substance and good sensitivity.

Specific examples of the diamine residue represented by any one of formulas (2) to (4) include diamine residues represented by formulas (20) to (37).

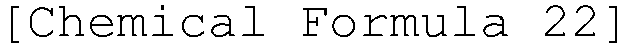

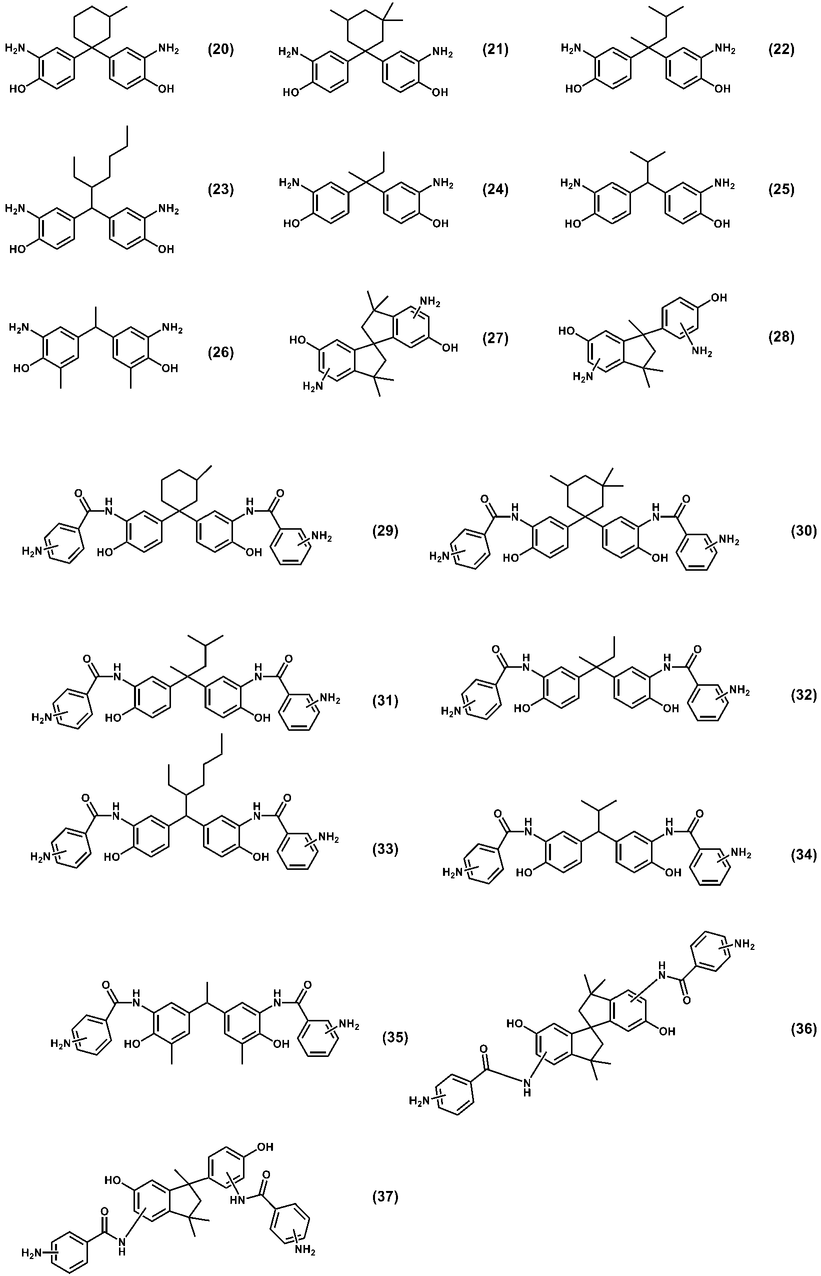

In particular, it is preferable that the resin (A) includes a diamine residue represented by formula (2), the total number of carbon atoms of R³ is 1 or more and 5 or less in formula (6), and the total number of carbon atoms of R⁴ and R⁵ is 3 or more and 10 or less in formula (7). The expression "in the formula (6), the total number of carbon atoms of R³ is 1 or more and 5 or less" referred to here means that, for example, in a case where there is a plurality of R³ in the formula (6), the sum of the number of the carbon atoms of each of the plurality of R³ is 1 or more and 5 or less. In addition, the expression "in the formula (7), the total number of carbon atoms of R⁴ and the carbon atoms of R⁵ is 3 or more and 10 or less" referred to here means that the sum of the counted number of the carbon atoms of R⁴ and the counted number of the carbon atoms of R⁵ is 3 or more and 10 or less. When the number of carbon atoms of R³, R⁴, and R⁵ is within the above range, a photosensitive resin composition having good thinner solubility can be obtained without deteriorating development residual substances and sensitivity, which is preferable.

In particular, it is preferable that when the resin (A) includes a diamine residue represented by formula (2), and in formula (6), when a = 1 is represented by formula (6-1) and a = 2 is represented by formula (6-2), Condition 1 and Condition 2 are satisfied, and in formula (7), the number of carbon atoms of R⁴ is different from the number of carbon atoms of R⁵.

Condition 1: In formula (6-1), the total number of carbon atoms of R¹¹ to R¹⁴ is different from the total number of carbon atoms of R¹⁵ to R¹⁸.

Condition 2: In formula (6-2), the total number of carbon atoms of R¹⁹ to R²² is different from the total number of carbon atoms of R²⁵ to R²⁸.

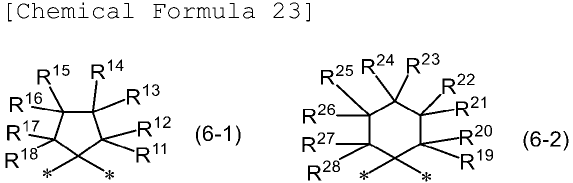

In formula (6-1) and formula (6-2), R¹¹ to R²⁸ each independently represent a hydrogen atom or an alkyl group having 1 to 4 carbon atoms, provided that both formulas (6-1) and (6-2) satisfy the condition of formula (6).

When formula (6) and formula (7) satisfy the above conditions, packing between the resins (A) can be suppressed, and a photosensitive resin composition having particularly good thinner solubility can be obtained, which is preferable.

Among them, it is preferable that the resin (A) includes a diamine residue represented by formula (2), and X² is a divalent group represented by any one of formulas (8) to (13) and (76) to (83).

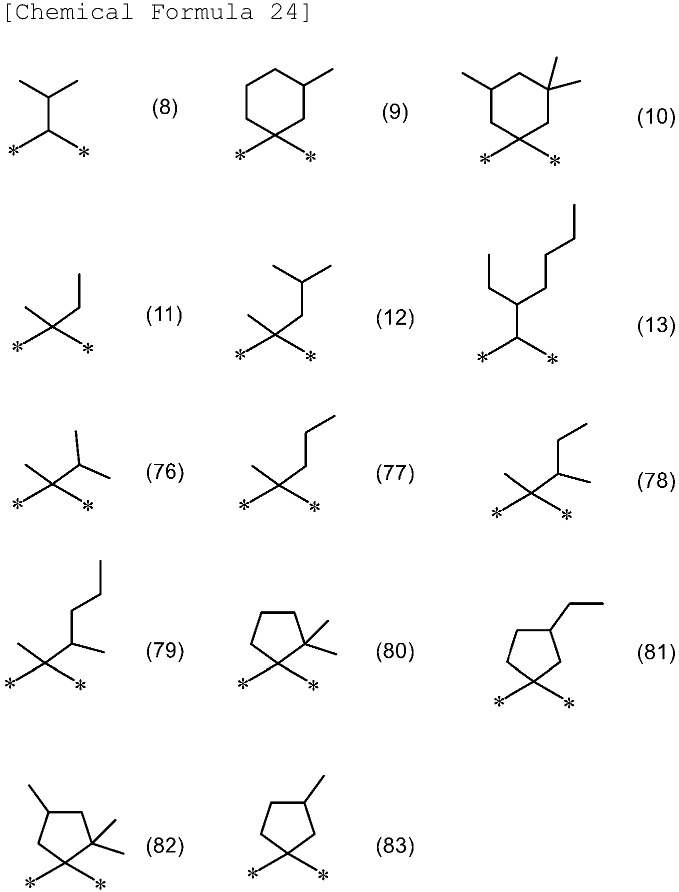

In formulas (8) to (13) and (76) to (83), * represents a bonding site bonded to an aromatic ring.

Specifically, in formulas (1), (19), and (70), Z¹ is preferably a residue of any diamine of formulas (20) to (25) and formulas (29) to (34). By including the residue of the diamine, the thinner solubility can be further enhanced.

In addition, it is preferable that the resin (A) includes a diamine residue represented by formula (2) and k = 1. When k = 1, a photosensitive resin composition having good thinner solubility can be obtained, and the dielectric constant of a cured product obtained by curing the photosensitive resin composition can be reduced. Specifically, in formula (1), (19), and (70), Z¹ is preferably a residue of the diamine of any one of formula (26) and formula (35).

Preferably, the resin (A) includes a diamine residue represented by formula (2), and R² in formula (2) is a methyl group. When R² is a methyl group, it is possible to obtain a photosensitive resin composition having good sensitivity and few residual substances. In addition, it is possible to reduce the dielectric constant of a cured product obtained by curing the photosensitive resin composition. Specifically, in formula (1), (19), and (70), Z¹ is preferably a residue of the diamine of any one of formula (26) and formula (35).

The resin (A) may have another diamine residue in addition to the above-mentioned diamine residue.

Specific examples of the other diamine residue include an aliphatic diamine residue and an aromatic diamine residue. The aliphatic diamine residue means a residue of a diamine having no aromatic ring. Examples of the aliphatic diamine residue include residues of aliphatic alkyldiamines containing an alkylene group, or an alkylene ether group such as a polyethylene ether group, a polyoxypropylene group, or a tetramethylene ether group, alicyclic diamines, and aliphatic diamines having a siloxane structure.

Examples of aliphatic alkylene diamine residues include residues of
polymethylenediamines such as tetramethylenediamine, hexamethylenediamine, octamethylenediamine, decamethylenediamine, dodecamethylenediamine, 7-ethylhexadecanediamine, 7,12-dimethyloctadecanediamine, 8,13-dimethyloctadecanediamine, 8-methylnonadecanediamine, 9-methylnonadecanediamine, 7,12-dimethyloctadecanediamine-7,11-ene, 8,13-dimethyloctadecanediamine-8,12-ene, and Diamine H20 (trade name, manufactured by OKAMURA OIL MILL, LTD.);
diamines containing polyethylene ether groups such as JEFFAMINE KH-511, JEFFAMINE ED-600, JEFFAMINE ED-900, JEFFAMINE ED-2003, JEFFAMINE EDR-148, and JEFFAMINE EDR-176;
polyoxypropylenediamines such as D-200, D-400, D-2000, D-4000, RP-409, and RP-2009;
diamines containing tetramethylene ether groups such as RT-1000 and HT-1100, and amino group-containing alkylene ether diamines such as HT-1000 and HE-1000 (all of which are trade names, manufactured by Huntsman Corporation); and
dimer diamines such as "Versamine" (registered trademark) 551 and "Versamine" (registered trademark) 552 (manufactured by BASF SE), and "Priamine" (registered trademark) 1073, "Priamine" (registered trademark) 1074, and "Priamine" (registered trademark) 1075 (manufactured by Cargill, Incorporated).

Examples of the alicyclic diamine residue include residues of cyclohexyldiamine, methylenebis(cyclohexylamine), norbornanediamine, and PRO-NBDA (trade name, manufactured by Mitsui Fine Chemicals, Inc.).

Examples of the aliphatic diamine residue having a siloxane structure include residues of 1,3-bis(3-aminopropyl)tetramethyldisiloxane (hereinafter SiDA) and bis(p-aminophenyl)octamethylpentasiloxane. When an aliphatic group having a siloxane structure is copolymerized in a range in which heat resistance is not deteriorated, adhesion property with a substrate can be improved.

Examples of other aromatic diamine residues include
residues of diamines such as 1,4-bis(4-aminophenoxy)benzene, 1,3-bis(3-aminophenoxy)benzene, 1,3-bis(4-aminophenoxy)benzene, bis[4-(4-aminophenoxy)phenyl]sulfone, bis[4-(3-aminophenoxy)phenyl]sulfone, 2,2-bis[4-(4-aminophenoxy)phenyl]propane, 2,2-bis[4-(4-aminophenoxy)phenyl]hexafluoropropane, 2,2-bis(3-amino-4-hydroxyphenyl)hexafluoropropane (BAHF), bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, bis(3-amino-4-hydroxyphenyl)fluorene, 2,2-bis[3-(3-aminobenzamido)-4-hydroxyphenyl]propane (HB), 2,2-bis[3-(3-aminobenzamido)-4-hydroxyphenyl]-1,1,1-trifluoroethane, bis(3-amino-4-hydroxyphenyl)sulfone, 9,9-bis(3-amino-4-hydroxyphenyl)fluorene (AZ-FDA), and 2,2-bis(3-amino-4-hydroxyphenyl)propane (BAP). Among them, from the viewpoint of solubility in an alkaline developer, residues of hydroxyl group-containing diamines such as BAHF, BAP, AZ-FDA, 2,2-bis[3-(3-aminobenzamido)-4-hydroxyphenyl]propane (HB), and 2,2-bis[3-(3-aminobenzamido)-4-hydroxyphenyl]hexafluoropropane;
residues of sulfonic acid-containing diamines such as 3-sulfonic acid-4,4'-diaminodiphenyl ether;
residues of thiol group-containing diamines such as dimercaptophenylenediamine;
residues of aromatic diamines such as 3,4'-diaminodiphenyl ether, 4,4'-diaminodiphenyl ether, 3,4'-diaminodiphenylmethane, 4,4'-diaminodiphenylmethane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl; and
residues of compounds in which some of hydrogen atoms of these aromatic rings are substituted with an alkyl group having 1 to 10 carbon atoms, a fluoroalkyl group.

These diamine residues can be used as they are, as corresponding diisocyanate compounds, or as corresponding trimethylsilylated diamines. These may be used alone or in combination of two or more.

The end of the resin (A) may be capped with an end-capping agent such as a monoamine, an acid anhydride, a monoacid chloride, a monocarboxylic acid, or a monoactive ester. The dissolution rate of the resin in an alkaline aqueous solution can be easily adjusted to a preferable range by capping an end of the resin with an end-capping agent. Among them, it is preferable to use an end-capping agent having a phenolic hydroxyl group or a crosslinkable group. By using the end-capping agent having a phenolic hydroxyl group, alkali solubility is imparted to the resin, so that the residual substance can be reduced. In addition, by using the end-capping agent having a crosslinkable group, a crosslinking reaction proceeds in the step of thermal curing, so that a cured film excellent in chemical resistance and elongation at break can be obtained.

Among examples of the monoamine, examples of a monoamine having a phenolic hydroxyl group include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 4-aminosalicylic acid, 5-aminosalicylic acid, 6-aminosalicylic acid, 3-amino-4,6-dihydroxypyrimidine, 2-aminophenol (hereinafter OAP), 3-aminophenol (hereinafter MAP), and 4-aminophenol (hereinafter PAP). Examples of monoamines having a photocrosslinkable group include 2-ethynylaniline, 3-ethynylaniline, 4-ethynylaniline, 2-aminostyrene, 3-aminostyrene, 4-aminostyrene, and examples of other monoamines include aniline, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 2-aminobenzenesulfonic acid, 3-aminobenzenesulfonic acid, and 4-aminobenzenesulfonic acid. Two or more of them may be used.

Among the acid anhydrides, the monocarboxylic acids, the monoacid chloride compounds, or the monoactive ester compounds, examples of those having a phenolic hydroxyl group include 3-hydroxyphthalic anhydride, 3-carboxyphenol, 4-carboxyphenol, 1-hydroxy-7-carboxynaphthalene, 1-hydroxy-6-carboxynaphthalene, and 1-hydroxy-5-carboxynaphthalene. Examples of those having a photocrosslinkable group include maleic anhydride, 5-norbornene-2,3-dicarboxylic anhydride (hereinafter NA), itaconic anhydride, itaconic acid, maleic acid, acrylic acid, methacrylic acid, 3-phenylacrylic acid, crotonic acid, 1,2,3,6-tetrahydrophthalic anhydride, 3,4,5,6-tetrahydrophthalic anhydride, 7-oxabicyclo[2.2.1]hept-5-ene-2,3-dicarboxylic anhydride, and 3-methyl-4-cyclohexene-1,2-dicarboxylic anhydride. Examples of others include acetic anhydride, succinic anhydride, phthalic anhydride, cyclohexanedicarboxylic anhydride, 3-carboxythiophenol, 4-carboxythiophenol, 1-mercapto-7-carboxynaphthalene, 1-mercapto-6-carboxynaphthalene, 1-mercapto-5-carboxynaphthalene, 3-carboxybenzenesulfonic acid, 4-carboxybenzenesulfonic acid, terephthalic acid, phthalic acid, cyclohexanedicarboxylic acid, 1,5-dicarboxynaphthalene, 1,6-dicarboxynaphthalene, 1,7-dicarboxynaphthalene, 2,6-dicarboxynaphthalene, trimellitic anhydride, and cyclohexane-1,2,4-tricarboxylic acid-1,2-anhydride. As the monocarboxylic acids, monoacid chloride compounds in which carboxyl groups of monocarboxylic acids are transformed into acid chlorides may be used, a monoacid chloride compound in which only one carboxyl group of the dicarboxylic acid is transformed into an acid chloride may be used, or an active ester compound obtained by a reaction between a monoacid chloride compound and N-hydroxybenzotriazole or N-hydroxy-5-norbornene-2,3-dicarboximide may be used. Two or more of them may be used.

A plurality of different terminal groups may be introduced by reacting a plurality of end-capping agents.

Among them, the resin (A) preferably has a structure represented by formula (84).

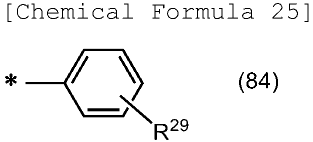

In formula (84), R²⁹ represents a hydroxyl group, an alkyl group having 1 to 3 carbon atoms, an alkoxy group having 1 to 3 carbon atoms, an alkenyl group having 2 to 5 carbon atoms, or an alkynyl group having 2 to 5 carbon atoms. * represents a bonding site with a nitrogen atom.

As used herein, the resin (A) having the structure represented by formula (84) means that the terminal of the resin (A) is capped with an end-capping agent which is a monoamine represented by formula (95).

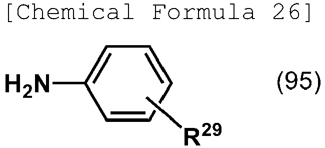

In formula (95), R²⁹ represents a hydroxyl group, an alkyl group having 1 to 3 carbon atoms, an alkoxy group having 1 to 3 carbon atoms, an alkenyl group having 2 to 5 carbon atoms, or an alkynyl group having 2 to 5 carbon atoms.

When the resin (A) has the structure represented by formula (84), the shelf stability of the photosensitive resin composition can be enhanced, which is preferable. From the viewpoint that the shelf stability of the photosensitive resin composition can be particularly enhanced, R²⁹ is preferably a hydroxyl group, an alkyl group having 1 to 2 carbon atoms, an alkoxy group having 1 to 2 carbon atoms, or an alkynyl group having 2 to 3 carbon atoms.

When a monoamine is used as the end-capping agent, the introduction rate thereof is preferably 1 mol% or more and 60 mol% or less with respect to 100 mol% of the total amine compound included in the resin (A). By setting the introduction rate of the monoamine to preferably 1 mol% or more, more preferably 5 mol% or more, the effect of reducing residual substances after development can be effectively obtained. In addition, by setting the introduction rate of the monoamine to preferably 60 mol% or less, more preferably 50 mol% or less, the molecular weight of the resin can be maintained high, and high chemical resistance and high elongation at break can be maintained.

When an acid anhydride, a monocarboxylic acid, a monoacid chloride compound, or a monoactive ester compound is used as the end-capping agent, the total introduction rate thereof is preferably 1 part by mol or more and 100 parts by mol or less with respect to 100 parts by mol of the total amine compounds included in the resin (A). By setting the introduction rate to preferably 1 part by mol or more, more preferably 5 parts by mol or more, the effect of reducing residual substances after development can be effectively obtained. On the other hand, by setting the introduction rate to preferably 100 parts by mol or less, more preferably 90 parts by mol or less, the molecular weight of the resin can be maintained high, and high chemical resistance and high elongation at break can be maintained.

The total amine compounds herein refer to the total content of the compounds having an amino group such as monoamines, diamines, and triamines.

The resin (A) includes a structural unit (a) and/or a structural unit (b), and the resin (A) includes a structural unit (c) and/or a structural unit (d), and
it is preferable that the resin (A) includes at least one of a structural unit (a) and a structural unit (c). The structural units (a) to (d) are as follows.

Structural unit (a): A structural unit represented by formula (1), formula (19), or formula (70), in which Z¹ in formulas (1), (19), and (70) is represented by formula (2), and two X¹ in formula (2) are each a direct bond
Structural unit (b): A structural unit represented by formula (48), formula (49), or formula (71), in which Z³ in formula (48), formula (49), and formula (71) is represented by formula (45), and two X¹ in formula (45) are each a direct bond
Structural unit (c): A structural unit represented by formula (1), formula (19), or formula (70), in which Z¹ in formula (1), formula (19), and formula (70) is represented by formula (2), and at least one X¹ of the two X¹ in formula (2) is a divalent group represented by formula (5)
Structural unit (d): A structural unit represented by formula (48), formula (49), or formula (71), in which Z³ in formula (48), formula (49), and formula (71) is represented by formula (45), and of two X¹ in formula (45), at least one X¹ is a divalent group represented by formula (5)

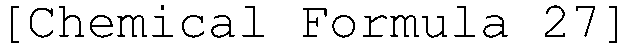

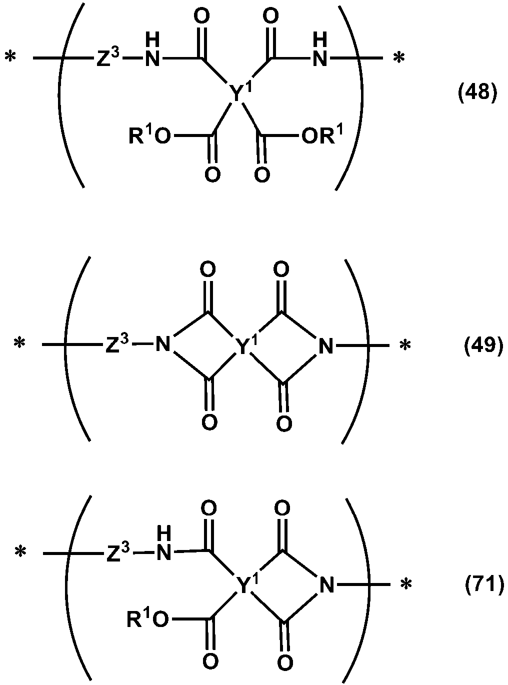

In formulas (48), (49), and (71), Y¹ and R¹ are in the same ranges as those described in formulas (1), (19), and (70). Z³ each independently represents a diamine residue represented by formula (45). * represents a bonding site.

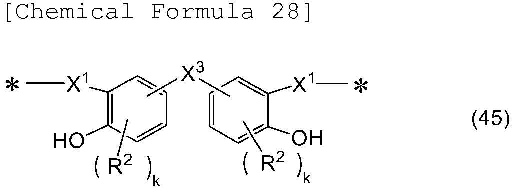

In formula (45), X¹ is each independently a direct bond or a divalent group represented by formula (5), and R² and k are in the same range as those described in formula (2). X³ represents a divalent organic group represented by any one of formulas (64) to (69). * represents a bonding site bonded to an imide structure, an amide structure, an amide acid ester structure, or an amide acid structure.

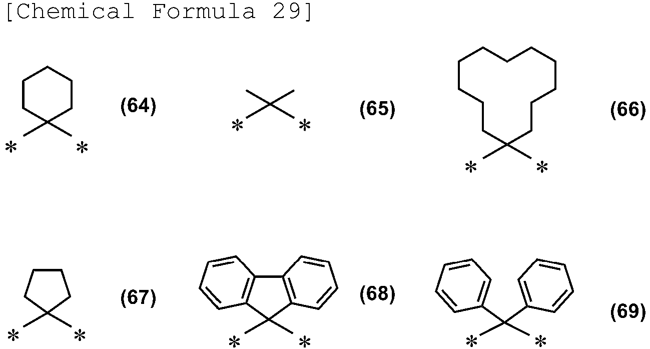

* represents a bonding site bonded to an aromatic ring.

Specific examples of the diamine residue represented by formula (45) include diamine residues represented by formulas (52) to (63).

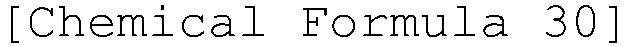

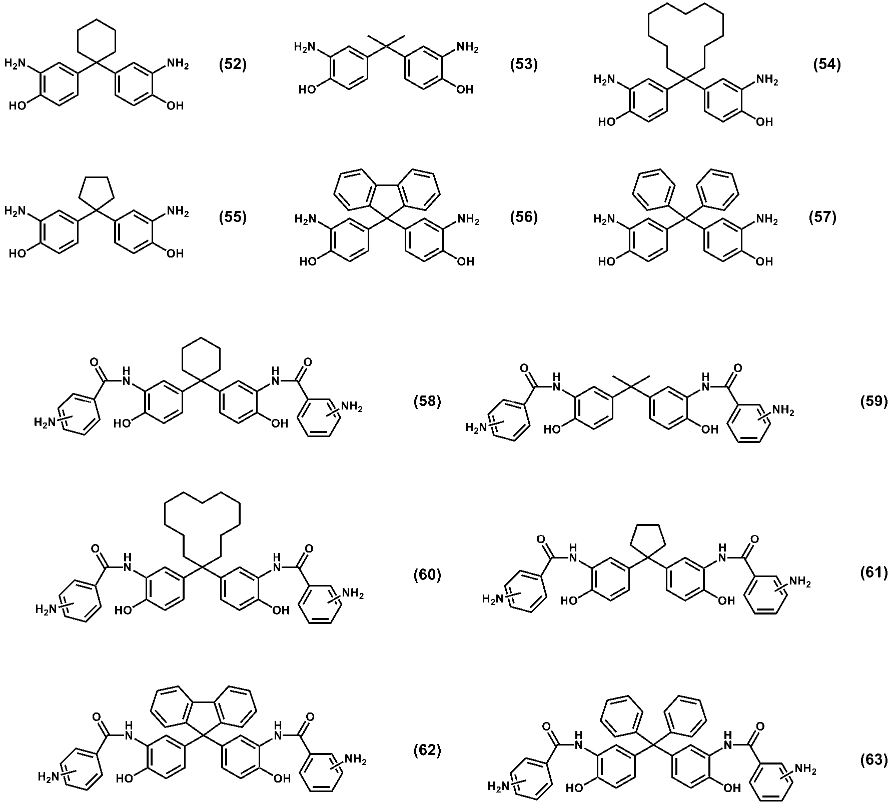

In the structural unit (a) and the structural unit (b), since two X¹ in the formula are both a direct bond, the resin (A) including the structural unit (a) and/or the structural unit (b) makes it possible to reduce residual substances. In the structural unit (c) and the structural unit (d), since at least one X¹ of the two X¹ in the formula is a divalent group represented by formula (5), the sensitivity can be improved by the resin (A) including the structural unit (c) and/or the structural unit (d). In addition, since the structural unit (a) and the structural unit (c) include the diamine residue represented by formula (2), the solvent solubility of the resin (A) can be improved by the resin (A) including at least one of the structural unit (a) and the structural unit (c). Therefore, the resin (A) includes the structural unit (a) and/or the structural unit (b), the resin (A) includes the structural unit (c) and/or the structural unit (d), and by the resin (A) including at least one of the structural unit (a) and the structural unit (c), it becomes possible to satisfy all the characteristics of sensitivity improvement, residual substance reduction, and excellent solvent solubility. In addition, by including a plurality of structural units having different structures as described above, aggregation of resins when the photosensitive resin composition is formed is suppressed, so that shelf stability of the photosensitive resin composition can be improved.

When the total amount of the polyimide structural units included in the resin (A) is 100 mol %, the total content of the structural units (a) and (b) is preferably 20 to 95 mol %, and the total content of the structural units (c) and (d) is preferably 5 mol % to 80 mol %. The total content of the structural unit (a) and the structural unit (b) is more preferably 25 to 95 mol%, and still more preferably 30 to 95 mol%. In addition, the total content of the structural unit (c) and the structural unit (d) is more preferably 5 mol% to 75 mol%, and still more preferably 5 mol% to 70 mol%. When the resin (A) includes each structural unit within the above range, all the characteristics of sensitivity, residual substance reduction, solvent solubility, and shelf stability can be set to preferable ranges. The structural unit of the polyimide is represented by formulas (73), (74), and (75) as described above.

In the present invention, the content of the structural unit is defined as follows. Here, a calculation method in the case of the structural unit (a) will be described as an example.

The structural unit (a) is a structural unit represented by formula (1), formula (19), or formula (70) (in formula (1), formula (19), and formula (70), Y¹ are each independently an acid dianhydride residue having 2 to 40 carbon atoms and having any structure of an aliphatic structure having 2 to 20 carbon atoms, an alicyclic structure having 4 to 40 carbon atoms, and an aromatic structure having 6 to 40 carbon atoms; Z¹ is represented by formula (2), and the two X¹ in formula (2) are both direct bonds). That is, a structure in which Y¹ which is an acid dianhydride residue and Z¹ (however, two X¹ are both direct bonds) which is a diamine residue are bonded to each other is the structural unit (a). Therefore, when the total amount of acid dianhydride residues included in the resin (A) is 100 mol%, the total amount of acid dianhydride residues corresponding to Y¹ is α mol%, and when the total amount of diamine residues included in the resin (A) is 100 mol%, the total amount of diamine residues corresponding to Z¹ is β mol%, the content of the structural unit (a) when the total amount of structural units of the polyimide is 100 mol% is calculated as follows. 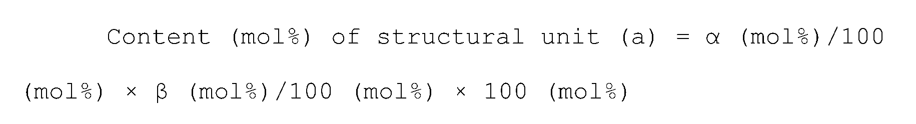 Content (mol%) of structural unit (a) = α (mol%)/100 (mol%) × β (mol%)/100 (mol%) × 100 (mol%)

As an example, when α is 70 mol% and β is 80 mol%, the ratio of structural unit (a) is 70 mol%/100 (mol%) × 80 mol%/100 (mol%) × 100 (mol%) = 56 mol%.

The resin (A) preferably further includes at least one of a structural unit represented by formula (50), a structural unit represented by formula (51), and a structural unit represented by formula (72).

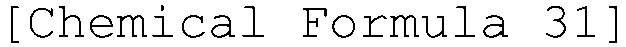

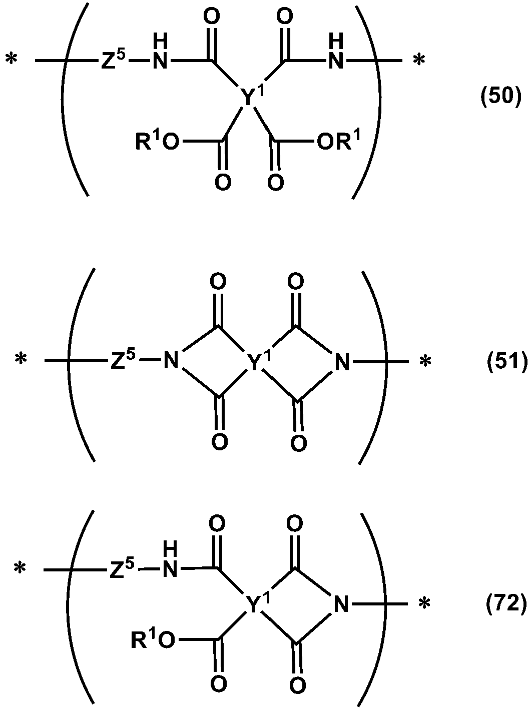

In formulas (50), (51), and (72), Y¹ and R¹ are in the same range as described in formulas (1), (19), and (70). Z⁵ each independently represents a diamine residue represented by formulas (46) or (47). * represents a bonding site.

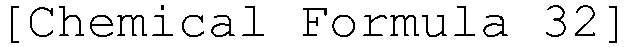

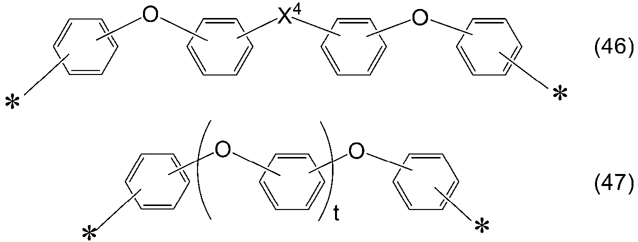

In formulas (46) and (47), X⁴ represents a direct bond or -C(CH₃)₂-. t represents any integer of 0 to 2. * represents a bonding site bonded to an imide structure, an amide structure, an amide acid ester structure, or an amide acid structure.

Since the diamine residue represented by formula (46) or (47) has a partial structure of phenyl ether, including the diamine residue represented by formula (46) or (47) makes it possible to impart flexibility to the resin (A), and as a result, it becomes possible to improve the elongation at break of the cured product of the photosensitive resin composition. Examples of the diamine residue represented by formula (46) or formula (47) include diamine residues such as 3,4'-diaminodiphenyl ether, 4,4'-diaminodiphenyl ether, 3,3'-diaminodiphenyl ether, 1,4-bis(4-aminophenoxy)benzene (TPE-Q), 1,3-bis(3-aminophenoxy)benzene (APB), 1,3-bis(4-aminophenoxy)benzene (TPE-R), 2,2-bis[4-(4-aminophenoxy)phenyl]propane, and 2,2-bis[4-(3-aminophenoxy)phenyl]propane. Among them, from the viewpoint of improving the elongation at break of the cured product and reducing the residual substance of the photosensitive resin composition, it is preferable to include a residue of any diamine of TPE-Q, TPE-R, and APB.

When the total amount of the structural units of the polyimide included in the resin (A) is 100 mol%, the total content of the structural unit represented by formula (50), the structural unit represented by formula (51) and the structural unit represented by formula (72) is preferably 1 to 30 mol% and more preferably 1 to 25 mol%. When the total content of the structural unit represented by formula (50), the structural unit represented by formula (51) and the structural unit represented by formula (72) is within the above range, the elongation at break of a cured product obtained by curing the photosensitive resin composition can be improved without deteriorating the residual substance and sensitivity of the photosensitive resin composition. The structural unit of the polyimide is represented by formulas (73), (74), and (75) as described above.

The weight average molecular weight (Mw) of the resin (A) is preferably 3,000 to 100,000 in terms of polystyrene by gel permeation chromatography (GPC). By setting the Mw to 100,000 or less, more preferably 80,000 or less, and still more preferably 60,000 or less, good solvent solubility and good solubility in a developer can be effectively obtained. By setting the weight average molecular weight to 3,000 or more, more preferably 5,000 or more, and still more preferably 7,000 or more, a high elongation at break can be effectively obtained. In the present invention, Mw is determined by the method described later.

The total amount of components having a molecular weight of 1,000 or less included in the resin (A) is preferably 0.5 to 5.0% by mass, more preferably 0.7 to 4.5% by mass, and still more preferably 1.0 to 4.0% by mass. When the total amount of the components having a molecular weight of 1,000 or less included in the resin (A) is within the above range, development residual substances can be reduced without deteriorating the heat resistance of a cured product obtained by curing the photosensitive resin composition containing the resin (A). Although the detailed mechanism of reduction of the development residual substance is unknown, it is considered that since a component having a molecular weight of 1,000 or less has better alkali solubility than a molecule having a molecular weight of more than 1,000, the component having a molecular weight of 1,000 or less functions as a dissolution promoting component during development and contributes to reduction of the development residual substance. In the present invention, the total amount of components having a molecular weight of 1,000 or less is determined by the method described later.

The resin (A) can be synthesized by a publicly known method. The resin (A) can be synthesized by, as a production method thereof, for example, a method of allowing a tetracarboxylic dianhydride and a diamine compound to undergo a reaction in a polymerization solvent at a low temperature, a method of obtaining a diester from a tetracarboxylic dianhydride and an alcohol, and then allowing the diester to undergo a reaction with an amine in the presence of a condensing agent, a method of obtaining a diester from a tetracarboxylic dianhydride and an alcohol, and then turning the residual dicarboxylic acid into an acid chloride, and allowing the acid chloride to undergo a reaction with an amine, or the like. The resin obtained by the above method may be dehydratively cyclized by heating or chemical treatment with an acid, a base, or the like.

The resin (A) polymerized by the above method is desirably charged into a large amount of deionized water or a mixed solution of methanol/deionized water, precipitated, collected by filtration, dried, and isolated. This precipitation procedure enables the removal of unreacted monomers and an oligomer component, e.g., a dimer and a trimer, thereby improving the film properties and the chemical resistance after heat curing.

The polymerization solvent is merely required to dissolve acid dianhydrides and diamines as raw material monomers, and the type thereof is not particularly limited. Examples of the polymerization solvent include amides such as N,N-dimethylformamide (hereinafter DMF), N,N-diethylformamide (hereinafter DEF), N,N-dimethylacetamide (hereinafter DMAc), N-methyl-2-pyrrolidone (hereinafter NMP), N-ethyl-2-pyrrolidone (hereinafter NEP), 1,3-dimethyl-2-imidazolidinone (hereinafter DMI), 3-methoxy-N,N-dimethylpropanamide (hereinafter MPA), 3-butoxy-N,N-dimethylpropanamide (hereinafter BPA), N,N'-dimethylpropyleneurea (hereinafter DMPU), N,N-dimethylisobutylamide (hereinafter DMIB), N,N-dimethylpropionamide (hereinafter DMPA), and 3-methyl-2-oxazolidinone; cyclic esters such as γ-butyrolactone (hereinafter GBL), γ-valerolactone, δ-valerolactone, γ-caprolactone, ε-caprolactone, and α-methyl-γ-butyrolactone; carbonates such as ethylene carbonate and propylene carbonate; glycols such as triethylene glycol; phenols such as m-cresol and p-cresol; esters such as methyl levulinate, ethyl levulinate, propyl levulinate, butyl levulinate, ethyl levulinate propylene glycol ketal, and ethyl levulinate glycerol ketal; acetophenone, sulfolane, dimethyl sulfoxide (hereinafter DMSO), and dihydrolevoglucosenone (Cyrene, manufactured by Circa). The amount of the polymerization solvent used is preferably 100 to 1,900 parts by mass, and more preferably 150 to 950 parts by mass with respect to 100 parts by mass of the resin (A).

The photosensitive resin composition of the present invention contains a photosensitive agent (B). When the photosensitive agent (B) is included, photosensitivity can be imparted to the resin composition. Examples of the photosensitive agent (B) include a photo acid generator (B1) and a photopolymerization initiator (B2). When the photosensitive resin composition of the present invention contains the photo acid generator (B1), an acid is generated in a part irradiated with light, so that the solubility of the part irradiated with light in an aqueous alkali solution is increased and a positive type relief pattern in which the part irradiated with light dissolves can be obtained. In addition, by containing the photo acid generator (B1) and the crosslinking agent (E), it is possible to obtain a negative type relief pattern in which the acid generated in the part irradiated with light promotes the crosslinking reaction of the crosslinking agent (E) and the part irradiated with light is insolubilized. In addition, by containing the photopolymerization initiator (B2) and the radically polymerizable compound (H), it is possible to obtain a negative type relief pattern in which active radicals generated in a part irradiated with light promote radical polymerization of ethylenically unsaturated bonds in the radically polymerizable compound, so that the part irradiated with light is insolubilized. In the photosensitive resin composition according to the present invention, it is preferable that the photosensitive agent (B) includes the photo acid generator (B1) and exhibits positive type photosensitivity. Since the photosensitive agent (B) includes the photo acid generator (B1) and exhibits positive type photosensitivity, variations in the opening dimension of the pattern due to the processing process can be easily reduced, and residual substances are reduced. When the photosensitive agent (B) contains the photopolymerization initiator (B2) and the radically polymerizable compound (H) and exhibits negative photosensitivity, the sensitivity of the photosensitive resin composition can be enhanced.

Examples of the photo acid generator (B1) include a quinone diazide compound, a sulfonium salt, a phosphonium salt, a diazonium salt, and an iodonium salt.

Examples of the quinone diazide compound include compounds in which a sulfonic acid of quinone diazide is bonded to a polyhydroxy compound by an ester, compounds in which a sulfonic acid of quinone diazide is sulfonamide-bonded to a polyamino compound, and compounds in which a sulfonic acid of quinone diazide is ester-bonded and/or sulfonamide-bonded to a polyhydroxypolyamino compound. It is preferable that 50 mol% or more of the whole functional groups of these polyhydroxy compounds and polyamino compounds are substituted with quinone diazide. In addition, it is preferable that two or more types of the photo acid generator (B1) are contained, and a highly sensitive photosensitive resin composition can thereby be obtained.

In the present invention, as the quinone diazide, either one having a 5-naphthoquinone diazide sulfonyl group or one having a 4-naphthoquinone diazide sulfonyl group is suitably used. A 4-naphthoquinone diazide sulfonyl ester compound has absorption in an i-line region of a mercury lamp, and is therefore suitable for the exposure to i-line. Absorption of a 5-naphthoquinone diazide sulfonyl ester compound extends to the g-line region of the mercury lamp, and the 5-naphthoquinone diazide sulfonyl ester compound is suitable for exposure to g-line. In the present invention, it is preferable to select a 4-naphthoquinone diazide sulfonyl ester compound or a 5-naphthoquinone diazide sulfonyl ester compound depending on the wavelength for exposure. A naphthoquinone diazide sulfonyl ester compound having a 4-naphthoquinone diazide sulfonyl group and a 5-naphthoquinone diazide sulfonyl group in one molecule may be contained, or both a 4-naphthoquinone diazide sulfonyl ester compound and a 5-naphthoquinone diazide sulfonyl ester compound may be contained.

Among the photo acid generator (B1), a sulfonium salt, a phosphonium salt, and a diazonium salt are preferable because they moderately stabilize the acid component generated by exposure to light. In particular, sulfonium salts are preferable.

Specific examples of the photopolymerization initiator (B2) include, for example, photopolymerization initiators described in [0223] to [0276] of International Publication No. 2019/087985 and [0047] to [0048] of International Publication No. 2019/194286. Among them, from the viewpoint of achieving high sensitivity, the photopolymerization initiator (B2) preferably includes an oxime ester-type photopolymerization initiator (B2-1) and/or a titanocene-type photopolymerization initiator (B2-2). Two or more of these may be contained.

The content of the photosensitive agent (B) is preferably 0.5 to 50 parts by mass with respect to 100 parts by mass of the resin (A).

The content of the photo acid generator (B1) in the photosensitive agent (B) is preferably 0.5 to 50 parts by mass with respect to 100 parts by mass of the component (A) from the viewpoint of increasing the sensitivity. Among them, the amount of the quinone diazide compound is preferably 3 to 40 parts by mass. The total amount of the sulfonium salt, phosphonium salt, and diazonium salt is preferably 0.5 to 20 parts by mass.

In the photosensitive agent (B), the content of the photopolymerization initiator (B2) is preferably 0.5 to 20 parts by mass with respect to 100 parts by mass of the resin (A). When the content of the photopolymerization initiator (B2) is 0.5 parts by mass or more, sufficient radicals are generated by light irradiation, and sensitivity is improved. When the content of the photopolymerization initiator (B2) is 20 parts by mass or less, curing in unirradiated portions due to excessive radical generation does not take place and the alkali developability is improved.

The photosensitive resin composition according to the present invention contains the solvent (C). In the photosensitive resin composition according to the present invention, the solvent (C) preferably contains a solvent represented by formula (17) and/or a solvent (C1) represented by formula (18).

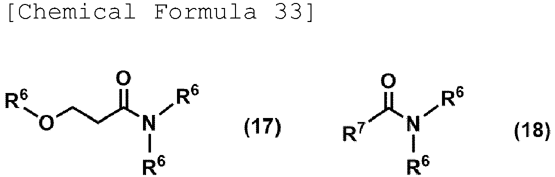

In formulas (17) and (18), R⁶ each independently represents an alkyl group having 1 to 6 carbon atoms, and R⁷ represents an alkyl group having 2 to 6 carbon atoms.

By including the solvent (C1), the ring-closing reaction of the resin (A) is accelerated, and the mechanical properties and chemical resistance of a cured product obtained by curing the photosensitive resin composition can be improved. In addition, since the solvent (C1) strongly interacts with the resin (A) component and the metal material, adhesion to the metal material can be improved by containing the solvent (C1).

The β-alkoxypropionamide which is a compound represented by formula (17) is preferably MPA or BPA from the viewpoint of promoting the solubility of the resin (A) and the ring-closing reaction of the resin (A) to improve the mechanical properties and chemical resistance of the cured product.

In the present invention, the content of the β-alkoxypropionamide is preferably 0.1 parts by mass or more, more preferably 1 part by mass or more, with respect to 100 parts by mass of the resin (A), from the viewpoint of promoting the ring-closing reaction of the resin (A) and improving the elongation at break and chemical resistance of the cured film. On the other hand, the content is preferably 15 parts by mass or less, and more preferably 10 parts by mass or less from the viewpoint of successfully forming a desired patterned film in use as a development film.

The compound represented by formula (18) is preferably DMPA or DMIB from the viewpoint of promoting the ring-closing reaction of the resin (A) and improving the mechanical properties and chemical resistance of the cured product.

In the present invention, the content of the compound represented by formula (18) is preferably 0.1 parts by mass or more, and more preferably 1 part by mass or more, with respect to 100 parts by mass of the resin (A), from the viewpoint of promoting the ring-closing reaction of the resin (A) to improve the mechanical properties and chemical resistance of the cured product. On the other hand, the content is preferably 15 parts by mass or less, and more preferably 10 parts by mass or less from the viewpoint of successfully forming a desired patterned film in use as a development film.

The photosensitive resin composition according to the present invention preferably includes a solvent (C2) that is a compound having a hydroxyl group and a boiling point of 100°C or more and 200°C or less at atmospheric pressure. By including the solvent (C2), not only can planarity be improved, but also developability can be improved, generation of development residual substances can be suppressed, and sensitivity can be improved.

Examples of the solvent (C2) include propylene glycol monomethyl ether (hereinafter PGME; boiling point: 120°C), methyl lactate (boiling point: 145°C), ethyl lactate (boiling point: 154°C), propyl lactate (boiling point: 169°C), 1-butanol (boiling point: 117°C), 1-pentanol (boiling point: 138°C), 1-hexanol (boiling point: 157°C), cyclohexanol (boiling point: 161°C), 3-methoxybutanol (boiling point: 161°C), ethylene glycol monomethyl ether (boiling point: 124°C), diacetone alcohol (boiling point: 166°C), tetrahydrofurfuryl alcohol (boiling point: 176°C), and diethylene glycol monomethyl ether (boiling point: 194°C).

The content of the solvent (C2) included in the photosensitive resin composition of the present invention is preferably 5 to 3,000 parts by mass, and more preferably 10 to 1,000 parts by mass, with respect to 100 parts by mass of the total amount of the resin (A).

The photosensitive resin composition according to the present invention includes both the solvent (C1) and the solvent (C2), and the content ratio Y/X, where X is the content of the solvent (C1) and Y is the content of the solvent (C2), in the photosensitive resin composition is preferably 1 or more and 1000 or less, more preferably 10 or more and 800 or less. When the ratio Y/X is within the above range, it is possible to satisfy all the characteristics of improvement in adhesion to a metal material, improvement in planarity, suppression of development residual substances, and improvement in sensitivity.

The photosensitive resin composition of the present invention may contain a solvent (C3) that is a solvent other than the solvent (C1) and the solvent (C2). Examples of the solvent (C3) include:
ethers such as ethylene glycol monoethyl ether, propylene glycol monoethyl ether, diethylene glycol dimethyl ether and diethylene glycol ethyl methyl ether;
esters such as ethylene glycol monomethyl ether acetate, propylene glycol monomethyl ether acetate, ethyl acetate, butyl acetate, butyl lactate, methyl levulinate, ethyl levulinate, propyl levulinate, and butyl levulinate;
alcohols such as methanol, ethanol, and isopropanol;
ketones such as methyl ethyl ketone, methyl isobutyl ketone, methyl amyl ketone, diisobutyl ketone, cyclopentanone, and diacetone alcohol;
polar aprotic solvents such as N-methyl-2-pyrrolidone, GBL, DMSO, 1,3-dimethyl-2-imidazolidinone, 3-methyl-2-oxazolidone, dihydrolevoglucosenone (Cyrene, manufactured by Circa); and
aromatic hydrocarbons such as toluene and xylene. Two or more of these may be contained.

The content of the solvent (C3) is preferably 1,500 parts by mass or less, and more preferably 1,000 parts by mass or less, with respect to 100 parts by mass of the resin (A).

The photosensitive resin composition according to the present invention is preferably a positive type photosensitive resin composition further including a dissolution accelerator (D), in which the photosensitive agent (B) includes a photo acid generator (B1). The dissolution accelerator (D) can supplement the alkali developability of the photosensitive resin composition, reduce the residual substance in the positive type photosensitive resin composition, and improve the sensitivity. The dissolution accelerator (D) is preferably a compound having a phenolic hydroxyl group, and examples thereof include Bis-z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-Pz, BisP-IPZ, BisCRIPZ, BisOCP-IPZ, BisOIPP-CP, Bis26X-IPZ, BisOTBP-CP, TekP4HBPA (tetrakis P-DO-BPA), TrisP-HAP, TrisP-PA, TrisP-PHBA, TrisP-SA, TrisOCRPA (trade name, manufactured by Honshu Chemical Industry Co., Ltd.), MILEX HBPX, MILEX PIRM, MILEX MDPR (trade name, manufactured by Mitsui Chemicals, Inc.), BIR-OC, BIP-PC, BIR-PC, BIR-PTBP, BIR-PCHP, BIP-BIOCF, 4PC, BIR-BIPC-F, TEP-BIP-A (trade name, manufactured by ASAHI YUKIZAI CORPORATION), bisphenol A, bisphenol AF (hereinafter BPAF), bisphenol B, bisphenol C, bisphenol S, 1,4-dihydroxynaphthalene, 1,5-dihydroxynaphthalene, 1,6-dihydroxynaphthalene, 1,7-dihydroxynaphthalene, 2,3-dihydroxynaphthalene, 2,6-dihydroxynaphthalene, 2,7-dihydroxynaphthalene, 2,4-dihydroxyquinoline, 2,6-dihydroxyquinoline, 2,3-dihydroxyquinoxaline, anthracene-1,2,10-triol, anthracene-1,8,9-triol, and 8-quinolinol. The content of the dissolution accelerator (D) is preferably 1 to 40 parts by mass with respect to 100 parts by mass of the resin (A) from the viewpoint that the sensitivity can be improved while the pattern shape is kept good.

The photosensitive resin composition of the present invention preferably includes a crosslinking agent (E). The crosslinking agent refers to a compound that has a crosslinkable group capable of binding to the resin. When the crosslinking agent (E) is contained, the elongation at break and the chemical resistance of a cured film can be improved. This is presumed to be because the crosslinking agent (E) component can introduce a new crosslinked structure into the cured product of the photosensitive resin composition, thereby improving the crosslinking density.

The crosslinking agent (E) is preferably a compound having two or more thermal crosslinkabilities in the molecule, such as an alkoxymethyl group, a methylol group, an epoxy group, or an oxetanyl group.

Specific examples of the crosslinking agent (E) include crosslinking agents described in [0407] to [0412] of International Publication No. 2019/087985.

The content of the crosslinking agent (E) is preferably 0.5 to 50 parts by mass with respect to 100 parts by mass of the resin (A). When the content is 0.5 to 50 parts by mass, the elongation at break and the chemical resistance of a cured film can be improved without deteriorating the storage stability of the photosensitive resin composition and the transparency of the cured film.

The photosensitive resin composition of the present invention preferably includes a surfactant (F). The surfactant refers to a compound that has a hydrophilic structure and a hydrophobic structure. By containing the surfactant (F) in an appropriate amount, the surface tension of the photosensitive resin composition can be arbitrarily adjusted, the leveling property at the time of application is improved, and the film thickness uniformity of the coating film can be improved. The surfactant (F) is preferably a fluororesin surfactant, a silicone surfactant, a polyoxyalkylene ether surfactant, or an acrylic resin surfactant. Among them, it is more preferable to include a silicone-based surfactant, a polyoxyalkylene ether-based surfactant, or an acrylic resin-based surfactant as the surfactant (F) from the viewpoint of suppressing contamination of the opening after curing. Specific examples of the surfactant (F) include surfactants described in [0419] to [0420] of International Publication No. 2019/087985.

The content ratio of the surfactant (F) in the photosensitive resin composition according to the present invention is preferably 0.001% by mass or more, more preferably 0.005% by mass or more in the entire photosensitive resin composition. When the content ratio is 0.001% by mass or more, the leveling property at the time of application can be improved. On the other hand, the content ratio of the surfactant is preferably 1% by mass or less, and more preferably 0.5% by mass or less. When the content ratio is 1% by mass or less, defects generated during application can be reduced, and a cured product having high heat resistance can be obtained.

The photosensitive resin composition of the present invention preferably contains an adhesion improver (G). Examples of the adhesion improver (G) contain silane coupling agents such as vinyltrimethoxysilane, vinyltriethoxysilane, epoxycyclohexylethyltrimethoxysilane, 3-glycidyloxypropyltrimethoxysilane, 3-glycidyloxypropyltriethoxysilane, p-styryltrimethoxysilane, 3-aminopropyltrimethoxysilane, 3-aminopropyltriethoxysilane, and N-phenyl-3-aminopropyltrimethoxysilane; titanium chelating agents; aluminum chelating agents; and compounds obtained by reacting an aromatic amine compound with an alkoxy-group-containing silicon compound. Two or more of these may be contained. When such an adhesion improver is contained, adhesion to a substrate material such as silicon wafer, ITO, SiO₂ or silicon nitride can be increased during development of a photosensitive resin composition, or the like. Among them, it is preferable to include a silane coupling agent as the adhesion improver (G) from the viewpoint of good storage stability of the photosensitive resin composition. The content of the adhesion improver (G) is preferably 0.1 parts by mass or more, and more preferably 0.3 parts by mass or more with respect to 100 parts by mass of the resin (A). Further, the content is preferably 10 parts by mass or less, more preferably 5 parts by mass or less. By including the adhesion improver (G) within the above range, it is possible to achieve both the storage stability of the photosensitive resin composition and the adhesion to the base substrate.

The photosensitive resin composition of the present invention may further include a radically polymerizable compound (H), and the photosensitive agent (B) may contain a photopolymerization initiator (B2). By adopting such a configuration, it is possible as described above to obtain a negative type relief pattern in which active radicals generated in the part irradiated with light cause radical polymerization of the ethylenically unsaturated bond in the radically polymerizable compound to proceed and the part irradiated with light is insolubilized. As a result, the photosensitive resin composition becomes a negative photosensitive resin composition.

Specific examples of the radically polymerizable compound (H) component include, for example, radically polymerizable compounds and the like described in [0189] to [0222] of International Publication No. 2019/087985. Among them, it is preferable that a flexible chain-containing aliphatic radically polymerizable compound is included. The flexible chain-containing aliphatic radically polymerizable compound refers to a compound having a plurality of ethylenically unsaturated double bond groups and a flexible skeleton such as an aliphatic chain or an oxyalkylene chain in the molecule.

When the flexible chain-containing aliphatic radically polymerizable compound is included, a curing reaction during light irradiation proceeds efficiently, so that the sensitivity during light irradiation can be improved. Furthermore, the change in pattern opening width dimension between before and after thermal curing can be suppressed. The content of the radically polymerizable compound (H) is preferably 5 to 50 parts by mass with respect to 100 parts by mass of the resin (A).

The photosensitive resin composition of the present invention may contain an additive (I) (Hereinafter, referred to as additive (I)) other than the above. Examples of the additive (I) include, for example, a polyfunctional thiol compound described in [0386] to [0398] of International Publication No. 2019/087985, a colorant described in [0281] to [0370] of International Publication No. 2019/087985, a dispersant described in [0371] to [0385] of International Publication No. 2019/087985, a sensitizer described in [0399] to [0402] of International Publication No. 2019/087985, a polymerization inhibitor described in [0403] to [0406] of International Publication No. 2019/087985, and inorganic particles and the like described in [0127] to [0130] of International Publication No. 2016/052268 and [0024] to [0025] of International Publication No. 2019/167461.

Examples of the method for producing the photosensitive resin composition of the present invention include a method in which the respective components of the resin (A), the photosensitive agent (B) and the solvent (C) and, if necessary, other components are put in a glass flask, a stainless steel container or the like and stirred and dissolved by a mechanical stirrer or the like, a method in which the components are dissolved by ultrasonic waves, and a method in which the components are stirred and dissolved by a planetary stirring and defoaming apparatus.

The obtained photosensitive resin composition is preferably filtered by the use of a filtration filter to remove dust and particles. The pore diameter of the filtration filter is 0.5 to 0.02 µm, for example, 0.5 µm, 0.2 µm, 0.1 µm, 0.05 µm, and 0.02 µm, but is not limited thereto. The material of the filtration filter may be polypropylene (PP), polyethylene (PE), nylon (NY), polytetrafluoroethylene (PTFE), and the like, and polyethylene and nylon are preferred. When the photosensitive resin composition contains inorganic particles, a pigment, or the like, it is preferable to use a filtration filter having a pore diameter larger than those of the inorganic particles, the pigment, or the like.

The cured product of the present invention is obtained by curing the photosensitive resin composition of the present invention. Examples of the method for curing the photosensitive resin composition include a method in which the photosensitive resin composition is heated and cured, and a method in which the photosensitive resin composition is irradiated with active actinic rays. By curing the photosensitive resin composition of the present invention, the heat resistance and chemical resistance of the cured product can be improved. The cured product is preferably one having a film shape, that is, a cured film.

Next, a method for producing a cured product of the present invention will be described.

The method for producing a cured product of the present invention preferably includes the following steps.
(1) a step of applying the photosensitive resin composition described above to a substrate to form a photosensitive resin film;
(2) a step of drying the photosensitive resin film;
(3) a step of exposing the dried photosensitive resin film to light through a photomask;
(4) a step of developing the exposed photosensitive resin film; and
(5) a step of applying a heating treatment to the developed photosensitive resin film.

In the step (1), the photosensitive resin composition of the present invention is applied to a substrate by a spin coating method, a slit coating method, a dip coating method, a spray coating method, a printing method, or the like to obtain a photosensitive resin film of the photosensitive resin composition. Prior to the application, the substrate to which the photosensitive resin composition is applied may be pretreated with an adhesion improver in advance. Examples of the pretreatment include a method of treating the substrate surface with the use of a solution prepared by dissolving an adhesion improver in a content of 0.5 to 20% by mass in a solvent such as isopropanol, ethanol, methanol, water, tetrahydrofuran, propylene glycol monomethyl ether acetate, propylene glycol monomethyl ether, ethyl lactate, or diethyl adipate. Examples of the method for treating the surface of the substrate surface include a spin coating method, a slit die coating method, a bar coating method, a dip coating method, a spray coating method, and a steam treatment. Specific examples of the adhesion improver include, for example, the adhesion improver and the like described in [0127] of International Publication No. 2019/065351.

In the step (2), the applied photosensitive resin film may be optionally subjected to a reduced-pressure drying treatment, and is then subjected to a heat treatment at 50°C to 180°C for 1 minute to several hours using a hot plate, an oven, infrared ray, or the like to afford a photosensitive resin film.

In the step (3), the photosensitive resin film is irradiated with actinic rays through a photomask having a desired pattern. Examples of the actinic ray to be employed for the exposure to light include ultraviolet ray, visible light, electron beam and X-ray. In the present invention, i-line (365 nm), h-line (405 nm), or g-line (436 nm) of a mercury lamp can be used preferably. After the irradiation with the actinic rays, post-exposure baking may be conducted. By conducting the post-exposure baking, advantageous effects, such as improvement in post-development resolution or increase in the allowable range of development conditions, can be expected. The post-exposure baking can use an oven, a hot plate, infrared rays, a flash annealing device, a laser annealing device, or the like. The post-exposure baking temperature is preferably 50 to 180°C, and more preferably 60 to 150°C. The post-exposure baking time is preferably 10 seconds to several hours. When the post-exposure baking time is within the range mentioned above, reaction progresses favorably, so that the development time can sometimes be reduced.

In the step (4), the exposed resin film is developed using a developer, whereby portions other than the exposed portions are removed. The developer is preferably a good solvent for the photosensitive resin composition or a combination of the good solvent and a poor solvent. For example, in the case of a photosensitive resin composition insoluble in an alkaline aqueous solution, NMP, N-cyclohexyl-2-pyrrolidone, DMAc, cyclopentanone, cyclohexanone, GBL, α-acetyl-γ-butyrolactone, and the like are preferable as the good solvent, and toluene, xylene, methanol, ethanol, isopropyl alcohol, ethyl lactate, propylene glycol methyl ether acetate, water, and the like are preferable as the poor solvent. When a good solvent and a poor solvent are mixed and used, it is preferable to adjust the ratio of the poor solvent to the good solvent according to the solubility of the polymer in the photosensitive resin composition. Two or more types of solvents, for example, several types of solvents may be used in combination. On the other hand, in the case of a photosensitive resin composition soluble in an alkaline aqueous solution, the developer to be used for development is one that dissolves and removes a polymer soluble in the alkaline aqueous solution, and is typically an alkaline aqueous solution in which an alkali compound is dissolved. Examples of the alkali compound include tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, and hexamethylenediamine. In some cases, polar solvents such as NMP, DMF, DMAc, DMSO, GBL, and dimethylacrylamide, alcohols such as methanol, ethanol, and isopropanol, esters such as ethyl lactate and propylene glycol monomethyl ether acetate, and ketones such as cyclopentanone, cyclohexanone, isobutyl ketone, and methyl isobutyl ketone may be added alone or in combination of several solvents to the alkaline aqueous solution. As the developing method, a method of a spray mode, a paddle mode, a dip mode, an ultrasonic mode, and the like can be employed.

Subsequently, the pattern formed by the development is preferably subjected to a rinsing treatment with deionized water. Here, alcohols such as ethanol and isopropyl alcohol, esters such as ethyl lactate and propylene glycol monomethyl ether acetate, or the like may be added to the deionized water for the rinsing treatment.

Next, the step (5) is conducted. When the heating treatment is carried out, a remaining solvent or a component having low heat resistance can be removed, resulting in the improvement in heat resistance and chemical resistance. In the photosensitive resin composition of the present invention, since the resin (A) can form an imide ring and an oxazole ring by heating treatment, heat resistance and chemical resistance can be improved. When the crosslinking agent (E) is contained, the thermal crosslinking reaction can proceed by heating treatment, and the mechanical properties, heat resistance and chemical resistance can be improved. This heating treatment is conducted for 5 minutes to 5 hours while selecting temperature levels and increasing the temperature stepwise, or while selecting a certain temperature range and continuously increasing the temperature. As one example, the heat treatment is conducted at each of 150°C and 250°C for 30 minutes. Alternatively, examples thereof include a method of linearly increasing the temperature from room temperature up to 300°C over 2 hours. The heating treatment condition in the present invention is preferably 180°C or more, more preferably 200°C or more, still more preferably 230°C or more, and particularly preferably 240°C or more. The heating treatment condition is preferably 400°C or lower, more preferably 350°C or lower, still more preferably 300°C or lower.

Next, as an example of a method for producing the cured product of the present invention, a method for producing a cured film which is one form of the cured product using a photosensitive sheet in which the photosensitive resin composition of the present invention is formed into a sheet shape will be described. Here, the photosensitive sheet refers to a sheet-shaped photosensitive resin composition obtained by applying a photosensitive resin composition on a peelable film and drying the photosensitive resin composition.

In the case of using a photosensitive sheet made of the photosensitive resin composition of the present invention formed in a sheet shape, when the photosensitive sheet has a protective film, the protective film is peeled off, the photosensitive sheet and the substrate are arranged to face each other, and the photosensitive sheet and the substrate are bonded to each other by thermocompression bonding, whereby a photosensitive resin film is obtained. The photosensitive sheet can be obtained by applying the photosensitive resin composition of the present invention on a support film composed of polyethylene terephthalate or the like, which is a peelable film, and drying the composition.

The thermocompression bonding can be conducted by a heat press treatment, a heat lamination treatment, a heat vacuum lamination treatment, or the like. The bonding temperature is preferably 40°C or more from the viewpoint of adhesion and embeddability to the substrate. In addition, when the photosensitive sheet has photosensitivity, the bonding temperature is preferably 140°C or lower in order to prevent the photosensitive sheet from being cured at the time of bonding and the resolution of pattern formation in the exposure/development step from being reduced.

In the photosensitive resin film obtained by bonding the photosensitive sheet to the substrate, a cured film can be formed following the step of exposing the photosensitive resin film, the step of developing the exposed photosensitive resin film, and the step of performing thermal curing.

The display device of the present invention includes the cured product of the present invention. Specific examples of the display device of the present invention include an LED display, a liquid crystal display device, and an organic EL display device. The cured product formed of the photosensitive resin composition of the present invention can be used for a display device including a first electrode formed on a substrate and a second electrode provided opposite to the first electrode, and specifically, for example, can be used for an insulating film constituting an LED display, a planarization layer of a liquid crystal display device, a planarization layer and/or a pixel defining layer of an organic EL display device, and the like.

The organic EL display device of the present invention includes the cured product of the present invention. Preferably, the organic EL display device of the present invention includes the cured product of the present invention as one or more selected from the group consisting of a pixel defining layer, an electrode insulation layer, a wiring insulation layer, an interlayer insulation layer, a TFT planarization layer, an electrode planarization layer, a wiring planarization layer, a TFT protective layer, an electrode protective layer, a wiring protective layer, a gate insulation layer, a color filter, a black matrix, and a black column spacer. The organic EL display device of the present invention can be suitably used for various electronic devices. Examples of the electronic device include a smartphone, a tablet PC, and smart glasses.

The electronic component of the present invention includes the cured product of the present invention.

The cured product formed from the photosensitive resin composition of the present invention can be used as an insulating film and a protective film constituting the electronic component.

Examples of the electronic component include active components having a semiconductor such as transistors, diodes, integrated circuits (ICs), and memories, as well as passive components such as resistors, capacitors, and inductors. Further, an electronic component including a semiconductor is also referred to as a semiconductor device or a semiconductor package.

Examples of the cured product in the electronic component are suitably used for uses such as a passivation film of a semiconductor, a semiconductor element, a surface protective film such as a thin film transistor (TFT), an interlayer insulating film such as an interlayer insulating film between redistributions in high-density multilayer wiring for mounting of 2 to 10 layers, an insulating film of a touch panel display, a protective film, and an insulation layer of an organic electroluminescent element, but are not limited thereto, and can have various structures.

The electronic component of the present invention preferably has the cured product of the present invention on a substrate. The substrate surface on which the cured product is to be formed can be appropriately selected depending on applications and steps. Examples of the substrate include a silicon substrate, a silicon carbide substrate, a gallium nitride substrate, ceramics, gallium arsenide, metal, and an epoxy resin. The substrate is preferably a silicon substrate, a silicon carbide substrate, or a gallium nitride substrate.

### EXAMPLES

The present invention will be described more concretely hereinafter with reference to examples and comparative examples. However, the present invention is not limited to these embodiments.

Incidentally, of the compounds used, those whose abbreviations are used will be named below.
ODPA: 4,4'-oxydiphthalic anhydride
TDA: 1,3,3a,4,5,9b-hexahydro-5(tetrahydro-2,5-dioxo-3-furanyl)naphtho[1,2-c]furan-1,3-dione (manufactured by New Japan Chemical Co., Ltd.)
MCTC: 5-(2,5-dioxotetrahydrofuryl)-3-methyl-3-cyclohexene-1,2-dicarboxylic anhydride (manufactured by Tokyo Chemical Industry Co., Ltd.)
HBPDA: Dicyclohexyl-3,4,3',4'-tetracarboxylic dianhydride (manufactured by Tokyo Chemical Industry Co., Ltd.)
BAHF: 2,2-bis(3-amino-4-hydroxyphenyl)hexafluoropropane (manufactured by Central Glass Co., Ltd.)
BAP: 2,2-bis(3-amino-4-hydroxyphenyl)propane (manufactured by Wakayama Seika Kogyo Co., Ltd.)
3,4'-ODA: 3,4'-diaminodiphenyl ether (manufactured by Tokyo Chemical Industry Co., Ltd.)
TPE-R: 1,3-bis(4-aminophenoxy)benzene
SiDA: 1,3-bis(3-aminopropyl)tetramethyldisiloxane (manufactured by Tokyo Chemical Industry Co., Ltd.)
MAP: 3-aminophenol (manufactured by Tokyo Chemical Industry Co., Ltd.)
4-APA: 4-aminophenylacetylene (manufactured by Tokyo Chemical Industry Co., Ltd.)
MPA: 3-methoxy-N,N-dimethylpropanamide (manufactured by KJ Chemicals Corporation)
DMIB: N,N-dimethylisobutylamide
DMPA: N,N-dimethylpropionamide
PGME: propylene glycol monomethyl ether
GBL: γ-butyrolactone
DMSO: Dimethyl sulfoxide
ITO: indium tin oxide
TMAH: Tetramethylammonium hydroxide
DMFDMA: N,N-dimethylformamide dimethyl acetal.

### [Common treatment conditions]

In the following measurement and evaluation methods and Examples and Comparative Examples, the following treatments were conducted under the following conditions unless otherwise specified.

### (1) Pretreatment of ITO substrate

The glass substrate with a 100 nm ITO layer deposited by sputtering on glass (GEOMATEC Co., Ltd.; hereinafter, referred to as an "ITO substrate") was subjected to a UV-O₃ cleaning treatment for 100 seconds with the use of a tabletop optical surface treatment device (PL16-110; manufactured by SEN LIGHTS Corporation), and then used. A Si wafer (manufactured by ELECTRONICS AND MATERIALS CORPORATION LIMITED) was subjected to dehydration baking by heating at 130°C for 2 minutes with a hot plate (HP-1SA (manufactured by AS ONE Corporation)), and then was used.

### (2) Heating treatment (curing)

The developed film was heated at 250°C for 1 hour in a nitrogen atmosphere using a high-temperature inert gas oven (INH-9CD-S manufactured by Koyo Thermo Systems Co., Ltd.) to obtain a cured film as one form of a cured product.

### [Measurement and evaluation methods]

### (1) Weight average molecular weight (Mw) of resin (A)

The weight average molecular weight (Mw) of the resin obtained in each Synthesis Example was determined by measuring the weight average molecular weight (Mw) in terms of polystyrene under the following conditions using a gel permeation chromatography (GPC) analyzer.
Measurement device: Waters 2695 (manufactured by Waters Corporation)
Column temperature: 50°C
Flow rate: 0.4 mL/min
Detector: 2489 UV/Vis Detector (measurement wavelength: 260 nm)
Developing solvent: NMP (containing 0.21% by mass of lithium chloride and 0.48% by mass of phosphoric acid)
Guard column: TOSOH TSK guard column (manufactured by Tosoh Corporation)
Column: TOSOH TSK-GEL a-2500 and TOSOH TSK-GEL a-4000 (both manufactured by Tosoh Corporation) are in series.
Number of measurements: twice (the average value of the measurements was taken as the weight average molecular weight of the polyimide).

### (2) Measurement of amount of components having molecular weight of 1,000 or less included in resin (A)

In the same manner as in the measurement method of the weight average molecular weight, the area% of the peak having a molecular weight of 1,000 or less in terms of polystyrene was calculated, and the area% of the peak having a molecular weight of 1,000 or less was regarded as the % by mass of the component having a molecular weight of 1,000 or less included in the resin (A).

### (3) Esterification rate

¹H-NMR of a mixed solution of 10 mg of the resin obtained in each Synthesis Example and 0.8 g of deuterated DMSO (DMSO-d6) was measured using a nuclear magnetic resonance (NMR) apparatus (EX-270 manufactured by JEOL Ltd.), and the integrated value of a peak derived from aromatic protons of the resin was determined. The esterification rate of the polyamic acid ester was calculated from the area ratio of the determined integrated value to a peak derived from methyl protons of the carboxylic acid ester. Since resins other than the polyamic acid ester do not have a carboxylic acid ester, the esterification rate is indicated by "-" as being unmeasurable.

### (4) Imide ring closure rate (R_{IM} (%))

The resin obtained in each Synthesis Example was dissolved in GBL such that a concentration of 35% by mass was attained. This solution was applied onto a 4 inch silicon wafer by a spin coating method using a spin coater (1H-DX manufactured by Mikasa Co., Ltd.), and then baked on a hot plate at 120°C for 3 minutes, whereby a resin film having a thickness of 4 to 5 µm was prepared. The wafer with a resin film was divided into two halves, and one was cured under a nitrogen stream (oxygen concentration: 20 ppm or less) at 140°C for 30 minutes using a clean oven (CLH-21CD-S manufactured by Koyo Thermo Systems Co., Ltd.), and then at 320°C for 1 hour following raising of the temperature. Thus, an imide ring was completely closed. The transmitted infrared absorption spectra of the resin film before and after the curing were measured with an infrared spectrophotometer (FT-720 manufactured by HORIBA, Ltd.). The presence of absorption peaks of the imide structure attributable to a polyimide (around 1780 cm⁻¹ and around 1377 cm⁻¹) was confirmed, and the peak intensities around 1377 cm⁻¹ (before curing: S, after curing: T) were determined. The peak intensity ratio obtained by dividing the peak intensity (S) by the peak intensity (T) was calculated by the following formula, and defined as the ratio containing imide groups in the polymer before heat treatment, that is, the imide ring closure rate. ${R}_{IM} \left(%\right) = \left(S/T\right) \times 100$

Since resins other than the polyimide (including the polyamic acid ester) do not have a structural unit of the polyimide, the imide ring closure rate is indicated by "-" as being unmeasurable.

### (5) Evaluation of content of compounds represented by formula (17) and formula (18) relative to resin (A)

The resin (A) (0.03 g) obtained in each Synthesis Example and 0.01 g of methyl 3-nitrobenzoate as an internal standard substance were dissolved in 0.7 g of deuterated DMSO, and the mixture was analyzed by NMR (GX-270, manufactured by JEOL Ltd.). Based on the area of the peak around 3.9ppm derived from methyl 3-nitrobenzoate, the content [parts by mass] of the compounds represented by formula (17) and formula (18) relative to 100 parts by mass of the resin (A) component was measured from each peak area.

### (6) Film Thickness Measurement

With the use of a surface roughness and contour measuring instrument (SURFCOM 1400D; manufactured by Tokyo Seimitsu Co., Ltd.), at the measurement magnification of 10,000 times, the measurement length of 1.0 mm, the measurement speed of 0.30 mm/s, the film thickness was measured.

### (7) Thinner Solubility

The photosensitive resin composition of each of Examples and Comparative Examples was applied onto a 4 inch silicon wafer by a spin coating method using a spinner (1H-DX manufactured by Mikasa Co., Ltd.), and then baked on a hot plate at 120°C for 2 minutes to prepare a resin film having a thickness of 2 µm. This wafer with a resin film was divided into two, and one was subjected to stationary immersion in 100 g of PGME at 23°C for 2 minutes and rinsed with pure water. The other divided wafer with a resin film was similarly subjected to stationary immersion in 100 g of PGME at 23°C for 5 minutes and rinsed with pure water. Dissolution of the resin film was confirmed visually and by film thickness measurement. It was determined as follows, and A, B, and C were regarded as acceptable. A is the most preferable result.
A: Completely dissolved by stationary immersion for 2 minutes
B: Not completely dissolved by stationary immersion for 2 minutes, but completely dissolved by stationary immersion for 5 minutes.
C: Film thickness after stationary immersion for 5 minutes was less than 1.0 µm.
D: Film thickness after stationary immersion for 5 minutes was 1.0 µm or more.

### (8) Planarity evaluation

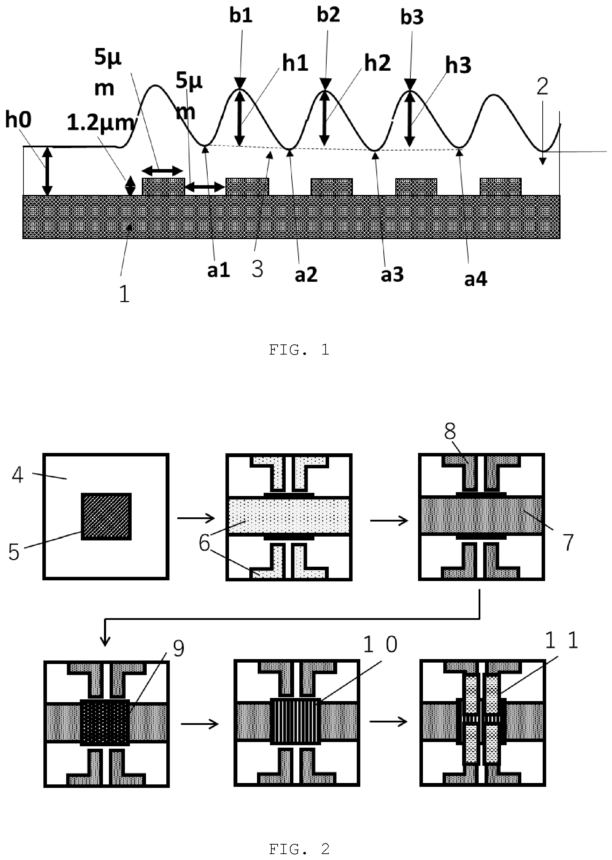

A sectional view of a planarity evaluation sample is shown in Fig. 1. Using a spin coater MS-A100 (manufactured by Mikasa Co., Ltd.), each of the photosensitive resin compositions of Examples and Comparative Examples as a sample was applied by a spin coating method onto a 100 mm-square stepped substrate 1 in which five line patterns each having a thickness (height) of 1.2 µm, a width of 5 µm, and a length of 15 mm were patterned in parallel at an interval of 5 µm in the central portion of the substrate, and was prebaked at 110°C for 120 seconds to prepare a prebaked film such that the film thickness h0 was 3.7 µm in a flat portion (the place where the measurement was conducted is referred to as "measurement point A" for convenience) not provided with the pattern on the substrate, which was separated to an extent not affected by the patterns. Subsequently, the resulting substrate with the film was subjected to a curing step in which the temperature was raised to 250°C at 5°C/min at an oxygen concentration of 20 ppm or less and a heating treatment was conducted at 250°C for 1 hour using a high-temperature inert gas oven (INH-9CD-S manufactured by Koyo Thermo Systems Co., Ltd.) to prepare a cured film having a film thickness of about 2.5 µm at the measurement point A. The surface step of the resulting cured film was measured with a surface profiler (P-15; manufactured by KLA-Tencor Corporation). For three line patterns among the five line patterns excluding the outermost two line patterns, the average value of the heights h1 to h3 of the line patterns from the baseline 3 of the film present on the line patterns was taken as the surface step h. Note that the baseline 3 was defined as a line connecting points at which the film thicknesses of the recesses present on the left and right sides of each of the portions of the resin film in the mountain range shape for measuring h1 to h3 were the smallest as viewed from Fig. 1. A specific example is described below. In Fig. 1, a straight line connecting the bottom portions a1 and a2 of the step shape was defined as a baseline, and a length from the top portion b1 of the step shape to an intersection of a line drawn perpendicularly to the substrate surface and the baseline was defined as h1. As to h2, a line connecting a2 and a3 was defined as a baseline, and h2 was defined as a length from b2 to an intersection of a line drawn from b2 perpendicularly to the substrate surface and the baseline. As to h3, a line connecting a3 and a4 was defined as a baseline, and h3 was defined as a length distance from b3 to an intersection of a line drawn from b3 perpendicularly to the substrate surface and the baseline. Planarity was determined from the surface step h as follows, and A, B, and C with the surface step h of less than 0.4 µm were regarded as acceptable. A is the most preferable result.
A: The surface step h is less than 0.2 µm.
B: The surface step h is 0.2 µm or more and less than 0.3 µm.
C: The surface step h is 0.3 µm or more and less than 0.4 µm.
D: The surface step h is 0.4 µm or more.

### (9) Sensitivity evaluation

The photosensitive resin compositions obtained in each of Examples and Comparative Examples were applied onto a 100 mm × 100 mm ITO substrate by spin coating using a spin coater (MS-A100; manufactured by Mikasa Co., Ltd.) with the rotation speed adjusted such that the film thickness of a prebaked film was about 1.8 µm, and then were prebaked at 110°C for 120 seconds using a buzzer hotplate (HPD-3000BZN; manufactured by AS ONE Corporation), whereby prebaked films having a film thickness of about 1.8 µm were prepared. The resulting prebaked film was exposed to ultraviolet rays with a maximum exposure energy of 150 mJ/cm² (i-ray illuminometer value) through a positive mask (manufactured by HOYA Corporation, stripe design line width: 20 µm) using a manually operated exposure machine (MA-1200; manufactured by Japan Science Engineering Co., Ltd.) with the exposure energy reduced every 5 mJ/cm², developed, rinsed, and dried, affording a patterned substrate having a photosensitive resin film formed in a prescribed pattern. The sensitivity was evaluated using a patterned substrate of each exposure amount. The development was performed by a method of performing shower development with an alkaline developer of a 2.38% by mass aqueous TMAH solution using a small-size automatic developing device for photolithography (AD-2000 manufactured by TAKIZAWA SANGYO K.K.). The development time was adjusted so that the film loss amount of the unexposed portion was 0.5 µm, and rinsing was performed using deionized water.

The opening portion of the resulting developed film was observed with an FPD/LSI inspection microscope (OPTIPHOT-300; manufactured by NIKON CORPORATION), and the minimum exposure amount at which the opening width was the line width (20 µm) which was equal to that in the mask design was defined as sensitivity. It was determined as follows, and AA, A, B, and C with a sensitivity of less than 110 mJ/cm² were regarded as acceptable. AA is the most preferable result.
AA: Less than 65 mJ/cm²
A: The sensitivity is 65 mJ/cm² or more and less than 80 mJ/cm².
B: The sensitivity is 80 mJ/cm² or more and less than 95 mJ/cm².
C: The sensitivity is 95 mJ/cm² or more and less than 110 mJ/cm².
D: The sensitivity is 110 mJ/cm² or more.

### (10) Evaluation of development residual substance

In the same manner as in the above (9), a photosensitive resin composition was applied onto an ITO substrate and prebaked to prepare a prebaked film having a film thickness of about 1.8 µm. The obtained pre-baked film was subjected to patterning exposure through a gray scale mask for sensitivity measurement (MDRM MODEL 4000-5-FS; manufactured by Opto-Line International, Inc.; having 1 : 1 line and space patterns of 2 to 50 µm and having areas with transmittances of 1%, 5%, 10%, 12%, 14%, 16%, 18%, 20%, 22%, 25%, 30%, 35%, 40%, 50% and 60%, respectively) with i-ray (wavelength: 365 nm), h-ray (wavelength: 405 nm), and g-ray (wavelength: 436 nm) of an ultra-high pressure mercury lamp at an exposure amount of 150 mJ/cm² (value of an i-ray illuminometer) using a manually operated exposure machine (MA-1200; manufactured by Japan Science Engineering Co., Ltd.), followed by development, rinsing, and drying to prepare a developed film of the photosensitive resin composition. The development time was adjusted so that the film loss amount of the unexposed portion was 0.5 µm, and rinsing was performed using deionized water.

With the use of an FPD/LSI inspection microscope (OPTIPHOT-300; manufactured by NIKON CORPORATION), the resolution pattern of the developed film prepared was observed to observe the presence or absence of any residual substance in the opening of the 20 µm line-and-space pattern at a portion with the minimum exposure amount where the opening width was the same line width (20 µm) as the mask design. It was determined as follows, and A, B, and C where the presence area of the residual substance in the opening was less than 10% were regarded as acceptable. A is the most preferable result.
A: No residual substance in opening (less than 1%)
B: The presence area of the residual substance in the opening is 1% or more and less than 5%.
C: The presence area of the residual substance in the opening is 5% or more and less than 10%.
D: The presence area of the residual substance in the opening is 10% or more.

### (11) Measurement of depth from substrate surface at which carbon component is no longer detected (X-ray photoelectron spectroscopy (XPS)) (penetration depth of carbon component)

A 4-inch silicon wafer on which aluminum was deposited was used instead of a 100 mm × 100 mm ITO substrate, and development and rinsing were performed in the same manner as in the above (9) except that the photosensitive resin composition as a sample was applied so that the film thickness of a prebaked film was 3.6 µm, followed by drying, to obtain a patterned substrate for which steps up to the development step were performed. The openings of the obtained patterned substrate were observed using an FPD/LSI inspection microscope (OPTIPHOT-300; manufactured by NIKON CORPORATION), and the minimum exposure amount at which the opening width was the same line width (20 µm) as the mask design was confirmed. The patterned substrate was then placed in a high-temperature inert gas oven (INH-9CD-S; manufactured by Koyo Thermo Systems Co., Ltd.) at 250°C to obtain a cured film. The thermal curing was performed under a condition in which the patterned substrate was put in an oven adjusted to 250°C under a nitrogen atmosphere and thermally cured for 60 minutes. Thereafter, the chemical state of the surface at the opening of the sample exposed at the minimum exposure amount at which the opening width is the same as the line width (20 µm) of the mask design was measured using an X-ray photoelectron spectrometer SSX-100 manufactured by SSI. Further, for the substrate portion between lines appearing after development, depth profile analysis by Ar ion etching was performed, and the depth at which the carbon component was no longer detected was measured in order to examine the degree of contamination of the substrate with the carbon component (organic substance). The results were determined as follows, and A, B, and C, for which the depth from the substrate surface at which the carbon component was no longer detected was less than 10.0 nm, were regarded as acceptable. A is the most preferable result.
A: The depth from the substrate surface at which the carbon component is no longer detected is less than 5.0 nm.
B: The depth from the substrate surface at which the carbon component is no longer detected is 5.0 nm or more and less than 7.5 nm.
C: The depth from the substrate surface at which the carbon component is no longer detected is 7.5 nm or more and less than 10.0 nm.
D: The depth from the substrate surface at which the carbon component is no longer detected is 10.0 nm or more.

### (12) Evaluation of elongation at break

The resin composition obtained in each of Examples and Comparative Examples was applied onto an 8-inch silicon wafer by a spin coating method using a coater/developer ACT-8 and prebaked at 120°C for 3 minutes in such a manner that the film thickness was 15 µm after the prebaking. Then, using an inert oven CLH-21CD-S (manufactured by Koyo Thermo Systems Co., Ltd.), the temperature of the prebaked item was raised to 250°C at a rate of 4.0°C/min at an oxygen concentration of 20 ppm or less, followed by a heating treatment at 250 °C for 1 hour. When the temperature reached 50°C or less, the silicon wafer was taken out and immersed in 45 % by mass of hydrofluoric acid for 3 minutes to peel off the cured film of the resin composition from the wafer. This film was cut into a strip having a width of 1 cm and a length of 9 cm, and pulled at a pulling speed of 50 mm/min at a room temperature of 23.0°C and a humidity of 45.0% RH using Tensilon RTM-100 (manufactured by Orientec Corporation) to measure the elongation at break. The measurement was performed on 10 strips per sample, and the average of the top five measured values ranked in descending order was determined from the results. It was determined as follows, and AA, A, B, and C in which the value of elongation at break was 5% or more were regarded as acceptable. AA is the most preferable result.
AA: The value of elongation at break is 20% or more.
A: The value of elongation at break is 15% or more and less than 20%.
B: The value of elongation at break is 10% or more and less than 15%.
C: The value of elongation at break is 5% or more and less than 10%.
D: The value of elongation at break is less than 5%.

### (13) Shelf stability (change in sensitivity after standing)

The photosensitive resin composition obtained in each of Examples and Comparative Examples was allowed to stand at 23°C and 45%RH for 5 days, and then sensitivity evaluation was performed in the same procedure as in (9) to determine sensitivity. When the sensitivity before standing was Eop (B) and the sensitivity after standing was Eop (A), the sensitivity change x (%) was calculated by the following formula. It was determined as follows, and A, B, and C in which the value of x was less than 125 were regarded as acceptable. A is the most preferable result.$Sensitivity change x \left(%\right) = Eop \left(A\right) / Eop \left(B\right) \times 100$
A: x is less than 105.
B: x is 105 or more and less than 115.
C: x is 115 or more and less than 125.
D: x is 125 or more.

### (14) Transmittance of cured film

The photosensitive resin compositions obtained in each of Examples and Comparative Examples were applied onto a TEMPAX glass substrate (manufactured by AGC TECHNO GLASS CO., LTD.) by spin coating using a spin coater (MS-A100; manufactured by Mikasa Co., Ltd.) with the rotation speed adjusted such that the film thickness of a prebaked film was about 2.8 µm, and then were prebaked at 110°C for 120 seconds using a buzzer hotplate (HPD-3000BZN; manufactured by AS ONE Corporation), whereby prebaked films having a film thickness of about 3.0 µm were prepared. Next, development, rinsing, and drying were performed to obtain a substrate with a developed film. Note that development was performed using a small-size automatic developing device for photolithography (AD-2000; manufactured by TAKIZAWA SANGYO K.K.) with an alkali developer of a 2.38% by mass aqueous TMAH solution, the development time was adjusted so that the film loss amount of the unexposed portion was 0.5 µm, and rinsing was performed using deionized water. Subsequently, the obtained substrate with a developed film was heated in a high-temperature inert gas oven (INH-9CD-S; manufactured by Koyo Thermo Systems Co., Ltd.) in which the temperature was raised to 250°C at 5°C/min at an oxygen concentration of 20ppm or less and a heating treatment was performed at 250°C for 1 hour, whereby a substrate with a cured film having a film thickness of 2.0 µm was obtained by performing a curing step. For the substrate with a cured film thus obtained, the transmittance at a wavelength of 400 nm was measured using an ultraviolet-visible spectrophotometer (MultiSpec-1500 manufactured by Shimadzu Corporation). Determination was made as follows, and A, B, and C where the transmittance of the cured film 2.0 µm at a wavelength of 400 nm was 60% or more were regarded as acceptable. A is the most preferable result.
A: The transmittance is 90% or more
B: The transmittance is 75% or more and less than 90%
C: The transmittance is 60% or more and less than 75%
D: The transmittance is less than 60%.

### (15) Evaluation of appearance and light emission reliability of organic EL display device

Fig. 2 shows a step of producing an organic EL display device including a step of forming a planarization layer and a pixel defining layer. First, the photosensitive resin composition obtained in each of Examples and Comparative Examples was applied to a 38 × 46 mm alkali-free glass substrate (4) by a spin coating method with the rotation speed adjusted so that the thickness of a finally obtained planarization layer was 2.0 µm to obtain a coating film. Subsequently, subsequently, the coating film was prebaked at 120°C for 120 seconds under atmospheric pressure using a hot plate (HPD-3000BZN manufactured by AS ONE Corporation), affording a prebaked film. The film was exposed to UV rays through a photomask and was then developed with a 2.38% aqueous TMAH solution to dissolve only an exposed area, and was then rinsed with pure water. The resulting developed film was cured. The curing was conducted under the condition in which the temperature was raised to 250°C at 5°C/min at an oxygen concentration of 20 ppm or less and a heating treatment was conducted at 250°C for 1 hour using a high-temperature inert gas oven (INH-9CD-S; manufactured by Koyo Thermo Systems Co., Ltd.). In this way, the planarization layer (5) having no opening was formed in an area of 16 mm in length × 16 mm in width at the center of the substrate. The thickness of the planarization layer was 2.0 µm. Next, a thin film (volume ratio 10 : 1) of a silver/copper alloy having a thickness of 10 nm was formed on the entire surface by a sputtering method, and etched to form a patterned metal reflection layer (6). Subsequently, an ITO transparent electrically conductive film having a thickness of 10 nm was formed on the entire surface by sputtering and etched to form a second electrode (7) having the same pattern and an auxiliary electrode (8) as an extraction electrode, and then ultrasonically washed with "Semico Clean" (registered trademark) 56 (manufactured by Furuuchi Chemical Corporation) for 10 minutes and washed with deionized water to obtain an electrode-formed substrate. The photosensitive composition was applied to the surface of the electrode-formed substrate using a spin coater with the rotation speed adjusted such that a finally obtained pixel defining layer had a thickness of 2.0 µm, and thus a coating film was obtained. Subsequently, the coating film was prebaked at 120°C for 120 seconds under atmospheric pressure using a hot plate (HPD-3000BZN manufactured by AS ONE Corporation), affording a prebaked film.

A positive type exposure mask was set on the coating film such that the vertical/horizontal edge portions in the patterned light-shielding portion of the positive type exposure mask, in which openings (rectangles of 30 µm in width/165 µm in length) were arranged at an inter-opening pitch of 50 µm, were parallel to the vertical/horizontal edge portions of the alkali-free glass substrate (4), respectively; and using a manually operated exposure machine (MA-1200; manufactured by Japan Science Engineering Co., Ltd.), the prebaked film was pattern-irradiated with exposure light of a mixed line of j-line (313 nm), i-line (wavelength: 365 nm), h-line (wavelength: 405 nm), and g-line (wavelength: 436 nm) of an ultra-high pressure mercury lamp through the positive type exposure mask at a minimum exposure amount required, to obtain an exposed film. Subsequently, development and rinsing were conducted, affording a developed film. As the positive type exposure mask, a mask with a patterned light shielding portion made of chromium formed on a surface of a soda glass substrate was used.

Further, the developed film was subjected to a heating treatment (curing) to form a cured film, thereby yielding a patterned cured film-formed substrate having an opening ratio of 18%, which included a 2.0 µm-thick patterned cured film (9) in which openings (rectangles of 30 µm in width × 165 µm in length) were arranged at an inter-opening pitch of 50 µm in an area of 16 mm in length × 16 mm in width at the central portion of the electrode-formed substrate. The curing was conducted under the condition in which the temperature was raised to 250°C at 5°C/min at an oxygen concentration of 20 ppm or less and a heating treatment was conducted at 250°C for 1 hour using a high-temperature inert gas oven (INH-9CD-S; manufactured by Koyo Thermo Systems Co., Ltd.). In the organic EL display device obtained after the process described later, the opening as referred to here is a portion that finally becomes a light-emitting pixel portion, and the patterned cured film is a portion corresponding to a pixel defining layer.

Next, an organic EL display device was produced using the patterned cured film-formed substrate. To form the organic EL layer (10) including a light-emitting layer by a vacuum deposition method, the patterned cured film-formed substrate was rotated with respect to a deposition source under the vapor deposition condition specified by a degree of vacuum of 1 × 10⁻³ Pa or less, and first, a film of a compound HT-1 was formed in a thickness of 10 nm as a hole injection layer, and a film of a compound HT-2 was formed in a thickness of 50 nm as a hole transport layer. Next, a compound GH-1 as a host material and a compound GD-1 as a dopant material were deposited on the light-emitting layer in a thickness of 40 nm. Thereafter, a compound ET-1 and a compound LiQ were laminated as electron transporting materials with a volume ratio of 1 : 1 in a thickness of 40 nm.

Next, the compound (LiQ) was deposited in a thickness of 2 nm, and then a silver/magnesium alloy (volume ratio: 10 : 1) was deposited in a thickness of 10 nm to form a first electrode (11).

The chemical structures of the compound groups (HT-1, HT-2, GH-1, GD-1, ET-1, LiQ) used for forming the organic EL layer are shown below.

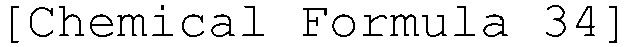

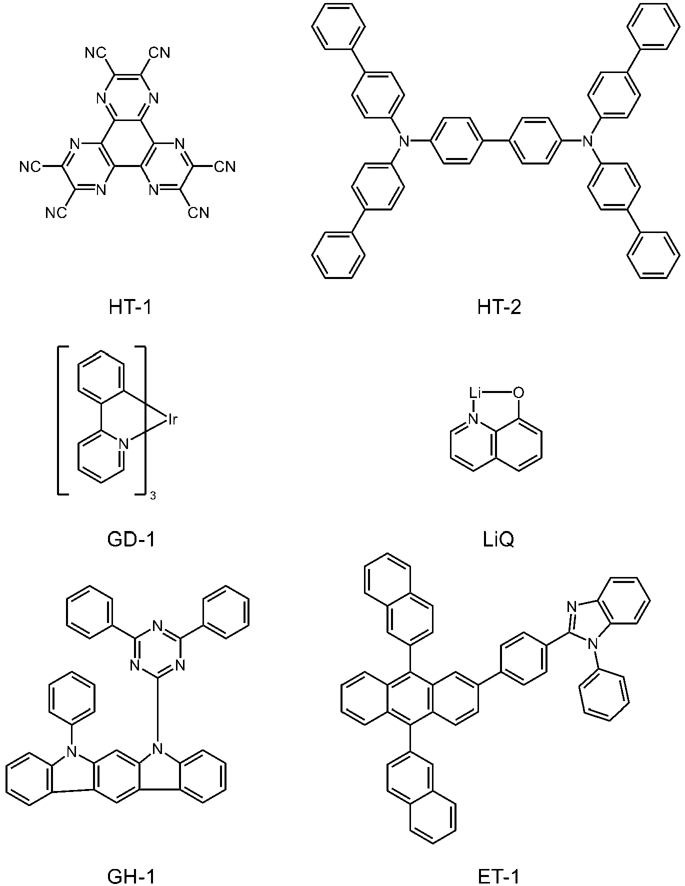

It is to be noted that the film thickness as referred to herein is a value displayed on a crystal oscillation-type film thickness monitor.

Thereafter, under a low-humidity nitrogen atmosphere, sealing was conducted by bonding a cap-shaped glass plate with an epoxy resin-based adhesive, yielding an organic EL display device.

### Observation of appearance of organic EL display device

The surface of the pixel defining layer of the obtained organic EL display device was observed using an FPD/LSI inspection microscope (OPTIPHOT-300; manufactured by NIKON CORPORATION); those in which swelling of the film due to bubbles was observed were determined as NG, and those in which the surface of the pixel defining layer was flat and swelling due to bubbles was not observed were determined as OK.

### Light emission reliability test of organic EL display device

The obtained organic EL display device was placed on a hot plate heated to 80°C with the display unit (light-emitting surface) facing upward, and the pixel light-emitting area ratio (ratio of the area of the actual light-emitting portions to the area of the light-emitting pixels) was evaluated after 1 hour from when light was emitted by DC drive at 10 mA/cm². Thereafter, the power was temporarily turned off to turn off the light.

Subsequently, the display unit was continuously irradiated with light having an illuminance of 3.0 W/m² at a wavelength of 420 nm using a xenon lamp as a light source as pseudo sunlight in a state of being placed on a hot plate heated to 80°C. After 100 hours, 500 hours, and 1000 hours from the start of irradiation, light was emitted again, the area of the light emitting unit was measured for 10 light-emitting pixel portions located in the central portion, the ratio (pixel light-emitting area ratio) of the area of the light emitting unit after a specified time to the light emitting unit after 1 hour of heating and light emission was determined, and the average value thereof was calculated. It was determined that the light emission reliability was excellent as a high pixel light-emitting area ratio could be maintained, and evaluation was performed based on the following criteria.
A: The pixel light-emitting area ratio is 95% or more.
B: The pixel light-emitting area ratio is 80% or more and less than 95%.
C: The pixel light-emitting area ratio is 65% or more and less than 80%.
D: The pixel light-emitting area ratio is less than 65%.

In each evaluation, A to C where the pixel light-emitting area ratio was 65% or more were regarded as acceptable, and D was regarded as failed. A is the most preferable result.

### <Synthesis Example 1: Synthesis of quinone diazide compound QD-a>

Under a dried nitrogen stream, 21.22 g (0.05 mol) of TrisP-PA (manufactured by Honshu Chemical Industry Co., Ltd.) and 36.27 g (0.135 mol) of 5-naphthoquinone diazide sulfonyl chloride were dissolved in 450 g of 1,4-dioxane, and the temperature of the resulting solution was adjusted to room temperature. A solution obtained by dissolving 15.18 g of triethylamine in 50 g of 1,4-dioxane was added dropwise thereto such that the temperature in the system was 35°C or less. After the dropwise addition, the solution was stirred at 30°C for 2 hours. The triethylamine salt was removed by filtration, and the filtrate was poured into water. Thereafter, filtration was conducted, and the generated precipitate was collected. The precipitate was dried in a vacuum dryer, affording a quinone diazide compound QD-a represented by formula (41).

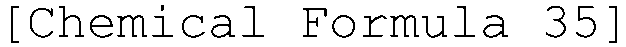

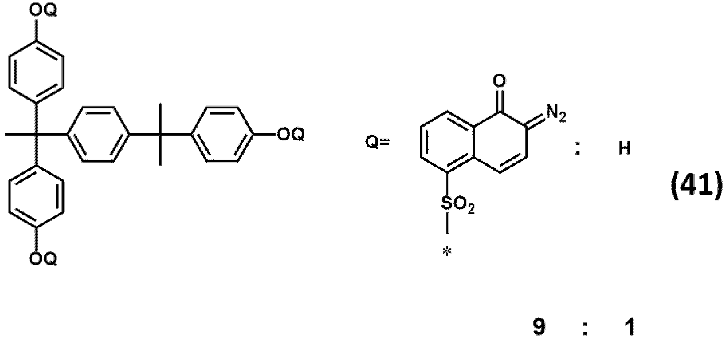

In the formula (41), * represents a bonding site with an oxygen atom.

### <Synthesis Example 2: Synthesis of quinone diazide compound QD-b>

A quinone diazide compound QD-b represented by formula (42) was obtained by conducting synthesis in the same manner as in the Synthesis Example of the quinone diazide compound QD-a except that 36.27 g (0.135 mol) of 4-naphthoquinone diazide sulfonyl chloride was used instead of 36.27 g (0.135 mol) of 5-naphthoquinone diazide sulfonyl chloride.

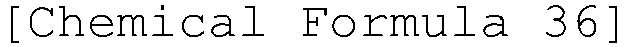

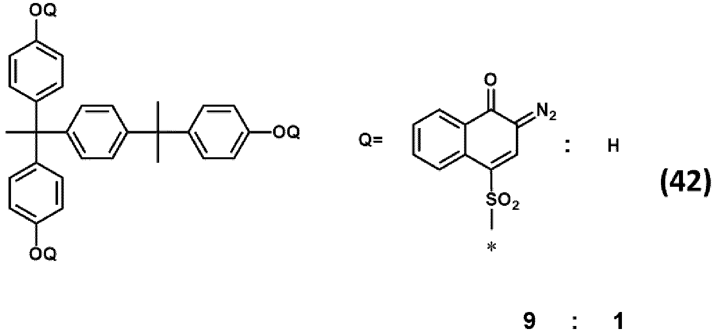

In the formula (42), * represents a bonding site with an oxygen atom.

### <Synthesis Example 3: Synthesis of diamine (DAP-A)>

A 500 ml four-necked flask equipped with a stirrer, a thermocouple and a dropping funnel was charged with BisP-3MZ (manufactured by Honshu Chemical Industry Co., Ltd.). 4,4'-(3-Methylcyclohexane-1,1-diyl)diphenol (24.28 g, 0.086 mol) and glacial acetic acid (100 ml) were charged and stirred, and the internal temperature was raised to 50°C in a hot water bath. Concentrated nitric acid (2 ml, 0.026 mol) was added dropwise thereto over 1 hour, and thereafter, the internal temperature was lowered to 13°C by ice cooling, and further concentrated nitric acid (13.3 ml, 0.149 mol) was added dropwise over 1 hour. Thereafter, stirring was continued for 3 hours, and the precipitated yellow crystals were collected by filtration, washed sequentially with 40 ml of glacial acetic acid and 80 ml of deionized water, and dried under reduced pressure, affording a dinitro form.

Subsequently, 50.27 g (0.135 mol) of the dinitro form, 180 ml (3.71 mol) of hydrazine monohydrate and 900 ml of ethanol were put in a 2-L four-necked flask equipped with a stirrer, a thermocouple, a Dimroth cooling tube and a dropping funnel, and stirred under ice cooling, and 0.9 g of 5% palladium on carbon (manufactured by Wako Pure Chemical Industries, Ltd.) suspended in 30 ml of ethanol was added dropwise thereto over 1 hour. Thereafter, the solution was refluxed for 2 hours, and the palladium on carbon was removed by filtration while cleaning with 300 ml of ethanol. All the solvents were removed by heating under reduced pressure conditions, and the residual substance was washed with 75 ml of ethanol cooled with ice and filtered, then further washed sequentially with 75 ml of deionized water and 150 ml of diethyl ether, and dried under reduced pressure to obtain a diamine (DAP-A).

### <Synthesis Example 4: Synthesis of diamine (DAP-B)>

BisP-HTG (manufactured by Honshu Chemical Industry Co., Ltd.) instead of BisP-3MZ (manufactured by Honshu Chemical Industry Co., Ltd.). Except that 26.70 g (0.086 mol) of 4,4'-(3,3,5-trimethylcyclohexylidene) bisphenol was used to synthesize a dinitro form, and 54.06 g (0.135 mol) of the dinitro form was used, a diamine (DAP-B) was obtained in the same manner as in Synthesis Example 3.

### <Synthesis Example 5: Synthesis of diamine (DAP-C)>

Except that 23.25 g (0.086 mol) of 4,4'-(1,3-dimethylbutylidene)diphenol (manufactured by Tokyo Chemical Industry Co., Ltd.) was used in place of BisP-3MZ (manufactured by Honshu Chemical Industry Co., Ltd.) to synthesize a dinitro form, and 48.65 g (0.135 mol) of the dinitro form was used, a diamine (DAP-C) was obtained in the same manner as in Synthesis Example 3.

### <Synthesis Example 6: Synthesis of Diamine (DAP-D)>

Except that (20.84 g, 0.086 mol) of 2,2-bis(4-hydroxyphenyl)butane (manufactured by Tokyo Chemical Industry Co., Ltd.) was used in place of BisP-3MZ (manufactured by Honshu Chemical Industry Co., Ltd.) to synthesize a dinitro form, and 44.86 g (0.135 mol) of the dinitro form was used, a diamine (DAP-D) was obtained in the same manner as in Synthesis Example 3.

### <Synthesis Example 7: Synthesis of diamine (DAP-E)>

BisP-IOTD (manufactured by Honshu Chemical Industry Co., Ltd.) instead of BisP-3MZ (manufactured by Honshu Chemical Industry Co., Ltd.). Except that 25.66 g (0.086 mol) of 4,4'-(2-ethylhexylidene)diphenol was used to synthesize a dinitro form, and 52.44 g (0.135 mol) of the dinitro form was used, a diamine (DAP-E) was obtained in the same manner as in Synthesis Example 3.

### <Synthesis Example 8: Synthesis of diamine (DAP-F)>

BisP-IBTD (manufactured by Honshu Chemical Industry Co., Ltd.) instead of BisP-3MZ (manufactured by Honshu Chemical Industry Co., Ltd.). Except that 4,4'-(2-methylpropane-1,1-diyl)diphenol (22.13 g, 0.086 mol) was used to synthesize a dinitro form, and 46.89 g (0.135 mol) of the dinitro form was used, a diamine (DAP-F) was obtained in the same manner as in Synthesis Example 3.

### <Synthesis Example 9: Synthesis of diamine (DAP-G)>

BIOC-E (manufactured by ASAHI YUKIZAI CORPORATION) instead of BisP-3MZ (manufactured by Honshu Chemical Industry Co., Ltd.) A diamine (DAP-G) was obtained in the same manner as in Synthesis Example 3, except that 1,1'-bis(4-hydroxy-3-methylphenyl)ethane (20.84 g, 0.086 mol) was used to synthesize a dinitro form, and 44.86 g (0.135 mol) of the dinitro form was used.

### <Synthesis Example 10: Synthesis of diamine (DAP-H)>

SPI (manufactured by JFE Chemical Corporation) instead of BisP-3MZ (manufactured by Honshu Chemical Industry Co., Ltd.). Except that 3,3,3',3'-tetramethyl-1,1'-spirobiindane-6,6'-diol (26.52 g, 0.086 mol) was used to synthesize a dinitro form, and 53.79 g (0.135 mol) of the dinitro form was used, a diamine (DAP-H) was obtained in the same manner as in Synthesis Example 3.

### <Synthesis Example 11: Synthesis of diamine (DAP-I)>

TMHI (manufactured by JFE Chemical Corporation) instead of BisP-3MZ (manufactured by Honshu Chemical Industry Co., Ltd.) Except that 3-(4-hydroxyphenyl)-1,1,3-trimethyl-5-indanol 23.08 g (0.086 mol) was used to synthesize a dinitro form, and 48.38 g (0.135 mol) of the dinitro form was used, a diamine (DAP-H) was obtained in the same manner as in Synthesis Example 3.

### <Synthesis Example 12: Synthesis of 2,2-bis[3-(3-aminobenzamide)-4-hydroxyphenyl]hexafluoropropane (HA)>

BAHF (18.3 g (0.05 mol)) was dissolved in 100 mL of acetone and 17.4 g (0.3 mol) of propylene oxide (manufactured by Tokyo Chemical Industry Co., Ltd.), and the solution was cooled to -15°C. To this solution, a solution prepared by dissolving 20.4 g (0.11 mol) of 3-nitrobenzoyl chloride (manufactured by Tokyo Chemical Industry Co., Ltd.) in 100 mL of acetone was added dropwise. After the completion of the dropwise addition, the solution was stirred at -15°C for 4 hours and then returned to room temperature. The precipitated white solid was collected by filtration, and vacuum-dried at 50°C.

30 g of the obtained white solid was charged in a 300 mL stainless steel autoclave, and dispersed in 250 mL of methyl cellosolve, followed by adding 2.0 g of 5% palladium on carbon (manufactured by Wako Pure Chemical Industries, Ltd.). Hydrogen was introduced thereinto with a balloon, and a reduction reaction was conducted at room temperature. After about 2 hours, the reaction was completed when it was confirmed that the balloon could not deflate any more. After the end of the reaction, the solution was filtrated to remove the palladium compound used as a catalyst and concentrated with a rotary evaporator to provide a diamine compound (HA) as represented by the formula given below.

### <Synthesis Example 13: Synthesis of diamine compound (HB)>

Except that BAP (12.9 g, 0.05 mol) was used in place of BAHF, a diamine compound (HB) was obtained in the same manner as in Synthesis Example 12.

### <Synthesis Example 14: Synthesis of diamine compound (HC)>

Except that DAP-B obtained in Synthesis Example 4 (17.0 g, 0.05 mol) was used in place of BAHF, a diamine compound (HC) was obtained in the same manner as in Synthesis Example 12.

### <Synthesis Example 15: Synthesis of diamine compound (HD)>

Except that 15.0 g (0.05 mol) of DAP-C obtained in Synthesis Example 5 was used in place of BAHF, a diamine compound (HD) was obtained in the same manner as in Synthesis Example 12.

### <Synthesis Example 16: Synthesis of diamine compound (HE)>

Except that 13.6 g (0.05 mol) of DAP-D obtained in Synthesis Example 6 was used in place of BAHF, a diamine compound (HE) was obtained in the same manner as in Synthesis Example 12.

### <Synthesis Example 17: Synthesis of diamine compound (DAP-J)>

Except that 23.08 g (0.086 mol) of 4,4'-cyclohexylidene bisphenol (Manufactured by Tokyo Chemical Industry Co., Ltd.) was used in place of BisP-3MZ (manufactured by Honshu Chemical Industry Co., Ltd.) to synthesize a dinitro form, and 48.38 g (0.135 mol) of the dinitro form was used, a diamine compound (DAP-J) was obtained in the same manner as in Synthesis Example 3.

### <Synthesis Example 18: Synthesis of diamine compound (DAP-K)>

Except that in place of BisP-3MZ (manufactured by Honshu Chemical Industry Co., Ltd.), 27.90 g (0.086 mol) of 4,4'-(p-menthane-2,8-diyl)diphenol (Chemieliva Pharmaceutical.), which is one type of terpene diphenol, was used to synthesize a dinitro form, and 55.95 g (0.135 mol) of the dinitro form was used, a diamine compound (DAP-K) was obtained in the same manner as in Synthesis Example 3.

The structures of the diamine compounds obtained in Synthesis Example 3 to 18 are collectively shown below.

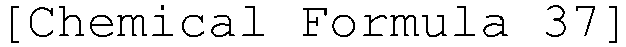

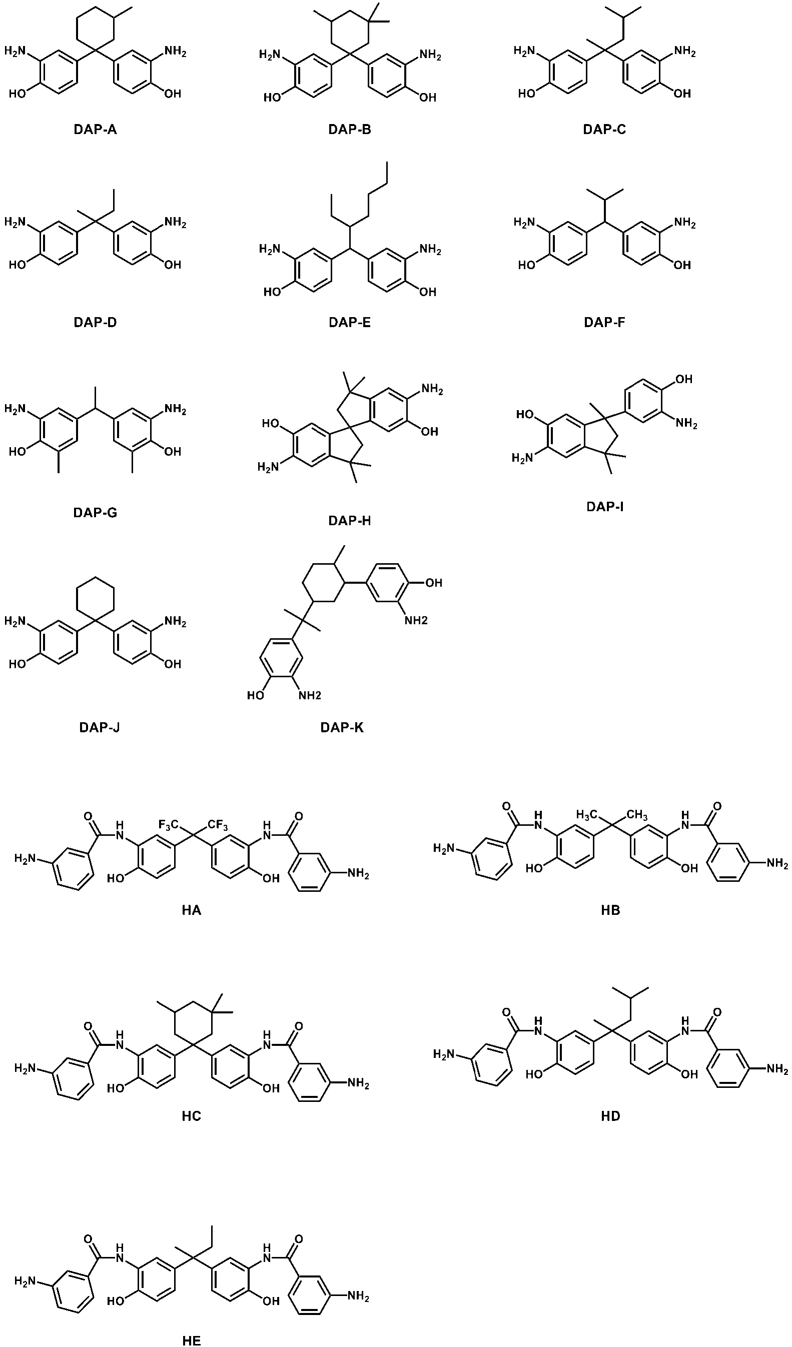

### <Synthesis Example 51: Synthesis of polyamic acid (a-1)>

In a dry nitrogen flow, 13.0 g (0.042 mol) of the diamine compound (DAP-A) obtained in Synthesis Example 3 and 0.62 g (0.0025 mol) of SiDA were dissolved in 95 g of MPA. To this solution, 7.51 g (0.025 mol) of TDA and 7.76 g (0.025 mol) of ODPA were added together with 10 g of MPA, and the mixture was stirred at 60°C for 2 hours. Then, 1.09 g (0.010 mol) of MAP as an end-capping agent was added together with 10 g of MPA, and the mixture was reacted at 60°C for 1 hour. Then the resultant mixture was stirred at 140°C for 4 h. After the termination of the stirring, the solution was poured into 2 L of deionized water, and a precipitate of a polymer solid was collected by filtration. Further, the precipitates were washed with 2 L of deionized water three times, and the collected polymer solid was dried in a vacuum dryer at 50°C for 72 hours, affording a polyamic acid (a-1) as a form of polyimide.

### <Synthesis Example 52: Synthesis of polyamic acid (a-2)>

Except that 14.13 g (0.042 mol) of the diamine compound (DAP-B) prepared in Synthesis Example 4 was used in place of the diamine compound (DAP-A), a polyamic acid (a-2) as a form of polyimide was obtained in the same manner as in Synthesis Example 51.

### <Synthesis Example 53: Synthesis of polyamic acid (a-3)>

Except that 12.47 g (0.042 mol) of the diamine compound (DAP-C) prepared in Synthesis Example 5 was used in place of the diamine compound (DAP-A), a polyamic acid (a-3) as a form of polyimide was obtained in the same manner as in Synthesis Example 51.

### <Synthesis Example 54: Synthesis of polyamic acid (a-4)>

Except that 11.30 g (0.042 mol) of the diamine compound (DAP-D) prepared in Synthesis Example 6 was used in place of the diamine compound (DAP-A), a polyamic acid (a-4) as a form of polyimide was obtained in the same manner as in Synthesis Example 51.

### <Synthesis Example 55: Synthesis of polyamic acid (a-5)>

Except that 13.63 g (0.042 mol) of the diamine compound (DAP-E) prepared in Synthesis Example 7 was used in place of the diamine compound (DAP-A), a polyamic acid (a-5) as a form of polyimide was obtained in the same manner as in Synthesis Example 51.

### <Synthesis Example 56: Synthesis of polyamic acid (a-6)>

Except that 11.30 g (0.042 mol) of the diamine compound (DAP-F) prepared in Synthesis Example 8 was used in place of the diamine compound (DAP-A), a polyamic acid (a-6) as a form of polyimide was obtained in the same manner as in Synthesis Example 51.

### <Synthesis Example 57: Synthesis of polyamic acid (a-7)>

Except that 11.30 g (0.042 mol) of the diamine compound (DAP-G) prepared in Synthesis Example 9 was used in place of the diamine compound (DAP-A), a polyamic acid (a-7) as a form of polyimide was obtained in the same manner as in Synthesis Example 51.

### <Synthesis Example 58: Synthesis of polyamic acid (a-8)>

Except that 14.05 g (0.042 mol) of the diamine compound (DAP-H) prepared in Synthesis Example 10 was used in place of the diamine compound (DAP-A), a polyamic acid (a-8) as a form of polyimide was obtained in the same manner as in Synthesis Example 51.

### <Synthesis Example 59: Synthesis of polyamic acid (a-9)>

Except that 12.38 g (0.042 mol) of the diamine compound (DAP-I) prepared in Synthesis Example 11 was used in place of the diamine compound (DAP-A), a polyamic acid (a-9) as a form of polyimide was obtained in the same manner as in Synthesis Example 51.

### <Synthesis Example 60: Synthesis of polyamic acid (a-10)>

Except that 6.61 g (0.025 mol) of MCTC (manufactured by Tokyo Chemical Industry Co., Ltd.) was used in place of TDA, a polyamic acid (a-10) as a form of polyimide was obtained in the same manner as in Synthesis Example 52.

### <Synthesis Example 61: Synthesis of polyamic acid (a-11)>

Except that 10.72 g (0.032 mol) of the diamine compound (DAP-B) and 2.00 g (0.010 mol) of 3,4'-ODA(3,4'-diaminodiphenyl ether, manufactured by Tokyo Chemical Industry Co., Ltd.) were used in place of 14.13 g (0.042 mol) of the diamine compound (DAP-B), a polyamic acid (a-11) as a form of polyimide was obtained in the same manner as in Synthesis Example 52.

### <Synthesis Example 62: Synthesis of polyamic acid (a-12)>

Except that 7.32 g (0.022 mol) of the diamine compound (DAP-B) and 4.00 g (0.020 mol) of 3,4'-ODA(3,4'-diaminodiphenyl ether, manufactured by Tokyo Chemical Industry Co., Ltd.) were used in place of 14.13 g (0.042 mol) of the diamine compound (DAP-B), a polyamic acid (a-12) as a form of polyimide was obtained in the same manner as in Synthesis Example 52.

### <Synthesis Example 63: Synthesis of polyamic acid ester (a-13)>

In a dry nitrogen flow, 24.02 g (0.042 mol) of the diamine compound (HC) obtained in Synthesis Example 13 and 0.62 g (0.0025 mol) of SiDA were dissolved in 95 g of MPA. To this solution, 15.0 g (0.050 mol) of TDA was added together with 10 g of MPA, and the mixture was stirred at 60°C for 2 hours. Then, 1.09 g (0.010 mol) of MAP as an end-capping agent was added together with 10 g of MPA, and the mixture was reacted at 60°C for 1 hour. After lowering the temperature from 60°C to 40°C, a solution of 11.9 g (0.010 mol) of DMFDMA diluted with 10 g of MPA was added dropwise. After the dropwise addition, stirring was continued at 40°C for 2 hours. After the termination of the stirring, the solution was poured into 2 L of deionized water, and a precipitate of a polymer solid was collected by filtration. Further, the precipitates were washed with 2 L of deionized water three times, and the collected polymer solid was dried in a vacuum dryer at 50°C for 72 hours, affording a polyamic acid ester (a-13) as a form of polyimide.

### <Synthesis Example 64: Synthesis of polyamic acid ester (a-14)>

Except that 22.35 g (0.042 mol) of the diamine compound (HD) was used in place of 24.02 g (0.042 mol) of the diamine compound (HC), a polyamic acid ester (a-14) as a form of polyimide was obtained in the same manner as in Synthesis Example 63.

### <Synthesis Example 65: Synthesis of polyamic acid ester (a-15)>

Except that 21.19 g (0.042 mol) of the diamine compound (HE) was used in place of 24.02 g (0.042 mol) of the diamine compound (HC), a polyamic acid ester (a-15) as a form of polyimide was obtained in the same manner as in Synthesis Example 63.

### <Synthesis Example 66: Synthesis of polyamic acid ester (a-16)>

Except that 13.21 g (0.050 mol) of MCTC was used in place of 15.01 g (0.050 mol) of TDA, a polyamic acid ester (a-16) as a form of polyimide was obtained in the same manner as in Synthesis Example 63.

### <Synthesis Example 67: Synthesis of polyamic acid ester (a-17)>

Except that DMIB was used in place of MPA as a solvent, a polyamic acid ester (a-17) as a form of polyimide was obtained in the same manner as in Synthesis Example 66.

### <Synthesis Example 68: Synthesis of polyamic acid ester (a-18)>

Except that DMPA was used in place of MPA as a solvent, a polyamic acid ester (a-18) as a form of polyimide was obtained in the same manner as in Synthesis Example 66.

### <Synthesis Example 69: Synthesis of polyamic acid ester (a-19)>

Except that GBL was used in place of MPA as a solvent, a polyamic acid ester (a-19) as a form of polyimide was obtained in the same manner as in Synthesis Example 66.

### <Synthesis Example 70: Synthesis of polyamic acid (a-20)>

Except that 15.51 g (0.050 mol) of ODPA (manufactured by Tokyo Chemical Industry Co., Ltd.) was used in place of 7.51 g (0.025 mol) of TDA and 7.76 g (0.025 mol) of ODPA, a polyamic acid (a-20) as a form of polyimide was obtained in the same manner as in Synthesis Example 52.

### <Synthesis Example 71: Synthesis of Polyimide (a-21)>

In a dry nitrogen flow, 13.0 g (0.042 mol) of the diamine compound (DAP-A) obtained in Synthesis Example 3 and 0.62 g (0.0025 mol) of SiDA were dissolved in 95 g of MPA. To this solution, 7.51 g (0.025 mol) of TDA and 7.76 g (0.025 mol) of ODPA were added together with 10 g of MPA, and the mixture was stirred at 60°C for 2 hours. Then, 1.09 g (0.010 mol) of MAP as an end-capping agent was added together with 10 g of MPA, and the mixture was reacted at 60°C for 1 hour. Then the resultant mixture was stirred at 180°C for 4 h. After the termination of the stirring, the solution was poured into 2 L of deionized water, affording a white precipitate. This precipitate was collected by filtration, washed 3 times with deionized water, and then dried in a vacuum dryer at 50°C for 72 hours to obtain a powder of polyimide (a-21).

### <Synthesis Example 72: Synthesis of polyamic acid (a-22)>

Except that 10.72 g (0.042 mol) of BAP was used in place of the diamine compound (DAP-A), a polyamic acid (a-22) as a form of polyimide was obtained in the same manner as in Synthesis Example 51.

### <Synthesis Example 73: Synthesis of polyamic acid ester (a-23)>

Except that 25.09 g (0.042 mol) of the diamine compound (HA) was used in place of 24.02 g (0.042 mol) of the diamine compound (HC), a polyamic acid ester (a-23) as a form of polyimide was obtained in the same manner as in Synthesis Example 63.

### <Synthesis Example 74: Synthesis of polyamic acid ester (a-24)>

Except that 20.86 g (0.042 mol) of the diamine compound (HB) was used in place of 24.02 g (0.042 mol) of the diamine compound (HC), a polyamic acid ester (a-24) as a form of polyimide was obtained in the same manner as in Synthesis Example 63.

### <Synthesis Example 75: Synthesis of polyamic acid ester (a-25)>

Except that 15.5 g (0.050 mol) of ODPA was used in place of 15.0 g (0.050 mol) of TDA, a polyamic acid ester (a-25) as a form of polyimide was obtained in the same manner as in Synthesis Example 63.

### <Synthesis Example 76: Synthesis of polyamic acid ester (a-26)>

Except that 13.4 g (0.039 mol) of the diamine compound (DAP-B) and 1.46 g (0.0025 mol) of the diamine compound (HC) were used in place of 24.02 g (0.042 mol) of the diamine compound (HC), a polyamic acid ester (a-26) as a form of polyimide was obtained in the same manner as in Synthesis Example 75.

### <Synthesis Example 77: Synthesis of polyamic acid ester (a-27)>

Except that 12.6 g (0.037 mol) of the diamine compound (DAP-B) and 2.93 g (0.0051 mol) of the diamine compound (HC) were used in place of 24.02 g (0.042 mol) of the diamine compound (HC), a polyamic acid ester (a-27) as a form of polyimide was obtained in the same manner as in Synthesis Example 75.

### <Synthesis Example 78: Synthesis of polyamic acid ester (a-28)>

Except that 10.0 g (0.029 mol) of the diamine compound (DAP-B) and 7.32 g (0.013 mol) of the diamine compound (HC) were used in place of 24.02 g (0.042 mol) of the diamine compound (HC), a polyamic acid ester (a-28) as a form of polyimide was obtained in the same manner as in Synthesis Example 75.

### <Synthesis Example 79: Synthesis of polyamic acid ester (a-29)>

Except that 7.41 g (0.022 mol) of the diamine compound (DAP-B) and 11.7 g (0.020 mol) of the diamine compound (HC) were used in place of 24.02 g (0.042 mol) of the diamine compound (HC), a polyamic acid ester (a-29) as a form of polyimide was obtained in the same manner as in Synthesis Example 75.

### <Synthesis Example 80: Synthesis of polyamic acid ester (a-30)>

Except that 5.17 g (0.015 mol) of the diamine compound (DAP-B) and 15.5 g (0.027 mol) of the diamine compound (HC) were used in place of 24.02 g (0.042 mol) of the diamine compound (HC), a polyamic acid ester (a-30) as a form of polyimide was obtained in the same manner as in Synthesis Example 75.

### <Synthesis Example 81: Synthesis of polyamic acid ester (a-31)>

Except that 3.45 g (0.010 mol) of the diamine compound (DAP-B) and 18.4 g (0.032 mol) of the diamine compound (HC) were used in place of 24.02 g (0.042 mol) of the diamine compound (HC), a polyamic acid ester (a-31) as a form of polyimide was obtained in the same manner as in Synthesis Example 75.

### <Synthesis Example 82: Synthesis of polyamic acid ester (a-32)>

Except that 8.80 g (0.029 mol) of the diamine compound (DAP-C) and 7.35 g (0.013 mol) of the diamine compound (HC) were used in place of 24.02 g (0.042 mol) of the diamine compound (HC), a polyamic acid ester (a-32) as a form of polyimide was obtained in the same manner as in Synthesis Example 75.

### <Synthesis Example 83: Synthesis of polyamic acid ester (a-33)>

Except that 9.98 g (0.029 mol) of the diamine compound (DAP-B) and 6.84 g (0.013 mol) of the diamine compound (HD) were used in place of 24.02 g (0.042 mol) of the diamine compound (HC), a polyamic acid ester (a-33) as a form of polyimide was obtained in the same manner as in Synthesis Example 75.

### <Synthesis Example 84: Synthesis of polyamic acid ester (a-34)>

Except that 8.80 g (0.029 mol) of the diamine compound (DAP-C) and 6.31 g (0.013 mol) of the diamine compound (HB) were used in place of 24.02 g (0.042 mol) of the diamine compound (HC), a polyamic acid ester (a-34) as a form of polyimide was obtained in the same manner as in Synthesis Example 75.

### <Synthesis Example 85: Synthesis of polyamic acid ester (a-35)>

Except that 7.57 g (0.029 mol) of BAP and 7.35 g (0.013 mol) of the diamine compound (HC) were used in place of 24.02 g (0.042 mol) of the diamine compound (HC), a polyamic acid ester (a-35) as a form of polyimide was obtained in the same manner as in Synthesis Example 75.

### <Synthesis Example 86: Synthesis of polyamic acid ester (a-36)>

Except that 1.17 g (0.010 mol) of 4-APA was used in place of 1.09 g (0.010 mol) of MAP, a polyamic acid ester (a-36) as a form of polyimide was obtained in the same manner as in Synthesis Example 78.

### <Synthesis Example 87: Synthesis of polyamic acid ester (a-37)>

Except that 9.98 g (0.029 mol) of the diamine compound (DAP-B), 7.00 g (0.012 mol) of the diamine compound (HC), and 0.15 g (0.00051 mol) of TPE-R were used in place of 24.02 g (0.042 mol) of the diamine compound (HC), a polyamic acid ester (a-37) as a form of polyimide was obtained in the same manner as in Synthesis Example 75.

### <Synthesis Example 88: Synthesis of polyamic acid ester (a-38)>

Except that 9.98 g (0.029 mol) of the diamine compound (DAP-B), 5.84 g (0.010 mol) of the diamine compound (HC), and 0.74 g (0.0025 mol) of TPE-R were used in place of 24.02 g (0.042 mol) of the diamine compound (HC), a polyamic acid ester (a-38) as a form of polyimide was obtained in the same manner as in Synthesis Example 75.

### <Synthesis Example 89: Synthesis of polyamic acid ester (a-39)>

Except that 9.12 g (0.027 mol) of the diamine compound (DAP-B), 4.39 g (0.0076 mol) of the diamine compound (HC), and 2.22 g (0.0076 mol) of TPE-R were used in place of 24.02 g (0.042 mol) of the diamine compound (HC), a polyamic acid ester (a-39) as a form of polyimide was obtained in the same manner as in Synthesis Example 75.

### <Synthesis Example 90: Synthesis of polyamic acid ester (a-40)>

Except that 7.42 g (0.022 mol) of the diamine compound (DAP-B), 4.39 g (0.0076 mol) of the diamine compound (HC), and 3.71 g (0.013 mol) of TPE-R were used in place of 24.02 g (0.042 mol) of the diamine compound (HC), a polyamic acid ester (a-40) as a form of polyimide was obtained in the same manner as in Synthesis Example 75.

### <Synthesis Example 91: Synthesis of polyamic acid ester (a-41)>

Except that 6.54 g (0.019 mol) of the diamine compound (DAP-B), 4.39 g (0.0076 mol) of the diamine compound (HC), and 4.44 g (0.015 mol) of TPE-R were used in place of 24.02 g (0.042 mol) of the diamine compound (HC), a polyamic acid ester (a-41) as a form of polyimide was obtained in the same manner as in Synthesis Example 75.

### <Synthesis Example 92: Synthesis of polyamic acid ester (a-42)>

Except that 0.51 g (0.0025 mol) of 3,4'-ODA was used in place of 0.74 g (0.0025 mol) of TPE-R, a polyamic acid ester (a-42) as a form of polyimide was obtained in the same manner as in Synthesis Example 88.

### <Synthesis Example 93: Synthesis of polyamic acid ester (a-43)>

Except that 9.98 g (0.029 mol) of the diamine compound (DAP-B) and 7.35 g (0.013 mol) of HC were used in place of 14.13 g (0.042 mol) of the diamine compound (DAP-B), a polyamic acid (a-43) as a form of polyimide was obtained in the same manner as in Synthesis Example 70.

### <Synthesis Example 94: Synthesis of polyamic acid ester (a-44)>

Except that DMIB was used in place of MPA as a solvent, a polyamic acid ester (a-44) as a form of polyimide was obtained in the same manner as in Synthesis Example 78.

### <Synthesis Example 95: Synthesis of polyamic acid ester (a-45)>

Except that GBL was used in place of MPA as a solvent, a polyamic acid ester (a-45) as a form of polyimide was obtained in the same manner as in Synthesis Example 78.

### <Synthesis Example 96: Synthesis of polyamic acid ester (a-46)>

After completion of stirring, the solution was charged into 2 L of a mixed solution of deionized water and methanol (1/1, weight ratio), and a precipitate of a polymer solid was collected by filtration, and further washed three times with 2 L of a mixed solution of deionized water and methanol (1/1, weight ratio), and the collected polymer solid was dried in a vacuum dryer at 50°C for 72 hours, and a polyamic acid ester (a-46) as a form of polyimide was obtained in the same manner as in Synthesis Example 63.

### <Synthesis Example 97: Synthesis of polyamic acid ester (a-47)>

Except that 24.60 g (0.043 mol) of the diamine compound (HC) was used, and MAP as an end-capping agent was not used, a polyamic acid ester (a-47) as a form of polyimide was obtained in the same manner as in Synthesis Example 63.

### <Synthesis Example 98: Synthesis of polyamic acid (a-48)>

Except that 7.66 g (0.025 mol) of HBPDA was used in place of 7.51 g (0.025 mol) of TDA, a polyamic acid (a-48) as a form of polyimide was obtained in the same manner as in Synthesis Example 52.

### <Synthesis Example 99: Synthesis of polyamic acid (a-49)>

Except that 12.53 g (0.042 mol) of the diamine compound (DAP-J) prepared in Synthesis Example 17 was used in place of the diamine compound (DAP-A), a polyamic acid (a-49) as a form of polyimide was obtained in the same manner as in Synthesis Example 51.

### <Synthesis Example 100: Synthesis of polyamic acid (a-50)>

Except that 14.89 g (0.042 mol) of the diamine compound (DAP-K) prepared in Synthesis Example 18 was used in place of the diamine compound (DAP-A), a polyamic acid (a-50) as a form of polyimide was obtained in the same manner as in Synthesis Example 51.

Tables 1-1 to 1-4 show, for Synthesis Examples 51 to 100, the measurement results of the components (molar ratio), molecular weight (Mw), esterification rate [%], imide ring closure rate [%], the amount of components having a molecular weight of 1000 or less, and the content [parts by mass] of the compounds represented by formula (17) and formula (18).

**[Table 1-1]**

| | Resin (A) | Tetracarboxylic acid, dicarboxylic acid, and derivatives thereof (molar ratio) | | Diamine and derivatives thereof (molar ratio) | | | End-capping agent (molar ratio) | Polymerization solvent | Resin evaluation | | | | |
|---|---|---|---|---|---|---|---|---|---|---|---|---|---|
| | | | | | | | | | Weight average molecular weight (Mw) | Amount of components having molecular weight of 1000 or less [% by mass] | Esterification rate [%] | Imide ring closure rate [%] | Content of compounds represented by formula (17) and formula (18) [parts by mass] |
| Synthesis Example 51 | Polyamic acid (a-1) | TDA (50) | ODPA (50) | DAP-A (83) | - | SiDA (5) | MAP (20) | MPA | 25000 | 2.1 | 0 | 75 | 4.2 |
| Synthesis Example 52 | Polyamic acid (a-2) | TDA (50) | ODPA (50) | DAP-B (83) | - | SiDA (5) | MAP (20) | MPA | 25000 | 2.1 | 0 | 75 | 4.2 |
| Synthesis Example 53 | Polyamic acid (a-3) | TDA (50) | ODPA (50) | DAP-C (83) | - | SiDA (5) | MAP (20) | MPA | 25000 | 2.1 | 0 | 75 | 4.2 |
| Synthesis Example 54 | Polyamic acid (a-4) | TDA (50) | ODPA (50) | DAP-D (83) | - | SiDA (5) | MAP (20) | MPA | 25000 | 2.1 | 0 | 75 | 4.2 |
| Synthesis Example 55 | Polyamic acid (a-5) | TDA (50) | ODPA (50) | DAP-E (83) | - | SiDA (5) | MAP (20) | MPA | 25000 | 2.1 | 0 | 75 | 4.2 |
| Synthesis Example 56 | Polyamic acid (a-6) | TDA (50) | ODPA (50) | DAP-F (83) | - | SiDA (5) | MAP (20) | MPA | 25000 | 2.1 | 0 | 75 | 4.2 |
| Synthesis Example 57 | Polyamic acid (a-7) | TDA (50) | ODPA (50) | DAP-G (83) | - | SiDA (5) | MAP (20) | MPA | 25000 | 2.1 | 0 | 75 | 4.2 |
| Synthesis Example 58 | Polyamic acid (a-8) | TDA (50) | ODPA (50) | DAP-H (83) | - | SiDA (5) | MAP (20) | MPA | 25000 | 3.0 | 0 | 75 | 4.2 |
| Synthesis Example 59 | Polyamic acid (a-9) | TDA (50) | ODPA (50) | DAP-I (83) | - | SiDA (5) | MAP (20) | MPA | 25000 | 3.1 | 0 | 75 | 4.2 |
| Synthesis Example 60 | Polyamic acid (a-10) | MCTC (50) | ODPA (50) | DAP-B (83) | - | SiDA (5) | MAP (20) | MPA | 25000 | 1.9 | 0 | 75 | 4.2 |
| Synthesis Example 61 | Polyamic acid (a-11) | TDA (50) | ODPA (50) | DAP-B (63) | 3,4'-ODA (20) | SiDA (5) | MAP (20) | MPA | 25000 | 2.2 | 0 | 75 | 4.2 |
| Synthesis Example 62 | Polyamic acid (a-12) | TDA (50) | ODPA (50) | DAP-B (43) | 3,4'-ODA (40) | SiDA (5) | MAP (20) | MPA | 25000 | 2.1 | 0 | 75 | 4.2 |
| Synthesis Example 63 | Polyamic acid ester (a-13) | TDA (100) | - | HC (83) | - | SiDA (5) | MAP (20) | MPA | 33000 | 1.5 | 80 | 8 | 4.2 |
| Synthesis Example 64 | Polyamic acid ester (a-14) | TDA (100) | - | HD (83) | - | SiDA (5) | MAP (20) | MPA | 33000 | 1.4 | 80 | 8 | 4.2 |
| Synthesis Example 65 | Polyamic acid ester (a-15) | TDA (100) | - | HE (83) | - | SiDA (5) | MAP (20) | MPA | 33000 | 1.5 | 80 | 8 | 4.2 |

**[Table 1-2]**

| | Resin (A) | Tetracarboxylic acid, dicarboxylic acid, and derivatives thereof (molar ratio) | | Diamine and derivatives thereof (molar ratio) | | | End-capping agent (molar ratio) | Polymerization solvent | Resin evaluation | | | | |
|---|---|---|---|---|---|---|---|---|---|---|---|---|---|
| | | | | | | | | | Weight average molecular weight (Mw) | Amount of components having molecular weight of 1000 or less [% by mass] | Esterification rate [%] | Imide ring closure rate [%] | Content of compounds represented by formula (17) and formula (18) [parts by mass] |
| Synthesis Example 66 | Polyamic acid ester (a-16) | MCTC (100) | - | HC (83) | - | SiDA (5) | MAP (20) | MPA | 33000 | 1.8 | 80 | 8 | 4.2 |
| Synthesis Example 67 | Polyamic acid ester (a-17) | MCTC (100) | - | HC (83) | - | SiDA (5) | MAP (20) | DMIB | 33000 | 1.7 | 80 | 8 | 4.2 |
| Synthesis Example 68 | Polyamic acid ester (a-18) | MCTC (100) | - | HC (83) | - | SiDA (5) | MAP (20) | DMPA | 33000 | 1.8 | 80 | 8 | 4.2 |
| Synthesis Example 69 | Polyamic acid ester (a-19) | MCTC (100) | - | HC (83) | - | SiDA (5) | MAP (20) | GBL | 33000 | 1.9 | 80 | 8 | 0 |
| Synthesis Example 70 | Polyamic acid (a-20) | ODPA (100) | - | DAP-B (83) | - | SiDA (5) | MAP (20) | MPA | 25000 | 1.8 | 0 | 75 | 4.2 |
| Synthesis Example 71 | polyimide (a-21) | TDA (50) | ODPA (50) | DAP-A (83) | - | SiDA (5) | MAP (20) | MPA | 25000 | 1.4 | 0 | 100 | 4.2 |
| Synthesis Example 72 | Polyamic acid (a-22) | TDA (50) | ODPA (50) | BAP (83) | - | SiDA (5) | MAP (20) | MPA | 25000 | 1.9 | 0 | 75 | 4.2 |
| Synthesis Example 73 | Polyamic acid ester (a-23) | TDA (100) | - | HA (83) | - | SiDA (5) | MAP (20) | MPA | 33000 | 1.8 | 80 | 8 | 4.2 |
| Synthesis Example 74 | Polyamic acid ester (a-24) | TDA (100) | - | HB (83) | - | SiDA (5) | MAP (20) | MPA | 33000 | 1.9 | 80 | 8 | 4.2 |
| Synthesis Example 75 | Polyamic acid ester (a-25) | ODPA (100) | - | HC (83) | - | SiDA (5) | MAP (20) | MPA | 34500 | 1.7 | 80 | 10 | 4.2 |
| Synthesis Example 76 | Polyamic acid ester (a-26) | ODPA (100) | - | DAP-B (78) | HC (5) | SiDA (5) | MAP (20) | MPA | 32000 | 1.8 | 55 | 45 | 4.2 |
| Synthesis Example 77 | Polyamic acid ester (a-27) | ODPA (100) | - | DAP-B (73) | HC (10) | SiDA (5) | MAP (20) | MPA | 32500 | 1.8 | 47 | 40 | 4.2 |
| Synthesis Example 78 | Polyamic acid ester (a-28) | ODPA (100) | - | DAP-B (58) | HC (25) | SiDA (5) | MAP (20) | MPA | 33000 | 1.8 | 58 | 30 | 4.2 |
| Synthesis Example 79 | Polyamic acid ester (a-29) | ODPA (100) | - | DAP-B (43) | HC (40) | SiDA (5) | MAP (20) | MPA | 34000 | 1.8 | 64 | 25 | 4.2 |
| Synthesis Example 80 | Polyamic acid ester (a-30) | ODPA (100) | - | DAP-B (30) | HC (53) | SiDA (5) | MAP (20) | MPA | 34000 | 1.8 | 70 | 20 | 4.2 |

**[Table 1-3]**

| | Resin (A) | Tetracarboxylic acid, dicarboxylic acid, and derivatives thereof (molar ratio) | Diamine and derivatives thereof (molar ratio) | | | End-capping agent (molar ratio) | | Polymerization solvent | Resin evaluation | | | | |
|---|---|---|---|---|---|---|---|---|---|---|---|---|---|
| | | | | | | | | | Weight average molecular weight (Mw) | Amount of components having molecular weight of 1000 or less [% by mass] | Esterification rate [%] | Imide ring closure rate [%] | Content of compounds represented by formula (17) and formula (18) [parts by mass] |
| Synthesis Example 81 | Polyamic acid ester (a-31) | ODPA (100) | DAP-B (20) | HC (63) | SiDA (5) | - | MAP (20) | MPA | 34000 | 1.8 | 70 | 15 | 4.2 |
| Synthesis Example 82 | Polyamic acid ester (a-32) | ODPA (100) | DAP-C (58) | HC (25) | SiDA (5) | - | MAP (20) | MPA | 33000 | 1.8 | 58 | 30 | 4.2 |
| Synthesis Example 83 | Polyamic acid ester (a-33) | ODPA (100) | DAP-B (58) | HD (25) | SiDA (5) | - | MAP (20) | MPA | 33000 | 1.8 | 58 | 30 | 4.2 |
| Synthesis Example 84 | Polyamic acid ester (a-34) | ODPA (100) | DAP-C (58) | HB (25) | SiDA (5) | - | MAP (20) | MPA | 33000 | 1.8 | 58 | 30 | 4.2 |
| Synthesis Example 85 | Polyamic acid ester (a-35) | ODPA (100) | BAP (58) | HC (25) | SiDA (5) | - | MAP (20) | MPA | 33000 | 1.8 | 58 | 30 | 4.2 |
| Synthesis Example 86 | Polyamic acid ester (a-36) | ODPA (100) | DAP-B (58) | HC (25) | SiDA (5) | - | 4-APA (20) | MPA | 33000 | 1.8 | 58 | 30 | 4.2 |
| Synthesis Example 87 | Polyamic acid ester (a-37) | ODPA (100) | DAP-B (58) | HC (24) | SiDA (5) | TPE-R (1) | MAP (20) | MPA | 33000 | 1.8 | 56 | 33 | 4.2 |
| Synthesis Example 88 | Polyamic acid ester (a-38) | ODPA (100) | DAP-B (58) | HC (20) | SiDA (5) | TPE-R (5) | MAP (20) | MPA | 33000 | 1.8 | 56 | 33 | 4.2 |
| Synthesis Example 89 | Polyamic acid ester (a-39) | ODPA (100) | DAP-B (53) | HC (15) | SiDA (5) | TPE-R (15) | MAP (20) | MPA | 33000 | 1.8 | 56 | 33 | 4.2 |
| Synthesis Example 90 | Polyamic acid ester (a-40) | ODPA (100) | DAP-B (43) | HC (15) | SiDA (5) | TPE-R (25) | MAP (20) | MPA | 33000 | 1.8 | 56 | 33 | 4.2 |
| Synthesis Example 91 | Polyamic acid ester (a-41) | ODPA (100) | DAP-B (38) | HC (15) | SiDA (5) | TPE-R (30) | MAP (20) | MPA | 33000 | 1.8 | 56 | 33 | 4.2 |
| Synthesis Example 92 | Polyamic acid ester (a-42) | ODPA (100) | DAP-B (58) | HC (20) | SiDA (5) | 3,4'-ODA (5) | MAP (20) | MPA | 33000 | 1.8 | 55 | 34 | 4.2 |
| Synthesis Example 93 | Polyamic acid (a-43) | ODPA (100) | DAP-B (58) | HC (25) | SiDA (5) | - | MAP (20) | MPA | 33000 | 1.8 | 0 | 75 | 4.2 |
| Synthesis Example 94 | Polyamic acid ester (a-44) | ODPA (100) | DAP-B (58) | HC (25) | SiDA (5) | - | MAP (20) | DMIB | 33000 | 1.8 | 58 | 30 | 4.2 |
| Synthesis Example 95 | Polyamic acid ester (a-45) | ODPA (100) | DAP-B (58) | HC (25) | SiDA (5) | - | MAP (20) | GBL | 33000 | 2.0 | 58 | 30 | 0 |

**[Table 1-4]**

| | Resin (A) | Tetracarboxylic acid, dicarboxylic acid, and derivatives thereof (molar ratio) | | Diamine and derivatives thereof (molar ratio) | | | End-capping agent (molar ratio) | Polymerization solvent | Resin evaluation | | | | |
|---|---|---|---|---|---|---|---|---|---|---|---|---|---|
| | | | | | | | | | Weight average molecular weight (Mw) | Amount of components having molecular weight of 1000 or less [% by mass] | Esterification rate [%] | Imide ring closure rate [%] | Content of compounds represented by formula (17) and formula (18) [parts by mass] |
| Synthesis Example 96 | Polyamic acid ester (a-46) | TDA (100) | - | HC (83) | - | SiDA (5) | MAP (20) | MPA | 33000 | 0.3 | 80 | 8 | 1.5 |
| Synthesis Example 97 | Polyamic acid ester (a-47) | TDA (100) | - | HC (85) | - | SiDA (5) | - | MPA | 34000 | 1.7 | 80 | 8 | 4.2 |
| Synthesis Example 98 | Polyamic acid (a-48) | HBPDA (50) | ODPA (50) | DAP-B (83) | - | SiDA (5) | MAP (20) | MPA | 27000 | 1.9 | 0 | 75 | 4.2 |
| Synthesis Example 99 | Polyamic acid (a-49) | TDA (50) | ODPA (50) | DAP-J (83) | - | SiDA (5) | MAP (20) | MPA | 25000 | 1.9 | 0 | 75 | 4.2 |
| Synthesis Example 100 | Polyamic acid (a-50) | TDA (50) | ODPA (50) | DAP-K (83) | - | SiDA (5) | MAP (20) | MPA | 25000 | 1.9 | 0 | 75 | 4.2 |

### [Example 1]

Under a yellow light, to 28.6 g of a mixed solvent having a mass ratio of PGME as a solvent (C2), ethyl lactate, and GBL as a solvent (C3) of 35 : 35 : 30, 4.07 g of a polyamic acid ester (a-1) as a resin (A) component, 0.488 g of QD-a and 0.488 g of QD-b as photo acid generators (B1) for a photosensitive agent (B), 0.814 g of HMOM-TPHAP (manufactured by Honshu Chemical Industry Co., Ltd.; a compound represented by the following formula (44)) as a crosslinking agent (E), and 0.004 g of BYK-302 (manufactured by BYK Japan KK) as a surfactant (F) were added and stirred for 30 minutes to be dissolved, thereby obtaining a uniform solution having a solid content of 18.0% by mass.

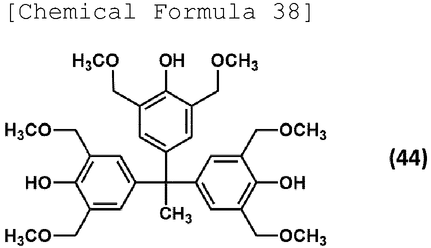

Subsequently, the solution was filtrated through a 0.45-µmφ filter to obtain a photosensitive resin composition 1. Next, using the obtained photosensitive resin composition 1, various evaluations were performed according to each of the measurement and evaluation methods (6) to (14).

### [Examples 2 to 46 and Comparative Examples 1 to 5]

Except that photosensitive resin compositions were prepared with the compositions shown in Table 2-1 to Table 2-4, photosensitive resin compositions 2 to 51, cured films, and organic EL display devices were produced in the same manner as in Example 1. These evaluation results are collectively shown in Table 3-1 to Table 3-4.

**[Table 2-1]**

| | Resin composition | Composition (parts by mass) | | | | | | | |
|---|---|---|---|---|---|---|---|---|---|
| | | Resin (A) | Photosensitive agent (B) | Solvent (C) | | | | Crosslinking agent (E) | Surfactant (F) |
| | | | | Solvent (C1) | Solvent (C2) | Solvent (C3) | Mass ratio of component (C1) and component (C2) (Y/X) | | |
| Example 1 | 1 | a-1 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 2 | 2 | a-2 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 3 | 3 | a-3 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 4 | 4 | a-4 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 5 | 5 | a-5 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 6 | 6 | a-6 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 7 | 7 | a-7 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 8 | 8 | a-8 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 9 | 9 | a-9 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 10 | 10 | a-10 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 11 | 11 | a-11 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 12 | 12 | a-12 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 13 | 13 | a-13 (100) | b-1 (12) | c-1 (4.2) | c-4 (246) | c-6 (211) | 117 | e-1 (20) | f-1 (0.1) |
| | | | b-2(12) | | c-5 (246) | | | | |

**[Table 2-2]**

| | Resin composition | Composition (parts by mass) | | | | | | | |
|---|---|---|---|---|---|---|---|---|---|
| | | Resin (A) | Photosensitive agent (B) | Solvent (C) | | | | Crosslinking agent (E) | Surfactant (F) |
| | | | | Solvent (C1) | Solvent (C2) | Solvent (C3) | Mass ratio of component (C1) and component (C2) (Y/X) | | |
| Example 14 | 14 | a-14 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 15 | 15 | a-15 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 16 | 16 | a-16 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 17 | 17 | a-16 (100) | b-1 (12) | c-1 (4.2) | - | c-6 (703) | 0 | e-1 (20) | f-1 (0.1) |
| | | | b-2(12) | | | | | | |
| Example 18 | 18 | a-17 (100) | b-1 (12) | c-2 (4.2) | c-4 (246) | c-6 (211) | 117 | e-1 (20) | f-1 (0.1) |
| | | | b-2(12) | | c-5 (246) | | | | |
| Example 19 | 19 | a-18 (100) | b-1 (12) | c-3 (4.2) | c-4 (246) | c-6 (211) | 117 | e-1 (20) | f-1 (0.1) |
| | | | b-2(12) | | c-5 (246) | | | | |
| Example 20 | 20 | a-19 (100) | b-1 (12) | - | c-4 (246) | c-6 (211) | Not calculable | e-1 (20) | f-1 (0.1) |
| | | | b-2(12) | | c-5 (246) | | | | |
| Example 21 | 21 | a-20 (100) | b-1 (12) | c-1 (4.2) | c-4 (246) | c-6 (211) | 117 | e-1 (20) | f-1 (0.1) |
| | | | b-2(12) | | c-5 (246) | | | | |
| Example 22 | 22 | a-21 (100) | b-1 (12) | c-1 (4.2) | c-4 (246) | c-6 (211) | 117 | e-1 (20) | f-1 (0.1) |
| | | | b-2(12) | | c-5 (246) | | | | |
| Comparative Example 1 | 23 | a-22 (100) | b-1 (12) | c-1 (4.2) | c-4 (246) | c-6 (211) | 117 | e-1 (20) | f-1 (0.1) |
| | | | b-2(12) | | c-5 (246) | | | | |
| Comparative Example 2 | 24 | a-23 (100) | b-1 (12) | c-1 (4.2) | c-4 (246) | c-6 (211) | 117 | e-1 (20) | f-1 (0.1) |
| | | | b-2(12) | | c-5 (246) | | | | |
| Comparative Example 3 | 25 | a-24 (100) | b-1 (12) | c-1 (4.2) | c-4 (246) | c-6 (211) | 117 | e-1 (20) | f-1 (0.1) |
| | | | b-2(12) | | c-5 (246) | | | | |

**[Table 2-3]**

| | Resin composition | Composition (parts by mass) | | | | | | | |
|---|---|---|---|---|---|---|---|---|---|
| | | Resin (A) | Photosensitive agent (B) | Solvent (C) | | | | Crosslinking agent (E) | Surfactant (F) |
| | | | | Solvent (C1) | Solvent (C2) | Solvent (C3) | Mass ratio of component (C1) and component (C2) (Y/X) | | |
| Example 23 | 26 | a-25 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 24 | 27 | a-26 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 25 | 28 | a-27 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 26 | 29 | a-28 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 27 | 30 | a-29 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 28 | 31 | a-30 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 29 | 32 | a-31 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 30 | 33 | a-32 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 31 | 34 | a-33 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 32 | 35 | a-34 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 33 | 36 | a-35 (100) | b-1 (12) | c-1 (4.2) | c-4 (246) | c-6 (211) | 117 | e-1 (20) | f-1 (0.1) |
| | | | b-2(12) | | c-6 (246) | | | | |
| Example 34 | 37 | a-36 (100) | b-1 (12) | c-1 (4.2) | c-4 (246) | c-6 (211) | 117 | e-1 (20) | f-1 (0.1) |
| | | | b-2(12) | | c-6 (246) | | | | |

**[Table 2-4]**

| | Resin composition | Composition (parts by mass) | | | | | | | |
|---|---|---|---|---|---|---|---|---|---|
| | | Resin (A) | Photosensitive agent (B) | Solvent (C) | | | | Crosslinking agent (E) | Surfactant (F) |
| | | | | Solvent (C1) | Solvent (C2) | Solvent (C3) | Mass ratio of component (C1) and component (C2) (Y/X) | | |
| Example 35 | 38 | a-37 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 36 | 39 | a-38 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 37 | 40 | a-39 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 38 | 41 | a-40 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 39 | 42 | a-41 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 40 | 43 | a-42 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 41 | 44 | a-43 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 42 | 45 | a-44 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Example 43 | 46 | a-45 (100) | b-1 (12) | - | c-4 (246) | c-6 (211) | Not calculable | e-1 (20) | f-1 (0.1) |
| | | | b-2(12) | | c-6 (246) | | | | |
| Example 44 | 47 | a-46 (100) | b-1 (12) | c-1 (1.5) | c-4 (246) | c-6 (211) | 328 | e-1 (20) | f-1 (0.1) |
| | | | b-2 (12) | | c-6 (246) | | | | |
| Example 45 | 48 | a-47 (100) | b-1 (12) | c-1 (1.5) | c-4 (246) | c-6 (211) | 328 | e-1 (20) | f-1 (0.1) |
| | | | b-2 (12) | | c-6 (246) | | | | |
| Example 46 | 49 | a-48 (100) | b-1 (12) | c-1 (1.5) | c-4 (246) | c-6 (211) | 328 | e-1 (20) | f-1 (0.1) |
| | | | b-2 (12) | | c-6 (246) | | | | |
| Comparative Example 4 | 50 | a-49 (100) | b-1 (12) | c-1 (4.2) | c-4 (246) | c-6 (211) | 117 | e-1 (20) | f-1 (0.1) |
| | | | b-2 (12) | | c-6 (246) | | | | |
| Comparative Example 5 | 51 | a-50 (100) | b-1 (12) | c-1 (4.2) | c-4 (246) | c-6 (211) | 117 | e-1 (20) | f-1 (0.1) |
| | | | b-2 (12) | | c-6 (246) | | | | |

The components listed in the above table are as follows.

### Resin (A)

(a-1) to (a-12), (a-20), (a-22), (a-43), (a-48) to (a-50): Polyamic acid resin described above
(a-13) to (a-19), (a-23) to (a-42), (a-44) to (a-47): Polyamic acid ester resin described above
(a-21): The polyimide resins described above. Photosensitive agent (B)
(b-1): QD-a (Compound described in Synthesis Example 1)
(b-2): QD-b (Compound described in Synthesis Example 2)

### Solvent (C)

(c-1): MPA
(c-2): DMIB
(c-3): DMPA
(c-4): PGME (solvent having hydroxyl group and having boiling point of 120°C at atmospheric pressure)
(c-5): Ethyl lactate (Solvent having hydroxyl group and having boiling point of 154°C at atmospheric pressure)
(c-6): GBL

### Crosslinking agent (E)

(e-1): HMOM-TPHAP (manufactured by Honshu Chemical Industry Co., Ltd.)

### Surfactant (F)

(f-1): BYK-302 (manufactured by BYK Japan KK)

**[Table 3-1]**

| | Resin composition | Characteristics of resin composition/photosensitive characteristics/ characteristics of cured film | | | | | | | | Evaluation of organic EL display device | | | | |
|---|---|---|---|---|---|---|---|---|---|---|---|---|---|---|
| | | Thinner Solubility | Planarity | Sensitivity | Development residual substance | Penetration depth of carbon component | Elongation at Break | Transmittance | Shelf stability | Appearance immediately after device fabrication | Pixel light-emitting area ratio | | | |
| | | | | | | | | | | | After 1 hour of heated light emission | 100 hours after light irradiation | 500 hours after light irradiation | 1000 hours after light irradiation |
| Example 1 | 1 | A | A | A | A | A | C | B | C | OK | A | A | B | C |
| Example 2 | 2 | A | A | A | A | A | C | B | C | OK | A | A | B | C |
| Example 3 | 3 | A | A | A | A | A | C | B | C | OK | A | A | B | C |
| Example 4 | 4 | A | A | A | A | A | C | B | C | OK | A | A | B | C |
| Example 5 | 5 | A | A | A | A | A | C | B | C | OK | A | A | B | C |
| Example 6 | 6 | A | A | A | A | A | C | B | C | OK | A | A | B | C |
| Example 7 | 7 | C | A | B | B | C | C | B | C | OK | B | B | B | C |
| Example 8 | 8 | C | B | B | A | C | C | B | C | OK | A | B | B | C |
| Example 9 | 9 | C | B | B | A | C | C | B | C | OK | A | B | B | C |
| Example 10 | 10 | A | A | A | A | A | C | B | C | OK | A | A | B | C |
| Example 11 | 11 | A | A | A | A | A | B | B | C | OK | A | A | B | C |
| Example 12 | 12 | A | A | B | C | B | B | B | C | OK | B | A | B | C |
| Example 13 | 13 | A | A | AA | A | A | C | A | B | OK | A | B | B | C |
| Example 14 | 14 | A | A | AA | A | A | C | A | B | OK | A | B | B | C |
| Example 15 | 15 | A | A | AA | A | A | C | A | B | OK | A | B | B | C |

**[Table 3-2]**

| | Resin composition | Characteristics of resin composition/photosensitive characteristics/ characteristics of cured film | | | | | | | | Evaluation of organic EL display device | | | | |
|---|---|---|---|---|---|---|---|---|---|---|---|---|---|---|
| | | Thinner Solubility | Planarity | Sensitivity | Development residual substance | Penetration depth of carbon component | Elongation at Break | Transmittance | Shelf stability | Appearance immediately after device fabrication | Pixel light-emitting area ratio | | | |
| | | | | | | | | | | | After 1 hour of heated light emission | 100 hours after light irradiation | 500 hours after light irradiation | 1000 hours after light irradiation |
| Example 16 | 16 | A | A | AA | A | A | C | A | B | OK | A | B | B | C |
| Example 17 | 17 | A | C | C | A | A | C | A | B | OK | A | B | C | C |
| Example 18 | 18 | A | A | AA | A | A | C | A | B | OK | A | B | B | C |
| Example 19 | 19 | A | A | AA | A | A | C | A | B | OK | A | B | B | C |
| Example 20 | 20 | A | C | A | A | A | C | A | B | OK | A | B | C | C |
| Example 21 | 21 | C | A | C | A | B | B | C | C | OK | A | B | B | B |
| Example 22 | 22 | B | A | B | B | B | C | B | C | OK | B | B | B | C |
| Comparative Example 1 | 23 | D | B | C | B | B | C | B | C | OK | B | C | C | D |
| Comparative Example 2 | 24 | A | B | A | A | D | D | A | B | NG | Evaluation not performed | | | |
| Comparative Example 3 | 25 | D | B | A | B | B | D | A | B | OK | B | C | C | D |
| Example 23 | 26 | C | A | A | B | A | A | C | B | OK | B | A | A | B |
| Example 24 | 27 | A | A | A | A | A | A | C | A | OK | A | A | A | B |
| Example 25 | 28 | A | A | AA | A | A | A | C | A | OK | A | A | A | B |
| Example 26 | 29 | A | A | AA | A | A | A | C | A | OK | A | A | A | B |
| Example 27 | 30 | A | A | AA | A | A | A | C | A | OK | A | A | A | B |

**[Table 3-3]**

| | Resin composition | Characteristics of resin composition/photosensitive characteristics/ characteristics of cured film | | | | | | | | Evaluation of organic EL display device | | | | |
|---|---|---|---|---|---|---|---|---|---|---|---|---|---|---|
| | | Thinner Solubility | Planarity | Sensitivity | Development residual substance | Penetration depth of carbon component | Elongation at Break | Transmittance | Shelf stability | Appearance immediately after device fabrication | Pixel light-emitting area ratio | | | |
| | | | | | | | | | | | After 1 hour of heated light emission | 100 hours after light irradiation | 500 hours after light irradiation | 1000 hours after light irradiation |
| Example 28 | 31 | B | A | AA | A | A | A | C | A | OK | A | A | A | B |
| Example 29 | 32 | C | A | AA | A | A | A | C | A | OK | A | A | A | B |
| Example 30 | 33 | A | A | AA | A | A | A | C | A | OK | A | A | A | B |
| Example 31 | 34 | A | A | AA | A | A | A | C | A | OK | A | A | A | B |
| Example 32 | 35 | B | A | AA | A | A | B | C | A | OK | A | A | A | B |
| Example 33 | 36 | B | A | AA | A | A | B | C | A | OK | A | A | A | B |
| Example 34 | 37 | A | A | A | A | A | AA | C | A | OK | A | A | A | B |
| Example 35 | 38 | A | A | AA | A | A | AA | C | A | OK | A | A | A | B |
| Example 36 | 39 | A | A | AA | A | A | AA | C | A | OK | A | A | A | B |
| Example 37 | 40 | A | A | AA | A | A | AA | C | A | OK | A | A | A | B |
| Example 38 | 41 | A | A | A | A | A | AA | C | A | OK | A | A | A | B |
| Example 39 | 42 | A | A | B | B | A | AA | C | A | OK | B | A | A | B |
| Example 40 | 43 | A | A | AA | A | A | A | C | A | OK | A | A | A | B |
| Example 41 | 44 | B | A | B | A | A | A | C | C | OK | A | A | A | B |
| Example 42 | 45 | A | A | AA | A | A | A | C | A | OK | A | A | A | B |
| Example 43 | 46 | A | C | A | A | A | A | C | A | OK | A | A | B | B |

**[Table 3-4]**

| | Resin composition | Characteristics of resin composition/photosensitive characteristics/ characteristics of cured film | | | | | | | | Evaluation of organic EL display device | | | | |
|---|---|---|---|---|---|---|---|---|---|---|---|---|---|---|
| | | Thinner Solubility | Planarity | Sensitivity | Development residual substance | Penetration depth of carbon component | Elongation at Break | Transmittance | Shelf stability | Appearance immediately after device fabrication | Pixel light-emitting area ratio | | | |
| | | | | | | | | | | | After 1 hour of heated light emission | 100 hours after light irradiation | 500 hours after light irradiation | 1000 hours after light irradiation |
| Example 44 | 47 | A | A | A | C | A | C | A | B | OK | A | B | B | C |
| Example 45 | 48 | A | A | A | A | A | C | A | C | OK | A | B | B | C |
| Example 46 | 49 | A | A | A | A | A | C | B | C | OK | A | A | B | C |
| Comparative Example 4 | 50 | D | B | C | B | B | C | B | C | OK | B | C | C | D |
| Comparative Example 5 | 51 | D | B | C | B | B | C | B | C | OK | B | C | C | D |

The above results indicate that the photosensitive resin compositions of Examples exhibit excellent thinner solubility and high sensitivity, with little development residual substance and suppressed contamination of the openings after curing, and that the organic EL display devices have excellent reliability. In Comparative Examples 1, 3, 4, and 5, since the resin (A) did not include the diamine residue represented by any one of formulas (2) to (4), the thinner solubility resulted in being poor. In Comparative Example 2, since the resin (A) did not include the diamine residue represented by any one of formulas (2) to (4) and included the diamine residue containing fluorine, contamination was observed in the opening after curing. In addition, when a pixel defining layer was fabricated on the planarization layer in order to produce the organic EL display device, foaming was observed between the planarization layer and the pixel defining layer. This is considered to be because gas caused by water or the like was generated from the planarization layer in the thermal curing step of the pixel defining layer.

### DESCRIPTION OF REFERENCE SIGNS

1: Stepped substrate
2: Cured product
3: Baseline
4: Non-alkali glass substrate
5: Planarization layer
6: Metal reflection layer
7: First electrode
8: Auxiliary electrode
9: Patterned cured film
10: Organic EL layer
11: Second electrode

## Claims

1. A photosensitive resin composition comprising:
a resin (A) including at least one of a structural unit represented by formula (1), a structural unit represented by formula (19), and a structural unit represented by formula (70), the resin (A) being hereinafter, referred to as resin (A); a photosensitive agent (B); and a solvent (C),
wherein when the total amount of diamine residues in the resin (A) is defined as 100 mol%, the total content of diamine residues represented by any one of formulas (2) to (4) is 30 to 100 mol%: 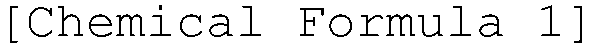 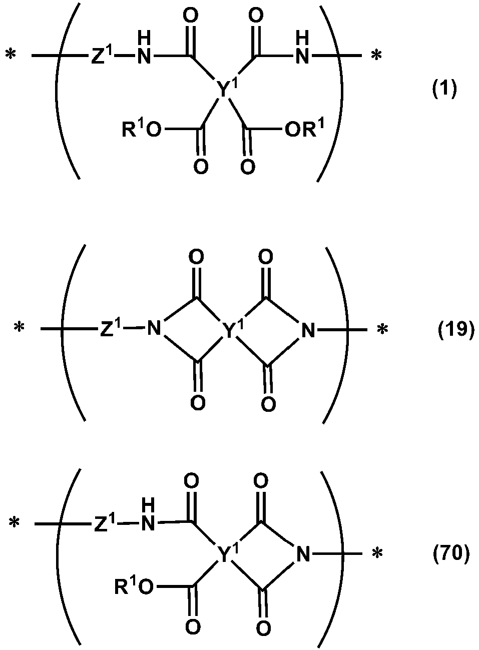
wherein in formulas (1), (19), and (70), Y¹ each independently represents an acid dianhydride residue having 2 to 40 carbon atoms and having any one of an aliphatic structure having 2 to 20 carbon atoms, an alicyclic structure having 4 to 40 carbon atoms, and an aromatic structure having 6 to 40 carbon atoms, Z¹ each independently represents a diamine residue represented by any one of formulas (2) to (4), R¹ each independently represents a hydrogen atom, an alkyl group having 1 to 20 carbon atoms, or a monovalent group having 2 to 20 carbon atoms and having an ethylenically unsaturated double bond, and * represents a bonding site, 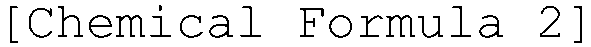 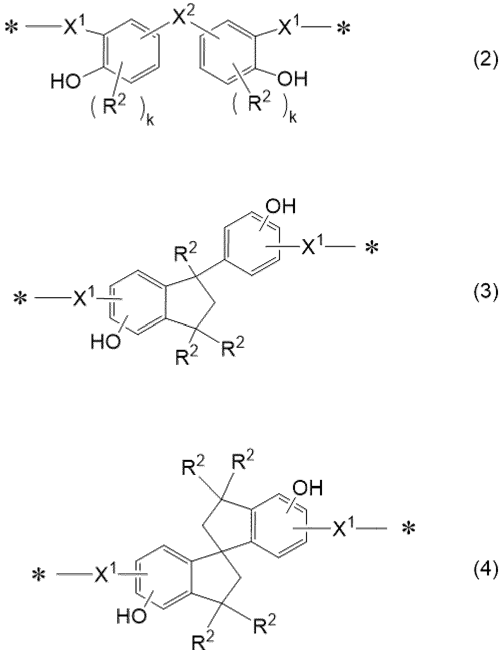
wherein in the formulas (2), (3) and (4), X¹ each independently represents a direct bond or a divalent group represented by formula (5), R² each independently represents an alkyl group having 1 to 4 carbon atoms, X² is a divalent group represented by formula (6) or (7), k each independently represents 0 or 1, and * represents a bonding site bonded to an imide structure, an amide structure, an amide acid ester structure, or an amide acid structure, 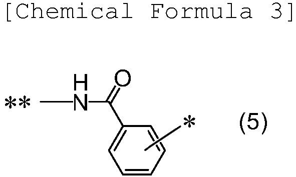
wherein in formula (5), * represents a bonding site bonded to a nitrogen atom, and ** represents a bonding site bonded to an aromatic ring, 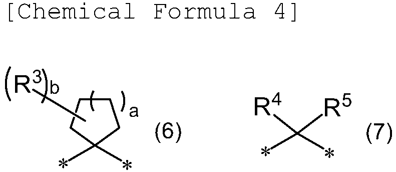
wherein in formulas (6) and (7), R³ each independently represents an alkyl group having 1 to 4 carbon atoms, a represents 1 or 2, b represents an integer of 1 to 3, R⁴ and R⁵ each independently represent a hydrocarbon group having 1 to 10 carbon atoms or a hydrogen atom, and * represents a bonding site bonded to an aromatic ring, provided that R⁴ and R⁵ do not have the same structure.

2. The photosensitive resin composition according to claim 1, wherein the resin (A) includes a diamine residue represented by formula (2), the total number of carbon atoms of R³ is 1 or more and 5 or less in formula (6), and the total number of carbon atoms of R⁴ and R⁵ is 3 or more and 10 or less in formula (7).

3. The photosensitive resin composition according to claim 1 or 2, wherein the resin (A) includes a diamine residue represented by formula (2), and in formula (6), when a=1 is represented by formula (6-1) and a = 2 is represented by formula (6-2), Condition 1 and Condition 2 are satisfied, and in formula (7), the number of carbon atoms of R⁴ is different from the number of carbon atoms of R⁵ :
Condition 1: in formula (6-1), the total number of carbon atoms of R¹¹ to R¹⁴ is different from the total number of carbon atoms of R¹⁵ to R¹⁸;
Condition 2: in formula (6-2), the total number of carbon atoms of R¹⁹ to R²² is different from the total number of carbon atoms of R²⁵ to R²⁸, 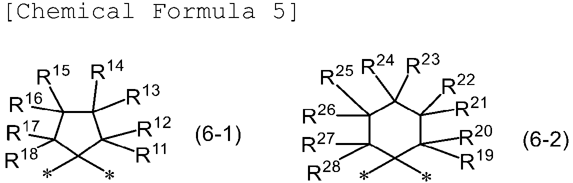
wherein in formula (6-1) and formula (6-2), R¹¹ to R²⁸ each independently represent a hydrogen atom or an alkyl group having 1 to 4 carbon atoms, provided that both formulas (6-1) and (6-2) satisfy the condition of formula (6).

4. The photosensitive resin composition according to claim 1 or 2, wherein the resin (A) includes a diamine residue represented by formula (2), and X² is a divalent group represented by any one of formulas (8) to (13) and (76) to (83) : 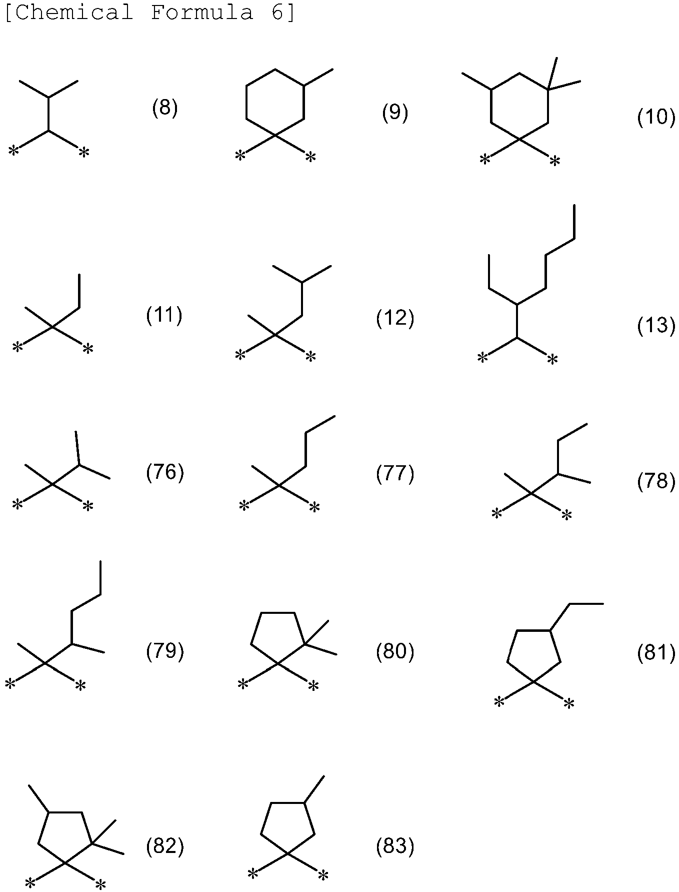 wherein in formulas (8) to (13) and (76) to (83), * represents a bonding site bonded to an aromatic ring.

5. The photosensitive resin composition according to claim 1 or 2, wherein in the formulas (1), (19), and (70), Y¹ each independently represents an acid dianhydride residue having 8 to 40 carbon atoms and having a diphenyl ether structure.

6. The photosensitive resin composition according to claim 1 or 2, wherein the resin (A) has a structure represented by formula (84): 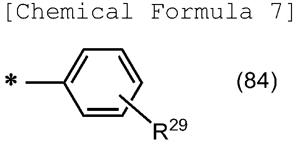 wherein in formula (84), R²⁹ represents a hydroxyl group, an alkyl group having 1 to 3 carbon atoms, an alkoxy group having 1 to 3 carbon atoms, an alkenyl group having 2 to 5 carbon atoms, or an alkynyl group having 2 to 5 carbon atoms, and * represents a bonding site with a nitrogen atom.

7. The photosensitive resin composition according to claim 1 or 2, wherein
the resin (A) includes a structural unit (a) and/or a structural unit (b), and the resin (A) includes a structural unit (c) and/or a structural unit (d), and
the resin (A) includes at least one of a structural unit (a) and a structural unit (c):
structural unit (a): a structural unit represented by formula (1), formula (19), or formula (70), in which Z¹ in formulas (1), (19), and (70) is represented by formula (2), and two X¹ in formula (2) are each a direct bond;
structural unit (b): a structural unit represented by formula (48), formula (49), or formula (71), in which Z³ in formula (48), formula (49), and formula (71) is represented by formula (45), and two X¹ in formula (45) are each a direct bond;
structural unit (c): a structural unit represented by formula (1), formula (19), or formula (70), in which Z¹ in formula (1), formula (19), and formula (70) is represented by formula (2), and at least one X¹ of the two X¹ in formula (2) is a divalent group represented by formula (5);
structural unit (d): a structural unit represented by formula (48), formula (49), or formula (71), in which Z³ in formula (48), formula (49), and formula (71) is represented by formula (45), and of two X¹ in formula (45), at least one X¹ is a divalent group represented by formula (5), 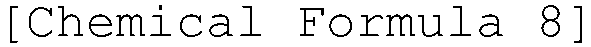 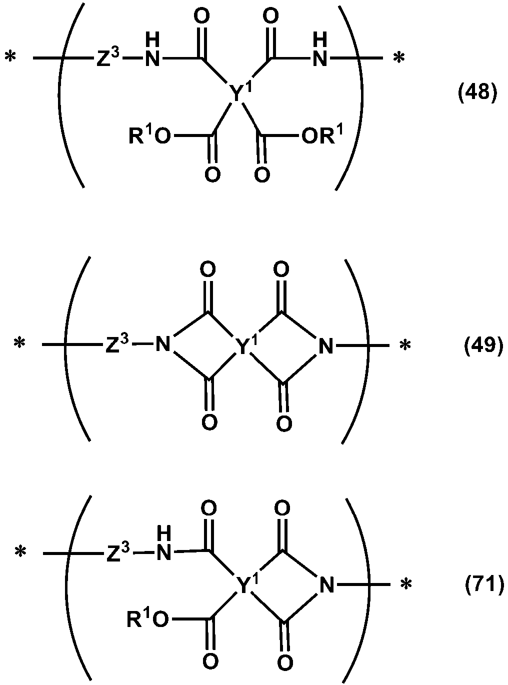
wherein in formulas (48), (49), and (71), Y¹ and R¹ are in the same ranges as those described in formulas (1), (19), and (70), Z³ each independently represents a diamine residue represented by formula (45), and * represents a bonding site, 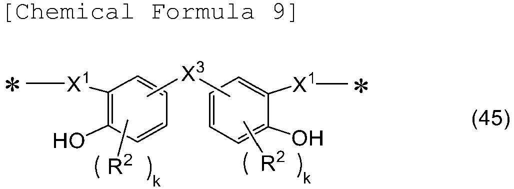
wherein in formula (45), X¹ is each independently a direct bond or a divalent group represented by formula (5), and R² and k are in the same range as those described in formula (2), X³ represents a divalent organic group represented by any one of formulas (64) to (69), and * represents a bonding site bonded to an imide structure, an amide structure, an amide acid ester structure, or an amide acid structure, 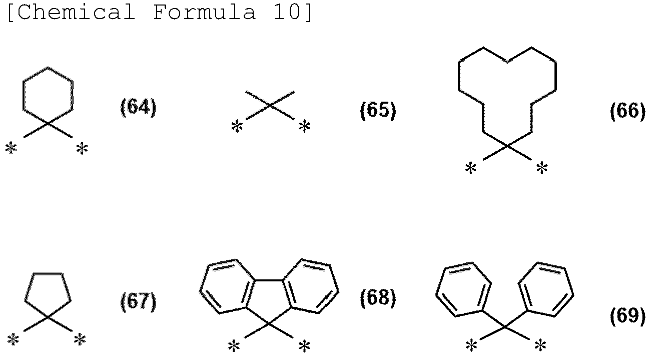
wherein * represents a bonding site bonded to an aromatic ring.

8. The photosensitive resin composition according to claim 7, wherein when the total amount of the polyimide structural units included in the resin (A) is 100 mol %, the total content of the structural units (a) and (b) is 20 to 95 mol %, and the total content of the structural units (c) and (d) is 5 mol % to 80 mol %.

9. The photosensitive resin composition according to claim 1 or 2, wherein the resin (A) further includes at least one of a structural unit represented by formula (50), a structural unit represented by formula (51), and a structural unit represented by formula (72): 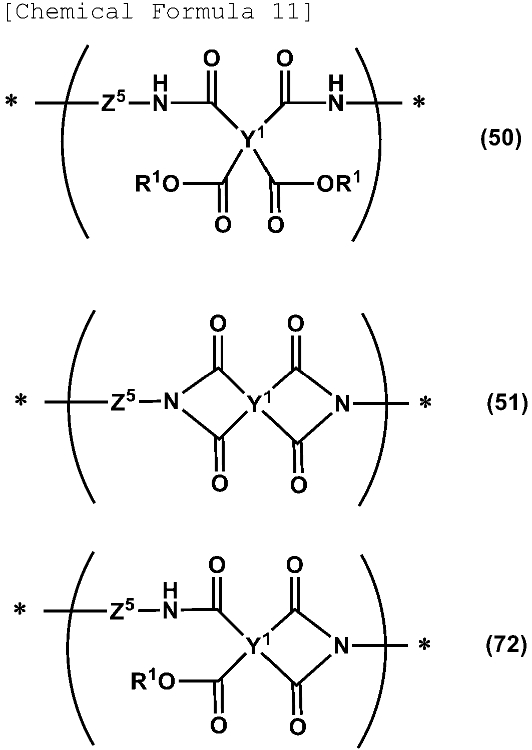 wherein in formulas (50), (51), and (72), Y¹ and R¹ are in the same ranges as those described in formulas (1), (19), and (70), Z⁵ each independently represents a diamine residue represented by formulas (46) or (47), and * represents a bonding site, 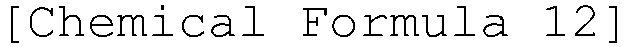 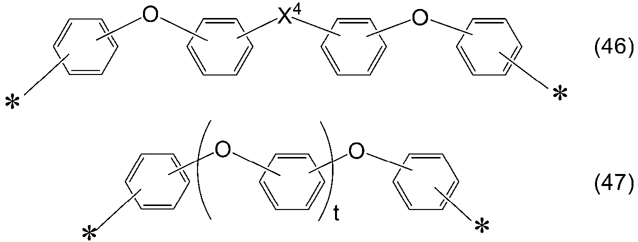 wherein in formulas (46) and (47), X⁴ represents a direct bond or -C(CH₃)₂-, t represents any integer of 0 to 2, and * represents a bonding site bonded to an imide structure, an amide structure, an amide acid ester structure, or an amide acid structure.

10. The photosensitive resin composition according to claim 9, wherein when the total amount of the structural units of the polyimide included in the resin (A) is 100 mol %, the total content of the structural unit represented by formula (50), the structural unit represented by formula (51), and the structural unit represented by formula (72) is 1 to 30 mol %.

11. The photosensitive resin composition according to claim 1 or 2, wherein the resin (A) includes an acid dianhydride residue having 4 to 20 carbon atoms and an alicyclic structure.

12. The photosensitive resin composition according to claim 11, wherein when the total amount of acid dianhydride residues in the resin (A) is 100 mol%, the total content of acid dianhydride residues having 4 to 20 carbon atoms and including an alicyclic structure is 20 to 100 mol%.

13. The photosensitive resin composition according to claim 11, wherein the resin (A) contains one or more acid dianhydride residues selected from the group consisting of formulas (15), (16), and (85) to (94): 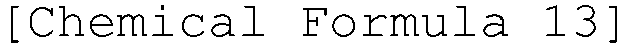 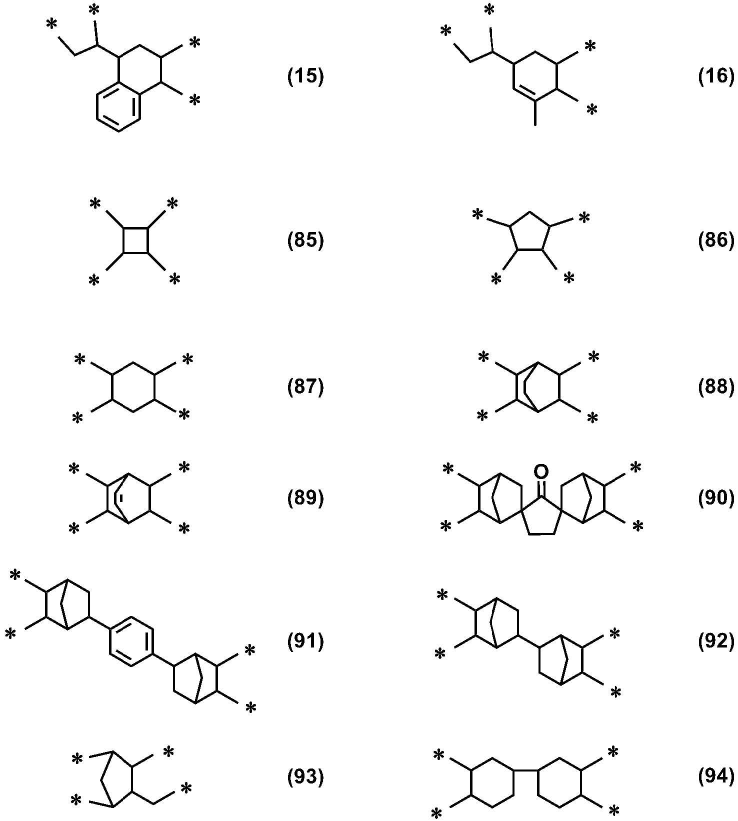 wherein in formulas (15), (16), and (85) to (94), * represents a bonding site bonded to an imide structure, an amide structure, an amide acid ester structure, or an amide acid structure.

14. The photosensitive resin composition according to claim 1 or 2, wherein the imide ring closure rate of the resin (A) is 50% or less.

15. The photosensitive resin composition according to claim 1 or 2, wherein the resin (A) has an esterification rate of 10% or more and 100% or less.

16. The photosensitive resin composition according to claim 1 or 2, wherein the solvent (C) contains a solvent represented by formula (17) and/or a solvent (C1) represented by formula (18): 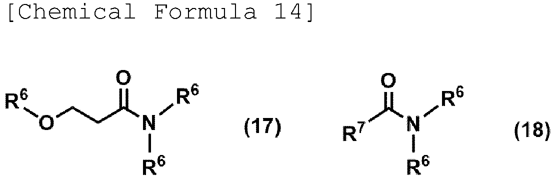
wherein in formulas (17) and (18), R⁶ each independently represents an alkyl group having 1 to 6 carbon atoms, and
R⁷ represents an alkyl group having 2 to 6 carbon atoms.

17. The photosensitive resin composition according to claim 1 or 2, wherein the solvent (C) includes a solvent (C2) having a hydroxyl group and a boiling point of 100°C or more and 200°C or less at atmospheric pressure.

18. The photosensitive resin composition according to claim 1 or 2, wherein
the photosensitive resin composition includes both a solvent (C1) represented by formula (17) and/or formula (18), the solvent (C1) being hereinafter, referred to as solvent (C1), and a solvent (C2) having a hydroxyl group and a boiling point of 100°C or more and 200°C or less at atmospheric pressure, the solvent (C2) being hereinafter, referred to as solvent (C2), and
a content ratio Y/X in the photosensitive resin composition is 1 or more and 1000 or less, where X (mass) is the content of the solvent (C1) and Y (mass) is the content of the solvent (C2).

19. A cured product obtained by curing the photosensitive resin composition according to claim 1 or 2.

20. A display device comprising the cured product according to claim 19.

21. An electronic component comprising the cured product according to claim 19.
